# EUROPEAN PATENT APPLICATION

(11) **EP 4 678 645 A1**
(43) Date of publication of application: **14.01.2026**
(21) Application number: 24788771.4
(22) Date of filing: 10.04.2024
(51) Int. Cl.: C07F 7/18, C07B 61/00, C08G 77/48, C09K 3/18, G02B 1/11, G02B 1/14, G02B 1/18

(54) **SILANE COMPOUND**

(30) Priority: 10.04.2023 JP 2023063754; 10.08.2023 JP 2023130960; 09.02.2024 JP 2024018640
(71) Applicant: Daikin Industries, Ltd., Osaka-shi, Osaka 530-0001 (JP)
(72) Inventor: TAKANO, Shinya, Osaka-Shi, Osaka 530-0001 (JP); NOMURA, Takashi, Osaka-Shi, Osaka 530-0001 (JP); KIMURA, Mari, Osaka-Shi, Osaka 530-0001 (JP); KUBOTA, Hiroki, Osaka-Shi, Osaka 530-0001 (JP); KATSUMA, Nozomi, Osaka-Shi, Osaka 530-0001 (JP); MATSUI, Motoshi, Osaka-Shi, Osaka 530-0001 (JP); KANEKO, Kazuki, Osaka-Shi, Osaka 530-0001 (JP); MORIMOTO, Kazuki, Osaka-Shi, Osaka 530-0001 (JP); WATANABE, Yusuke, Osaka-Shi, Osaka 530-0001 (JP); HARA, Manami, Osaka-Shi, Osaka 530-0001 (JP); GOTO, Akihiro, Changshu, Jiangsu 215522 (CN)
(74) Representative: Hoffmann Eitle
(86) International application number: PCT/JP2024/014575
(87) International publication number: WO 2024/214748

(57) **Abstract**

A silane compound comprising:
the following group A or group B at a terminal:

R¹ₙₐR²₃₋ₙₐSi-(O)_{z}- (A)

wherein
R¹ is each independently a group represented by -(R⁴-SiR³₂)ₘₐ-R³,
R⁴ is each independently an oxygen atom or a C₁₋₆ alkylene group,
R³ is each independently a hydrocarbon group or R^{1'},
R^{1'} has the same meaning as R¹,
ma is each independently an integer of 1 to 5, provided that the number of R^{1'} in R¹ is 20 or less,

R² is each independently a hydrocarbon group,
na is an integer of 1 to 3,
z is 0 or 1; and
a Si atom to which a hydroxyl group or a hydrolyzable group is bonded, at another terminal.

## Description

### Technical Field

The present disclosure relates to a silane compound.

### Background Art

Certain types of silane compounds are known to be capable of providing excellent water- and oil-repellency when used in surface treatment of a substrate (Patent Literature 1).

### Citation List

### Patent Literature

Patent Literature 1: JP 2019-44179 A

### Summary of Invention

### Technical Problem

An object of the present disclosure is to provide a silane compound capable of forming a surface-treating layer having higher friction durability.

### Solution to Problem

The present disclosure includes the following embodiments.
[1] A silane compound comprising:
   a group A at a terminal:

   R¹ₙₐR²₃₋ₙₐSi-(O)_{z}- (A)

   wherein
   R¹ is each independently a group represented by -(R⁴-SiR³₂)ₘₐ-R³,
   R⁴ is each independently an oxygen atom or a C₁₋₆ alkylene group,
   R³ is each independently a hydrocarbon group or R^{1'},
      R^{1'} has the same meaning as R¹,
   ma is each independently an integer of 1 to 5, provided that the number of R^{1'} in R¹ is 20 or less, R² is each independently a hydrocarbon group,
   na is 1 to 3, and
   z is 0 or 1; and
   a Si atom to which a hydroxyl group or a hydrolyzable group is bonded, at another terminal.
[2] The silane compound according to [1], which is represented by the following formula (1):

   R^{A}_{α}-X¹-R^{Si}_{β} (1)

   wherein
   R^{A} is the group A,
   X¹ is a di- to decavalent group,
   R^{Si} is a monovalent group containing a Si atom to which a hydroxyl group or a hydrolyzable group is bonded,
   α is an integer of 1 to 9, and
   β is an integer of 1 to 9.
[3] The silane compound according to [1] or [2], wherein in the group A,
   R¹ is each independently a group represented by - (OSiR³₂)ₘₐ-R³ ,
   R³ is each independently a hydrocarbon group or R^{1'},
   ma is each independently 1 or 2,
   R² is each independently a hydrocarbon group, and
   na is 1 to 3.
[4] The silane compound according to any one of [1] to [3], wherein R³ is a C₁₋₄ alkyl group.
[5] The silane compound according to any one of [2] to [4], wherein R^{Si} is a group represented by the following formula (S1), (S2), (S3), (S4), or (S5):

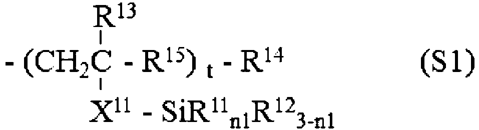

   - SiR¹¹ₙ₁R¹²₃₋ₙ₁ (S2)

   **-** SiR^{a1}ₖ₁R^{h1}ₗ₁R^{c1}ₘ₁ (S3)

   - CR^{d1}ₖ₂R^{e1}ₗ₂R^{f1}ₘ₂ (S4)

   **-** NR^{g1}R^{h1} (S5)

   wherein
   R¹¹ is each independently a hydroxyl group or a hydrolyzable group,
   R¹² is each independently a monovalent organic group,
   n1 is each independently an integer of 0 to 3 for each (SiR¹¹ₙ₁R¹²₃₋ₙ₁) unit,
   X¹¹ is each independently a single bond or a divalent organic group,
   R¹³ is each independently a hydrogen atom or a monovalent organic group,
   t is each independently an integer of 2 or more,
   R¹⁴ is each independently a hydrogen atom, a halogen atom, or -X¹¹-SiR¹¹ₙ₁R¹²₃₋ₙ₁,
   R¹⁵ is each independently a single bond, an oxygen atom, an alkylene group having 1 to 6 carbon atoms, or an alkyleneoxy group having 1 to 6 carbon atoms,
   R^{a1} is each independently -Z¹-SiR²¹ₚ₁R²²_{q1}R²³ᵣ₁,
   Z¹ is each independently a divalent organic group,
   R²¹ is each independently -Z^{1'}-SiR^{21'}_{p1'}R^{22'}_{q1'}R^{23'}_{r1'},
   R²² is each independently a hydroxyl group or a hydrolyzable group,
   R²³ is each independently a monovalent organic group,
   p1 is each independently an integer of 0 to 3,
   q1 is each independently an integer of 0 to 3,
   r1 is each independently an integer of 0 to 3,
   Z^{1'} is each independently a divalent organic group,
   R^{21'} is each independently -Z^{1"}-SiR^{22"}_{q1"}R^{23"}_{r1"},
   R^{22'} is each independently a hydroxyl group or a hydrolyzable group,
   R^{23'} is each independently a monovalent organic group,
   p1' is each independently an integer of 0 to 3,
   q1' is each independently an integer of 0 to 3,
   r1' is each independently an integer of 0 to 3,
   Z^{1"} is each independently a divalent organic group,
   R^{22"} is each independently a hydroxyl group or a hydrolyzable group,
   R^{23"} is each independently a monovalent organic group,
   q1" is each independently an integer of 0 to 3,
   r1" is each independently an integer of 0 to 3,
   R^{b1} is each independently a hydroxyl group or a hydrolyzable group,
   R^{c1} is each independently a monovalent organic group,
   k1 is each independently an integer of 0 to 3,
   l1 is each independently an integer of 0 to 3,
   m1 is each independently an integer of 0 to 3,
   provided that, in the formula (S3), at least two Si atoms to which a hydroxyl group or a hydrolyzable group is bonded are present,
   R^{d1} is each independently -Z²-CR³¹ₚ₂R³²_{q2}R³³ᵣ₂,
   Z² is each independently a single bond, an oxygen atom, or a divalent organic group,
   R³¹ is each independently -Z^{2'}-CR^{32'}_{q2'}R^{33'}_{r2'},
   R³² is each independently -Z³-SiR^{3'}ₙ₂R³⁵₃₋ₙ₂,
   R³³ is each independently a hydrogen atom, a hydroxyl group, or a monovalent organic group,
   p2 is each independently an integer of 0 to 3,
   q2 is each independently an integer of 0 to 3,
   r2 is each independently an integer of 0 to 3,
   Z^{2'} is each independently a single bond, an oxygen atom, or a divalent organic group,
   R^{32'} is each independently -Z³-SiR³⁴ₙ₂R³⁵₃₋ₙ₂,
   R^{33'} is each independently a hydrogen atom, a hydroxyl group, or a monovalent organic group,
   q2' is each independently an integer of 0 to 3,
   r2' is each independently an integer of 0 to 3,
   Z³ is each independently a single bond, an oxygen atom, or a divalent organic group,
   R³⁴ is each independently a hydroxyl group or a hydrolyzable group,
   R³⁵ is each independently a monovalent organic group,
   n2 is each independently an integer of 0 to 3,
   R^{e1} is each independently -Z³-SiR³⁴ₙ₂R³⁵₃₋ₙ₂,
   R^{f1} is each independently a hydrogen atom, a hydroxyl group, or a monovalent organic group,
   k2 is each independently an integer of 0 to 3,
   l2 is each independently an integer of 0 to 3,
   m2 is each independently an integer of 0 to 3,
   provided that, in the formula (S4), at least two Si atoms to which a hydroxyl group or a hydrolyzable group is bonded are present,
   R^{g1} and R^{h1} are each independently -Z⁴-SiR¹¹ₙ₁R¹²₃₋ₙ₁, - Z⁴-SiR^{a1}ₖ₁R^{b1}ₗ₁R^{c1}ₘ₁, or -Z⁴-CR^{d1}ₖ₂R^{e1}ₗ₂R^{f1}ₘ₂, and
   Z⁴ is each independently a single bond, an oxygen atom, or a divalent organic group,
   provided that, in the formula (S5), at least two Si atoms to which a hydroxyl group or a hydrolyzable group is bonded are present.
[6] The silane compound according to [5], wherein R^{Si} is a group represented by the formula (S2).
[7] The silane compound according to [5], wherein R^{Si} is a group represented by the formula (S3), (S4), or (S5).
[8] The silane compound according to any one of [2] to [7], wherein X¹ is a di- to decavalent group containing - CO-, -COO-, -NR⁴¹-, -CONR⁴¹-, -OCONR⁴¹-, -NR⁴¹-CO-NR⁴¹-, - O-, -S-, -CON=, or R^{S},
   R⁴¹ is a hydrogen atom or a C₁₋₆ alkyl group,
   R^{S} is a group represented by the following formula: 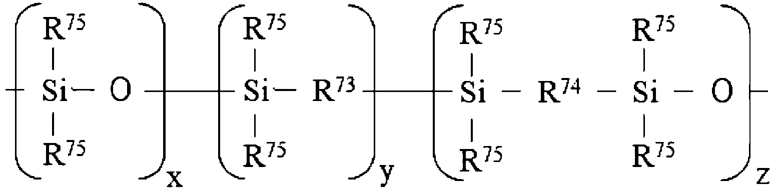 wherein
      R⁷³ is each independently a single bond, a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
      R⁷⁴ is each independently a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
         R⁷⁶ is each independently a C₁₋₆ alkylene group,
         R⁷⁷ is each independently an optionally substituted phenylene group or naphthylene group,
         R⁷⁸ is each independently a single bond or a C₁₋₆ alkylene group,
         R⁷⁹ is each independently a single bond or an oxygen atom,
      R⁷⁵ is each independently a hydrocarbon group,
      x is an integer of 0 to 500,
      y is an integer of 0 to 500,
      z is an integer of 0 to 500,
      x + y + z is 1 or more, and
      the occurrence order of the respective repeating units enclosed in parentheses provided with x, y, or z is not limited in the formula.
[9] The silane compound according to any one of [2] to [8], wherein X¹ is a group represented by the following formula:

   - (X²¹)ₐ₀-[(X¹¹)ₐ₁-(X¹²)ₐ₂]-

   wherein
   X²¹ is an optionally substituted tri- to hexavalent aromatic group, R⁶¹_{b1}R⁶²_{3-b1}C-, R⁶³_{b2}R⁶⁴_{3-b2}Si-, or R⁶⁵₂N-,
      R⁶¹ is each independently a single bond or a divalent organic group,
      R⁶² is each independently a hydrogen atom or a monovalent organic group,
      R⁶³ is each independently a single bond or a divalent organic group,
      R⁶⁴ is each independently a hydrogen atom or a monovalent organic group,
      R⁶⁵ is each independently a single bond or a divalent organic group,
      b1 is 2 or 3,
      b2 is 2 or 3,
   X¹¹ is a single bond or a divalent organic group,
   X¹² is -CO-, -COO-, -OCO-, -NR⁴¹-, -CONR⁴¹-, -NR⁴¹CO-, -OCONR⁴¹-, -NR⁴¹COO-, -NR⁴¹-CO-NR⁴¹-, -O-, -S-, or R^{S},
   R⁴¹ is a hydrogen atom or a C₁₋₆ alkyl group,
   R^{S} is a group represented by the following formula: 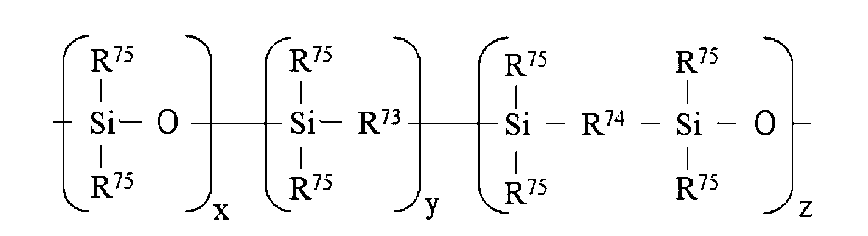 (wherein
      R⁷³ is each independently a single bond, a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
      R⁷⁴ is each independently a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
         R⁷⁶ is each independently a C₁₋₆ alkylene group,
         R⁷⁷ is each independently an optionally substituted phenylene group or naphthylene group,
         R⁷⁸ is each independently a single bond or a C₁₋₆ alkylene group,
         R⁷⁹ is each independently a single bond or an oxygen atom,
      R⁷⁵ is each independently a hydrocarbon group,
      x is an integer of 0 to 500,
      y is an integer of 0 to 500,
      z is an integer of 0 to 500,
      x + y + z is 1 or more, and
      the occurrence order of the respective repeating units enclosed in parentheses provided with x, y, or z is not limited in the formula),
      a0 is 0 or 1,
      a1 is an integer of 1 to 5,
      a2 is an integer of 0 to 5, and
      the occurrence order of the respective repeating units enclosed in parentheses provided with a1 or a2 is not limited in the formula; or
      a group represented by formula (X^{A1}): 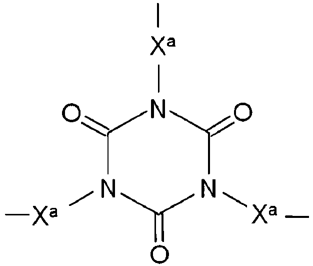
   wherein X^{a} is each independently a single bond or a divalent linking group.
[10] The silane compound according to [9], wherein X¹¹ is a divalent hydrocarbon group.
[11] The silane compound according to any one of [2] to [10], wherein R^{A} is the following group: 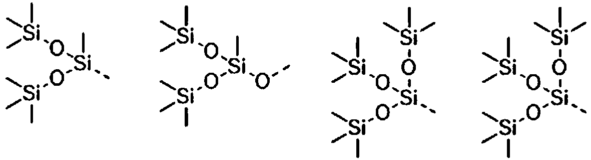 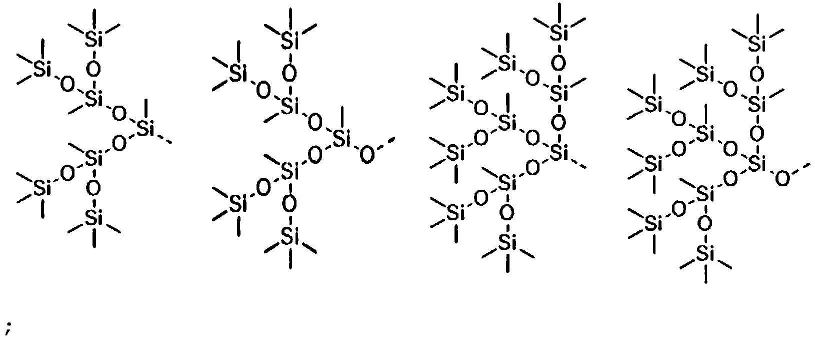 X¹ is the following group:
   C₁₋₃₀ alkylene,
   C₁₋₃₀ alkylene-CONH-C₁₋₃₀ alkylene,
   C₁₋₃₀ alkylene-OCO-C₁₋₃₀ alkylene,
   -OCO-C₁₋₃₀ alkylene,
   -OSi(CH₃)₂-C₁₋₃₀ alkylene-CONH-C₁₋₃₀ alkylene,
   -OSi(CH₃)₂-C₁₋₃₀ alkylene-OCO-C₁₋₃₀ alkylene,
   -Si(CH₃)₂-C₁₋₃₀ alkylene-CONH-C₁₋₃₀ alkylene,
   -Si(CH₃)₂-C₁₋₃₀ alkylene-OCO-C₁₋₃₀ alkylene,
   C₁₋₃₀ alkylene-CO-,
   (C₁₋₁₀ alkylene)₃C-C₁₋₃₀ alkylene-CONH-C₁₋₃₀ alkylene,
   (C₁₋₁₀ alkylene)₃C-C₁₋₃₀ alkylene-OCO-C₁₋₃₀ alkylene, or
   [C₁₋₁₀ alkylene-O-]₂phenyl-CONH-C₁₋₃₀ alkylene; and
   R^{Si} is -Si (OCH₃)₃, -Si (CH₃)(CH₂CH₂CH₂-Si(OCH₃)₃)₂, - CH(CH₂CH₂CH₂-Si (OCH₃)₃)₂, -C(CH₂CH₂CH₂-Si(OCH₃)₃)₃, and - N(CH₂CH₂CH₂-Si(OCH₃)₃)₂.
[12] The compound according to any one of [2] to [12], which is selected from the following compounds:

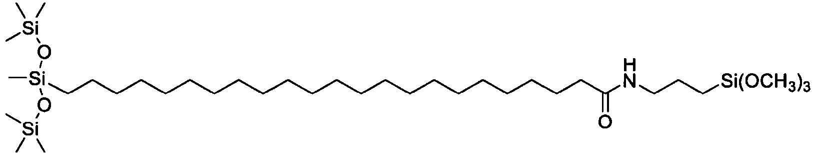

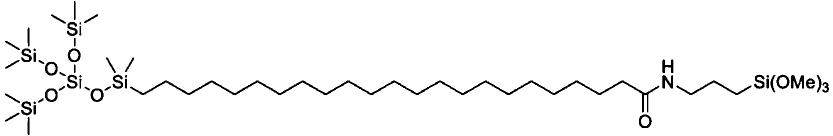

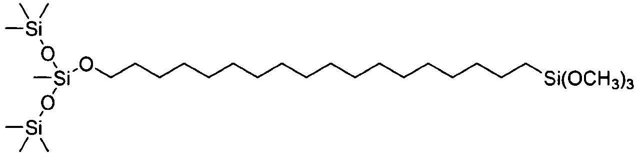

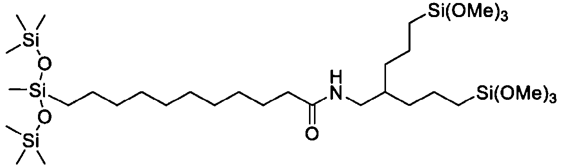

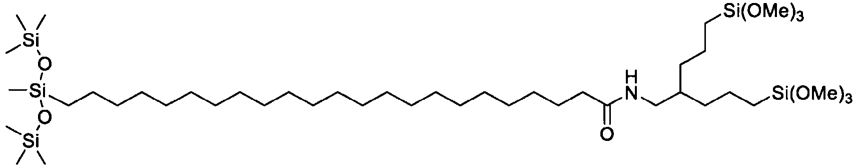

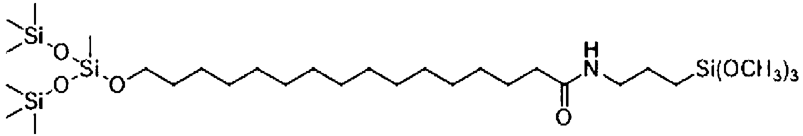

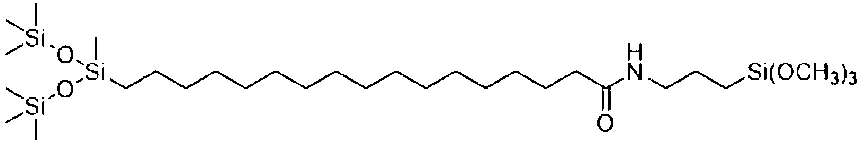

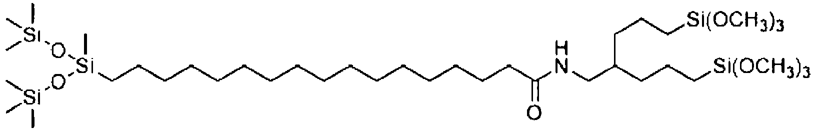

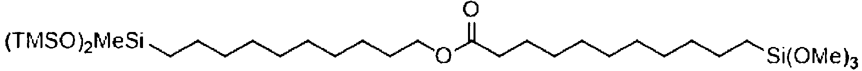

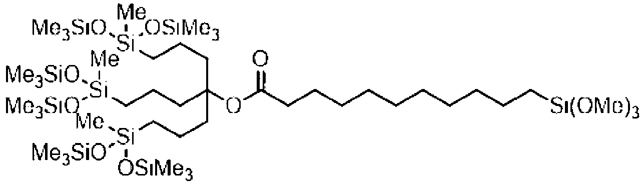

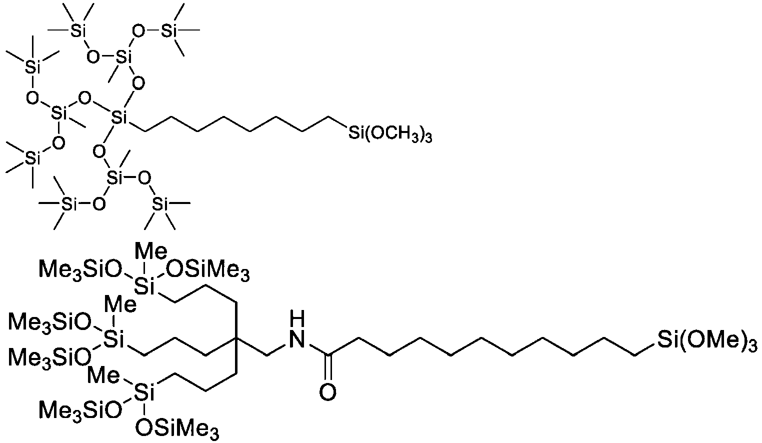

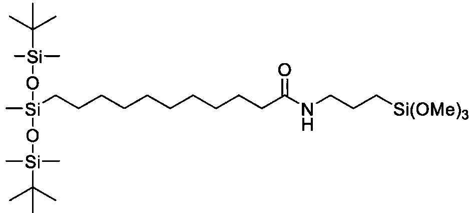

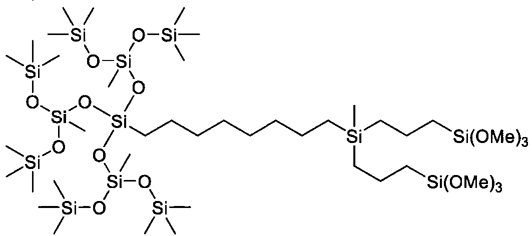

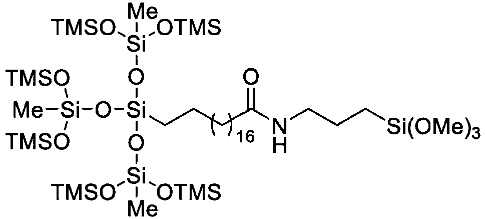

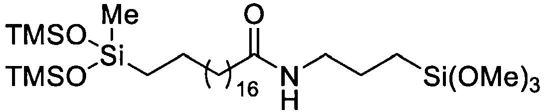

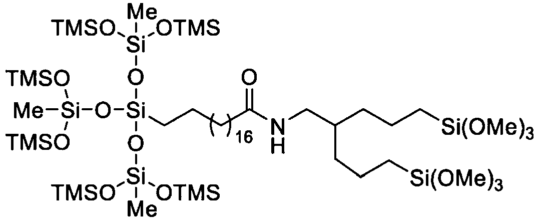

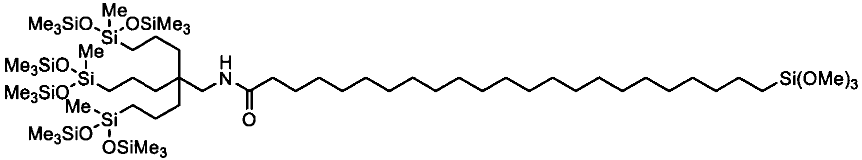

   ((CH₃)₃SiO)₂SiCH₃(CH₂)₂₂CON((CH₂)₃Si(OCH₃)₃)₂,

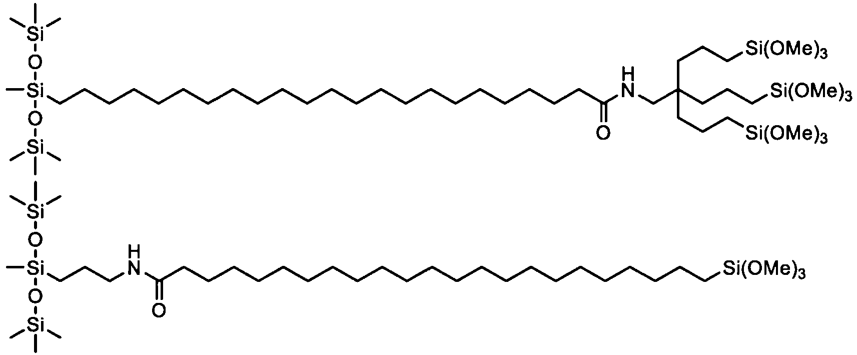

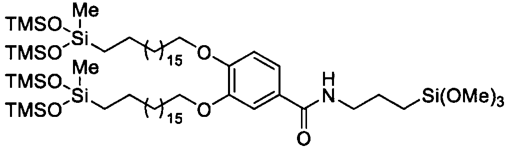

   ((CH₃)₃SiO)₂SiCH₃(CH₂)₂₁CONH(CH₂)₃Si(OCH₃)₃,

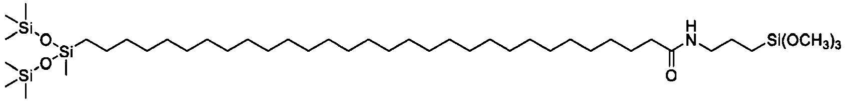

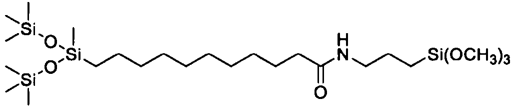

   [(CH₃)₃SiO]₂CH₃Si(CH₃)₂O(Si(CH₃)₂O)ₙSi(CH₃)₂CH₂CH₂CH₂CH₂CH₂CH₂ CH₂CH₂CH₂CH₂CH₂CH₂CH₂CH₂CH₂CH₂CH₂CH₂CH₂CH₂CH₂CH₂CONHCH₂CH₂CH₂Si (OCH₃)₃ wherein n is an integer of 2 to 20, [(CH₃)₃SiO]₃Si(CH₃)₂O(Si(CH₃)₂O)ₙSi(CH₃)₂CH₂CH₂CH₂CH₂CH₂CH₂CH₂ CH₂CH₂CH₂CH₂CH₂CH₂CH₂CH₂CH₂CH₂CH₂CH₂CH₂CH₂CH₂CONHCH₂CH₂CH₂Si(OC H₃)₃ wherein n is an integer of 2 to 20, and 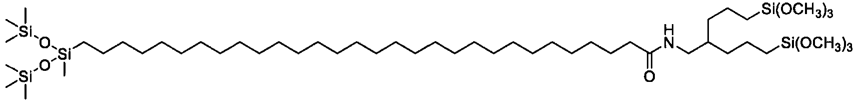 wherein TMSO is a trimethylsilyloxy group.
[13] A composition comprising the compound according to any one of [1] to [12] and a compound represented by formula (3):

   R⁵¹-R⁵²-CONR⁵⁴-R⁵³-SiR¹¹ₙ₁R¹²₃₋ₙ₁ (3)

   wherein
   R⁵¹ is CH₃CH₂CH₂-, CH₃CH=CH-, or R¹²₃₋ₙ₁R¹¹ₙ₁Si-,
   R⁵² is a C₀₋₃₀ alkylene group,
   R⁵³ is a C₁₋₁₀ alkylene group,
   R⁵⁴ is a hydrogen atom, a C₁₋₆ alkyl group, or a phenyl group,
   R¹¹ is each independently a hydroxyl group or a hydrolyzable group,
   R¹² is each independently a hydrogen atom or a monovalent organic group, and
   n1 is an integer of 1 to 3.
[14] The composition according to [13], comprising the compound represented by formula (3) in an amount of 0.1% by mass to 30% by mass based on the sum of the compound represented by formula (1) and the compound represented by the formula (3).
[15] The composition according to [13], which is a surface-treating agent.
[16] A surface-treating agent comprising the silane compound according to any one of [1] to [12].
[17] The surface-treating agent according to [16], further comprising a condensate of the silane compound according to any one of [1] to [12].
[18] The surface-treating agent according to [16] or [17], further comprising an alcohol represented by R⁹⁰-OH, wherein R⁹⁰ is a monovalent organic group.
[19] The surface-treating agent according to any one of [16] to [17], which is for vacuum deposition.
[20] The surface-treating agent according to any one of [16] to [18], which is for wet coating.
[21] A pellet comprising the surface-treating agent according to any one of [16] to [20].
[22] An article comprising a substrate and a layer on the substrate, wherein the layer is formed from the silane compound according to any one of [1] to [12].
[23] The article according to [22], comprising, between the substrate and the aforementioned layer, a silicon oxide-containing intermediate layer.
[24] The article according to [23], wherein the intermediate layer comprises an alkali metal atom.
[25] The article according to [24], wherein the alkali metal atom is at least partially sodium.
[26] The article according to any one of [22] to [25], which is an optical member.
[27] The article according to [26], which is a display.
[28] A compound represented by the following formula:

   CH₂=CH- (CH₂)ₙ₁₁₁COR¹¹¹

   wherein n111 is an integer of 25 or more, and
   R¹¹¹ is a hydrogen atom, a hydroxyl group, or a saturated or unsaturated hydrocarbon group having 1 to 12 carbon atoms and optionally substituted with a halogen.
[29] A compound represented by the following formula:

   CH₂=CH- (CH₂)ₙ₁₁₂COR¹¹²

   wherein n112 is an integer of 7 or more, and
   R¹¹² is an electron-withdrawing group containing an oxygen atom or a nitrogen atom directly bonded to a carbonyl group.
[30] A compound represented by the following formula:

   R^{A}-X¹¹¹-Rⁱ

   wherein
   R^{A} is a group A,
   R¹ is COOR¹¹³, CONR¹¹⁴₂, CONR¹¹³-R¹¹⁵-CR¹¹⁴₃, or COR¹¹⁶,
      R¹¹³ is a hydrogen atom, a hydroxyl group, or a saturated or unsaturated hydrocarbon group having 1 to 12 carbon atoms and optionally substituted with a halogen,
      R¹¹⁴ is an alkenyl group having 2 to 20 carbon atoms and having a double bond at a terminal,
      R¹¹⁵ is a divalent organic group,
      R¹¹⁶ is an electron-withdrawing group containing an oxygen atom or a nitrogen atom directly bonded to a carbonyl group, and
   X¹¹¹ is an alkylene group having 8 or more carbon atoms.

### Advantageous Effect of Invention

The present disclosure can provide a silane compound capable of forming a surface-treating layer having higher oil-repellency and friction durability.

### Description of Embodiments

The term "monovalent organic group" as used herein refers to a carbon-containing monovalent group. The monovalent organic group is not limited, and may be a hydrocarbon group or a derivative thereof. The derivative of a hydrocarbon group refers to a group that has one or more of N, O, S, Si, amide, sulfonyl, siloxane, carbonyl, carbonyloxy, and the like at the terminal or in the molecular chain of the hydrocarbon group. The term simply referred to as an "organic group" means a monovalent organic group. The term "divalent organic group" refers to a carbon-containing divalent group. The divalent organic group may be, for example, a divalent group obtained by further removing one hydrogen atom from the organic group. Similarly, an organic group having a valence of 3 or more refers to a group obtained by removing a predetermined number of hydrogen atoms from an organic group.

The "hydrocarbon group" as used herein refers to a group containing carbon and hydrogen and a group in which a hydrogen atom is removed from the hydrocarbon. Examples of the hydrocarbon group include, but are not limited to, C₁₋₂₀ hydrocarbon groups, such as an aliphatic hydrocarbon group and an aromatic hydrocarbon group. The "aliphatic hydrocarbon group" may be either linear, branched, or cyclic, and may be either saturated or unsaturated. The hydrocarbon group may contain one or more ring structures. The hydrocarbon group may be substituted with one or more substituents.

Examples of the substituent of the "hydrocarbon group" as used herein include, but are not limited to, a halogen atom; and one or more groups selected from a C₁₋₆ alkyl group, a C₂₋₆ alkenyl group, a C₂₋₆ alkynyl group, a C₃₋₁₀ cycloalkyl group, a C₃₋₁₀ unsaturated cycloalkyl group, a 5- to 10-membered heterocyclyl group, a 5- to 10-membered unsaturated heterocyclyl group, a C₆₋₁₀ aryl group, and a 5- to 10-membered heteroaryl group each optionally substituted with one or more halogen atoms.

The "hydrolyzable group" as used herein refers to a group that can undergo a hydrolysis reaction, i.e., refers to a group that can be removed from the main backbone of the compound by a hydrolysis reaction. Examples of the hydrolyzable group include -OR^{h}, -OCOR^{h}, -O-N=CR^{h}₂, -NR^{h}₂, -NHR^{h}, or -NCO (in these formulae, R^{h} represents a substituted or unsubstituted alkyl group having 1 to 4 carbon atoms), and -OR^{h} (i.e., an alkoxy group) is preferable. Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable.

The silane compound of the present disclosure has
the following group A at a terminal:

R¹ₙₐR²₃₋ₙₐSi-(O)_{z}- (A)

wherein
R¹ is each independently a group represented by -(R⁴-OSiR³₂)ₘₐ-R³,
   R⁴ is each independently an oxygen atom or a C₁₋₆ alkylene group,
   R³ is each independently a hydrocarbon group or R^{1'},
      R^{1'} has the same meaning as R¹,
   ma is each independently an integer of 1 to 5, provided that the number of R^{1'} in R¹ is 20 or less, R² is each independently a hydrocarbon group,
na is 1 to 3, and
z is 0 or 1; and
a Si atom to which a hydroxyl group or a hydrolyzable group is bonded, at another terminal.
R¹ is each independently a group represented by -(R⁴-SiR³₂)ₘₐ-R³
R⁴ is each independently an oxygen atom or a C₁₋₆ alkylene group.

The C₁₋₆ alkylene group in R⁴ may be linear or may be branched. The C₁₋₆ alkylene group is preferably a C₁₋₄ alkylene group, and more preferably a C₂₋₄ alkylene group.

In one embodiment, R⁴ is O.

In one embodiment, some R⁴ groups are O, and other R⁴ groups are C₁₋₆ alkylene groups.

R³ is each independently a hydrocarbon group or R^{1'}.

The hydrocarbon group in R³ may preferably be an alkyl group or an aryl group.

The alkyl group may be linear or may be branched. The alkyl group is preferably an alkyl group having 1 to 6 carbon atoms, and more preferably an alkyl group having 1 to 4 carbon atoms. The alkyl group is particularly preferably a methyl group, an ethyl group, a n-propyl group, an iso-propyl group, or a tert-butyl group.

The aryl group may be monocyclic or may be polycyclic. The aryl group is preferably an aryl group having 6 to 20 carbon atoms, and more preferably an aryl group having 6 to 10 carbon atoms. The aryl group is particularly preferably a phenyl group.

R³ is preferably an alkyl group, and more preferably an alkyl group having 1 to 4 carbon atoms.

R^{1'} has the same meaning as R¹. That is, R^{1'} is -(R⁴-SiR³₂)ₘₐ-R³. However, in R¹, the number of R^{1'} is 20 or less, preferably 10 or less, more preferably 6 or less, and even more preferably 3 or less.

In one embodiment, R³ is each independently a hydrocarbon group or R^{1'}.

In a preferable embodiment, R³ is each independently a hydrocarbon group.

In one embodiment, R³ is - (R^{4'}-SiR^{3'}₂)_{ma'}-R^{3'}, wherein
R^{3'} is each independently a hydrocarbon group or - (R⁴-SiR³₂)ₘₐ-R³,
at least one R^{3'} is -(R⁴-SiR³₂)ₘₐ-R³,
   R³ is each independently a hydrocarbon group,
   R⁴ is each independently an oxygen atom or a C₁₋₆ alkylene group,
   ma is each independently an integer of 1 to 5,
R^{4'} is each independently an oxygen atom or a C₁₋₆ alkylene group, and
ma' is each independently an integer of 1 to 5.

In another embodiment, R³ is - (R^{4'}-SiR^{3'}₂)_{ma'}-R^{3'}, wherein
R^{3'} is each independently a hydrocarbon group or - (R^{4"}-SiR^{3"}₂)_{ma"}-R^{3"} ,
at least one R^{3'} is -(R^{4"}-SiR^{3"}₂)_{ma"}-R^{3"},
   R^{3"} is each independently a hydrocarbon group or - (R⁴-SiR³₂)ₘₐ-R³,
   at least one R^{3"} is -(R⁴-SiR³₂)ₘₐ-R³,
      R³ is each independently a hydrocarbon group,
      R⁴ is each independently an oxygen atom or a C₁₋₆ alkylene group,
      ma is each independently an integer of 1 to 5,
   R^{4"} is each independently an oxygen atom or a C₁₋₆ alkylene group,
   ma" is each independently an integer of 1 to 5,
R^{4'} is each independently an oxygen atom or a C₁₋₆ alkylene group, and
ma' is each independently an integer of 1 to 5.
ma is each independently an integer of 1 to 5, and preferably 1 or 2.
R² is each independently a hydrocarbon group.

The hydrocarbon group in R² may preferably be an alkyl group or an aryl group.

The alkyl group may be linear or may be branched. The alkyl group is preferably an alkyl group having 1 to 6 carbon atoms, and more preferably an alkyl group having 1 to 4 carbon atoms. The alkyl group is particularly preferably a methyl group, an ethyl group, a n-propyl group, an iso-propyl group, or a tert-butyl group.

The aryl group may be monocyclic or may be polycyclic. The aryl group is preferably an aryl group having 6 to 20 carbon atoms, and more preferably an aryl group having 6 to 10 carbon atoms. The aryl group is particularly preferably a phenyl group.

R² is preferably an alkyl group, and more preferably an alkyl group having 1 to 4 carbon atoms.

na is 1 to 3. In one embodiment, na is 2. In another embodiment, na is 3. Note that na, when R^{1'} is present, is independently selected for (R⁴-SiR³₂)ₘₐ.

z is 0 or 1. In one embodiment, z is 0. In another embodiment, z is 1.

In R¹, 2 or more, preferably 3 or more, more preferably 4 or more, and even more preferably 6 or more, such as 8 or more, 9 or more, 10 or more, or 12 or more Si-O bonds are present.

In a preferable embodiment, in the group A,
R¹ is each independently a group represented by -(R⁴-SiR³₂)ₘₐ-R³,
   R⁴ is each independently an oxygen atom or a C₁₋₆ alkylene group,
   R³ is each independently a hydrocarbon group (preferably an alkyl group having 1 to 4 carbon atoms) or R^{1'}, and preferably a hydrocarbon group (preferably an alkyl group having 1 to 4 carbon atoms),
      R^{1'} has the same meaning as R¹,
   ma is 1 or 2,
R² is each independently a hydrocarbon group and preferably an alkyl group having 1 to 4 carbon atoms, and
na is 1 to 3.

Examples of the group A include, but are not limited to, the following groups:

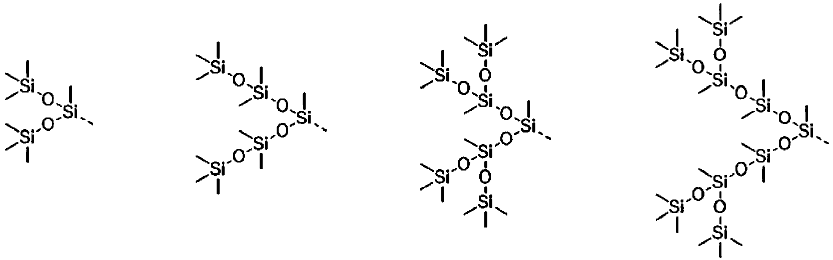

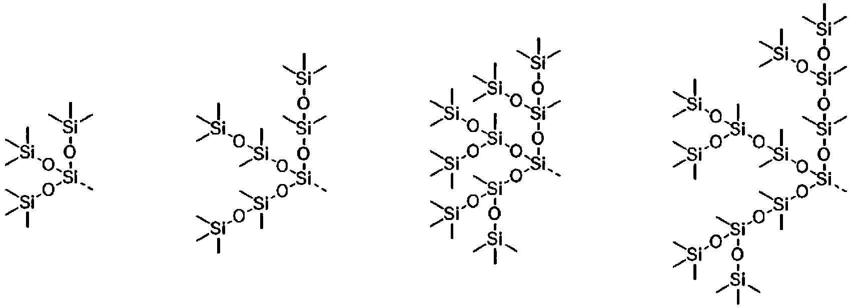

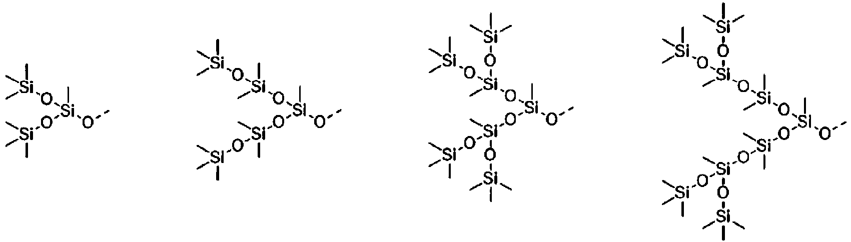

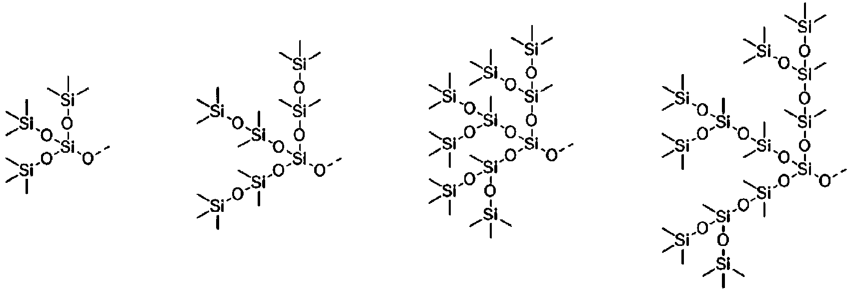

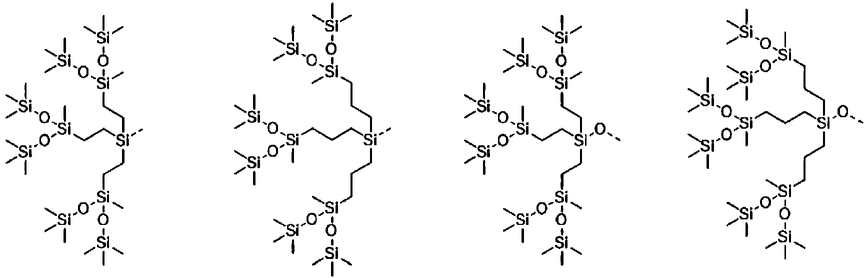

In one embodiment, the group A is the following group:

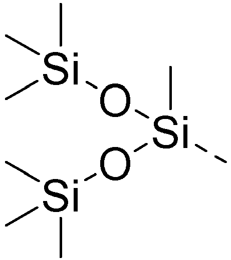

In one embodiment, the group A is the following group:

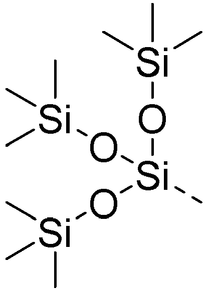

In a preferable embodiment, the silane compound is represented by the following formula (1):

R^{A}_{α}-X¹-R^{Si}_{β} (1)

wherein
R^{A} is a group A,
X¹ is a di- to decavalent group,
R^{Si} is a monovalent group containing a Si atom to which a hydroxyl group or a hydrolyzable group is bonded,
α is an integer of 1 to 9, and
β is an integer of 1 to 9.

In the formula, the group A has the same meaning as above.

X¹ is interpreted as a linker connecting the siloxane moiety (R¹) that mainly provides functions such as water-repellency and the silane moiety (R^{Si}) that provides an ability to bind to a substrate. Accordingly, X¹ is not limited as long as the silane compound represented by the formula (1) can stably exist.

In the formula (1), α is an integer of 1 to 9, and β is an integer of 1 to 9. These α and β may vary depending on the valence of X¹. The sum of α and β is the same as the valence of X¹. For example, when X¹ is a decavalent organic group, the sum of α and β is 10. For example, α may be 9, and β may be 1; α may be 5, and β may be 5; or α may be 1, and β may be 9. When X¹ is a divalent organic group, α and β are each 1.

X¹ is a di- to decavalent group.

The di- to decavalent group is preferably a di- to tetravalent group, and more preferably a divalent group. In another embodiment, the di- to decavalent organic group is preferably a tri- to octavalent organic group, and more preferably a tri- to hexavalent organic group.

In one embodiment, X¹ is a divalent group, and α and β are 1.

In one embodiment, X¹ is a tri- to hexavalent group, α is 1, and β is 2 to 5.

In one embodiment, X¹ is a trivalent organic group; and α is 2 and β is 1, or α is 1 and β is 2.

In one embodiment, X¹ may be a di- to decavalent group such as a di- or trivalent group, including -CO-, - COO-, -OCO-, -NR⁴¹-, -CONR⁴¹-, -NR⁴¹CO-, -OCONR⁴¹-, -NR⁴¹-CO-NR⁴¹-, -O-, -S-, -CON=, or R^{S}.

In one embodiment, X¹ is a divalent organic group including -CONR⁴¹-.

In one embodiment, X¹ is a divalent organic group including -CONH-. When X¹ contains a -CONH- group, intermolecular interactions due to hydrogen bonding occur, a packing structure is formed, and thus abrasion resistance may be improved.

R⁴¹ is a hydrogen atom or a C₁₋₆ alkyl group. The C₁₋₆ alkyl group in R⁴¹ may be linear or may be branched. In one embodiment, the C₁₋₆ alkyl group is linear. In another embodiment, the C₁₋₆ alkyl group is branched. The C₁₋₆ alkyl group is preferably a C₁₋₄ alkyl group, more preferably a C₁₋₃ alkyl group, even more preferably a methyl group or an ethyl group, and particularly preferably a methyl group.

In one embodiment, R⁴¹ is a hydrogen atom.

In one embodiment, R⁴¹ is a C₁₋₆ alkyl group, and preferably a methyl group.

R^{S} is a group represented by the following formula: 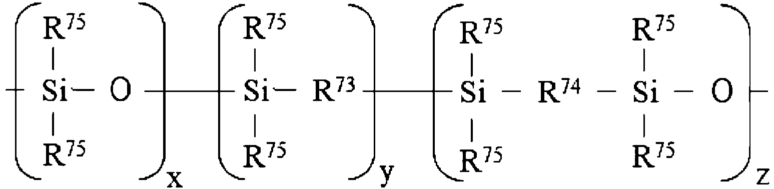 wherein
R⁷³ is each independently a single bond, a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
   R⁷⁶ is each independently a C₁₋₆ alkylene group,
   R⁷⁷ is each independently an optionally substituted phenylene group or naphthylene group,
   R⁷⁸ is each independently a single bond or a C₁₋₆ alkylene group,
   R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula.
R⁷³ is each independently a single bond, a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-, and is preferably a C₁₋₁₂ alkylene group or -R⁷⁶-OR⁷⁶-.

In one embodiment, R⁷³ is a single bond.

In one embodiment, R⁷³ is a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-, and is preferably a C₁₋₁₂ alkylene group or -R⁷⁶-O-R⁷⁶-.

R⁷⁴ is each independently a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹- .

In one embodiment, R⁷⁴ is each independently a C₁₋₁₂ alkylene group or -R⁷⁶-O-R⁷⁶-.

In another embodiment, R⁷⁴ is each independently - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-.

In one embodiment, R⁷³ is each independently a C₁₋₁₂ alkylene group or -R⁷⁶-O-R⁷⁶-, and R⁷⁴ is each independently a C₁₋₁₂ alkylene group or -R⁷⁶-O-R⁷⁶-.

In another embodiment, R⁷³ is each independently a C₁₋₁₂ alkylene group or -R⁷⁶-O-R⁷⁶-, and R⁷⁴ is each independently -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-.

The C₁₋₁₂ alkylene group may be linear or may be branched. The C₁₋₁₂ alkylene group is preferably linear.

The C₁₋₁₂ alkylene group is preferably a C₂₋₈ alkylene group, and more preferably a C₂₋₆ alkylene group.

R⁷⁶ is each independently a C₁₋₆ alkylene group. The C₁₋₆ alkylene group may be linear or may be branched. The C₁₋₆ alkylene group is preferably linear.

The C₁₋₆ alkylene group is preferably a C₂₋₄ alkylene group, and more preferably a C₂₋₃ alkylene group.

In a preferable embodiment, in a group containing a plurality of R⁷⁶, all R⁷⁶ are the same group.

R⁷⁷ is each independently an optionally substituted arylene group.

In one embodiment, R⁷⁷ is each independently

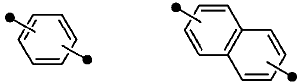

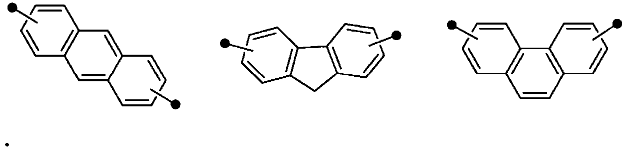

In one embodiment, R⁷⁷ is a phenylene group.

In another embodiment, R⁷⁷ is a naphthylene group.

The arylene group may have a substituent. The number of substituents is not limited, and is, for example, 1 to 4, and preferably 1 or 2.

In one embodiment, the phenylene group and the naphthylene group may have a substituent. The number of substituents is not limited, and is, for example, 1 to 4, and preferably 1 or 2. The substituted phenylene group is preferably 2,5-substituted phenylene.

The substituent with respect to the arylene group is each independently -R⁴¹-R⁴².

R⁴¹ is a single bond, an oxygen atom, or a sulfur atom, preferably a single bond or an oxygen atom, and more preferably an oxygen atom.

R⁴² is a C₁₋₁₂ alkyl group, -(O-R⁴³)ₚ, -R⁴⁴-R⁴⁵, or -R⁴⁴-OR⁴⁶, all of which are optionally substituted with a halogen.

The halogen is fluorine, chlorine, bromine, or iodine, and is preferably fluorine.

The C₁₋₁₂ alkyl group in R⁴² may be linear or may be branched.

R⁴³ is a C₁₋₆ alkylene group, and preferably a C₂₋₄ alkylene group. Such an alkylene group may be linear or may be branched.

R⁴⁴ is a C₁₋₁₂ alkylene group, and preferably a C₁₋₆ alkylene group. Such an alkylene group may be linear or may be branched.

R⁴⁵ is -CH=CH₂ or -OCOCH=CH₂.

R⁴⁶ is a hydrogen atom or a C₁₋₆ alkyl group. Such an alkyl group may be linear or may be branched. The C₁₋₆ alkyl group is preferably a C₁₋₃ alkyl group, more preferably a C₁₋₂ alkyl group, and even more preferably a methyl group.

R⁷⁸ is each independently a single bond or a C₁₋₆ alkylene group. Such a C₁₋₆ alkylene group may be linear or may be branched.

In one embodiment, R⁷⁸ is a single bond.

In another embodiment, R⁷⁸ is a C₁₋₆ alkylene group.

R⁷⁹ is each independently a single bond or an oxygen atom.

In one embodiment, R⁷⁹ is a single bond.

In another embodiment, R⁷⁹ is an oxygen atom.

R⁷⁵ is each independently a hydrocarbon group. Such a hydrocarbon group may be substituted.

R⁷⁵ is, each independently, preferably an unsubstituted hydrocarbon group or a hydrocarbon group substituted with a halogen atom. Such a halogen atom is preferably a fluorine atom.

R⁷⁵ is, each independently, preferably a C₁₋₁₈ alkyl group or aryl group optionally substituted with a halogen atom, and more preferably a C₁₋₁₈ alkyl group or aryl group.

The C₁₋₁₈ alkyl group may be linear or may be branched, and is preferably linear. The C₁₋₁₈ alkyl group is preferably a C₁₋₁₀ alkyl group, more preferably a C₁₋₆ alkyl group, even more preferably a C₁₋₄ alkyl group, and yet more preferably a methyl group.

The aryl group is preferably a phenyl group.

In one embodiment, R⁷⁵ is each independently a C₁₋₆ alkyl group, preferably a C₁₋₄ alkyl group, and more preferably a methyl group.

In another embodiment, R⁷⁵ is a phenyl group.

In another embodiment, R⁷⁵ is each independently a methyl group or a phenyl group, and preferably a methyl group.

x is an integer of 0 to 500, preferably an integer of 0 to 300, more preferably an integer of 0 to 100, even more preferably an integer of 1 to 100, yet more preferably an integer of 5 to 50, and further preferably an integer of 10 to 30, such as 1 to 20, 2 to 20, 1 to 10, or 2 to 20.

In one embodiment, x is 0.

In one embodiment, x is an integer of 1 to 500, preferably an integer of 1 to 300, more preferably an integer of 1 to 100, even more preferably an integer of 5 to 50, and yet more preferably an integer of 10 to 30.

y is an integer of 0 to 500, preferably an integer of 0 to 300, more preferably an integer of 0 to 100, even more preferably an integer of 1 to 100, yet more preferably an integer of 5 to 50, and further preferably an integer of 10 to 30, such as 1 to 20, 2 to 20, 1 to 10, or 2 to 20.

In one embodiment, y is 0.

In one embodiment, y is an integer of 1 to 500, preferably an integer of 1 to 300, more preferably an integer of 1 to 100, even more preferably an integer of 5 to 50, and yet more preferably an integer of 10 to 30.

z is an integer of 0 to 500, preferably an integer of 0 to 300, more preferably an integer of 0 to 100, even more preferably an integer of 1 to 100, yet more preferably an integer of 5 to 50, and further preferably an integer of 10 to 30, such as 1 to 20, 2 to 20, 1 to 10, or 2 to 20.

In one embodiment, z is 0.

In one embodiment, z is an integer of 1 to 500, preferably an integer of 1 to 300, more preferably an integer of 1 to 100, even more preferably an integer of 5 to 50, and yet more preferably an integer of 10 to 30.

In one embodiment, y is 0, and z is 0.

The divalent siloxane-containing group may be a random polymer, or may be a block polymer.

In a preferable embodiment, X¹ is a group represented by the following formula:

- (X²¹)ₐ₀-[(X¹¹)ₐ₁-(X¹²)ₐ₂]-

wherein
X²¹ is an optionally substituted tri- to hexavalent aromatic group, R⁶¹_{b1}R⁶²_{3-b1}C-, R⁶³_{b2}R⁶⁴_{3-b2}Si-, or R⁶⁵₂N-,
   R⁶¹ is each independently a single bond or a divalent organic group,
   R⁶² is each independently a hydrogen atom or a monovalent organic group,
   R⁶³ is each independently a single bond or a divalent organic group,
   R⁶⁴ is each independently a hydrogen atom or a monovalent organic group,
   R⁶⁵ is each independently a single bond or a divalent organic group,
   b1 is 2 or 3,
   b2 is 2 or 3,
X¹¹ is a single bond or a divalent organic group,
X¹² is -CO-, -COO-, -OCO-, -NR⁴¹-, -CONR⁴¹-, -NR⁴¹CO-, -OCONR⁴¹, -NR⁴¹COO-, -NR⁴¹-CO-NR⁴¹-, -O-, -S-, or R^{S},
   R⁴¹ is a hydrogen atom or a C₁₋₆ alkyl group,
   R^{S} is a group represented by the following formula: 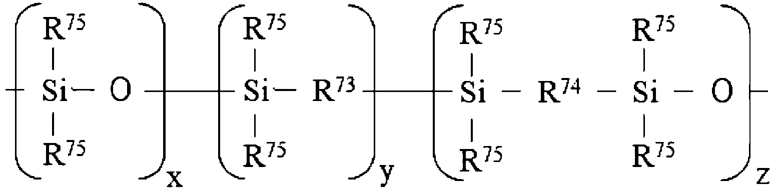 (wherein
      R⁷³ is each independently a single bond, a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
      R⁷⁴ is each independently a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
         R⁷⁶ is each independently a C₁₋₆ alkylene group,
         R⁷⁷ is each independently an optionally substituted phenylene group or naphthylene group,
         R⁷⁸ is each independently a single bond or a C₁₋₆ alkylene group,
         R⁷⁹ is each independently a single bond or an oxygen atom,
      R⁷⁵ is each independently a hydrocarbon group,
      x is an integer of 0 to 500,
      y is an integer of 0 to 500,
      z is an integer of 0 to 500,
      x + y + z is 1 or more, and
      the occurrence order of the respective repeating units enclosed in parentheses provided with x, y, or z is not limited in the formula),
      a0 is 0 or 1,
      a1 is an integer of 1 to 5,
      a2 is an integer of 0 to 5, and
      the occurrence order of the respective repeating units enclosed in parentheses provided with a1 or a2 is not limited in the formula; or
   a group represented by formula (X^{A1}): 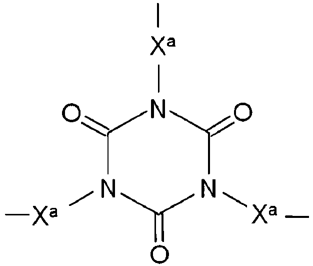 wherein X^{a} is each independently a single bond or a divalent linking group.

The left side of group X¹ binds to R¹ and the right side binds to R^{Si}.

X²¹ is an optionally substituted tri- to hexavalent aromatic group, R⁶¹_{b1}R⁶²_{3-b1}C-, R⁶³_{b2}R⁶⁴_{3-b2}Si-, or R⁶⁵₂N-.

The aromatic group in the optionally substituted tri- to hexavalent aromatic group is preferably a benzene ring or a naphthalene ring, and preferably a benzene ring. In a preferable embodiment, the optionally substituted tri- to hexavalent aromatic group is a phenyl group to which two or three R⁶¹ groups are bonded (R⁶¹-C₆H₄ - or (R⁶¹)₂C₆H₃-).

R⁶¹ is each independently a single bond or a divalent organic group.

R⁶¹ is preferably a C₁₋₆ alkylene group, -(CH₂)_{f1}-O-(CH₂)_{f2}- (wherein f1 is an integer of 0 to 6 such as an integer of 1 to 6, and f2 is an integer of 0 to 6 such as an integer of 1 to 6), or - (CH₂)_{f3}-phenylene-(CH₂)_{f4}-(wherein f3 is an integer of 0 to 6 such as an integer of 1 to 6, and f4 is an integer of 0 to 6 such as an integer of 1 to 6). Such a C₁₋₆ alkylene group may be linear or may be branched, and is preferably linear. These groups may be substituted with, for example, one or more substituents selected from, a fluorine atom, a C₁₋₆ alkyl group, a C₂₋₆ alkenyl group, and a C₂₋₆ alkynyl group, and are preferably unsubstituted.

In a preferable embodiment, R⁶¹ is a C₁₋₆ alkylene group or - (CH₂)_{f3}-phenylene- (CH₂)_{f4}-, and preferably - phenylene- (CH₂)_{f4}-.

In another preferable embodiment, R⁶¹ is a C₁₋₃ alkylene group. In one embodiment, R⁶¹ may be -CH₂CH₂CH₂-. In another embodiment, R⁶¹ may be -CH₂CH₂-.

R⁶² is each independently a hydrogen atom or a monovalent organic group.

In one embodiment, R⁶² is a hydrogen atom.

In another embodiment, R⁶² is a monovalent organic group.

In R⁶², the monovalent organic group is preferably a C₁₋₂₀ alkyl group, more preferably a C₁₋₆ alkyl group, and even more preferably a methyl group.

b1 is 2 or 3. In one embodiment, b1 is 2. In another embodiment, b1 is 3.

R⁶³ is each independently a single bond or a divalent organic group.

R⁶³ is preferably a C₁₋₆ alkylene group, -(CH₂)_{g1}-O-(CH₂)_{g2}- (wherein g1 is an integer of 0 to 6 such as an integer of 1 to 6, and g2 is an integer of 0 to 6 such as an integer of 1 to 6), or - (CH₂)_{g3}-phenylene-(CH₂)_{g4}-(wherein g3 is an integer of 0 to 6 such as an integer of 1 to 6, and g4 is an integer of 0 to 6 such as an integer of 1 to 6). Such a C₁₋₆ alkylene group may be linear or may be branched, and is preferably linear. These groups may be substituted with, for example, one or more substituents selected from, a fluorine atom, a C₁₋₆ alkyl group, a C₂₋₆ alkenyl group, and a C₂₋₆ alkynyl group, and are preferably unsubstituted.

In a preferable embodiment, R⁶³ is a C₁₋₆ alkylene group or -(CH₂)_{g3}-phenylene-(CH₂)_{g4}-, and preferably - phenylene-(CH₂)_{g4}-.

In another preferable embodiment, R⁶³ is a C₁₋₃ alkylene group. In one embodiment, R⁶³ may be -CH₂CH₂CH₂-. In another embodiment, R⁶³ may be -CH₂CH₂-.

R⁶⁴ is each independently a hydrogen atom or a monovalent organic group.

In one embodiment, R⁶⁴ is a hydrogen atom.

In another embodiment, R⁶⁴ is a monovalent organic group.

In R⁶⁴, the monovalent organic group is preferably a C₁₋₂₀ alkyl group, more preferably a C₁₋₆ alkyl group, and even more preferably a methyl group.

b2 is 2 or 3. In one embodiment, b2 is 2. In another embodiment, b2 is 3.

R⁶⁵ is each independently a single bond or a divalent organic group.

R⁶⁵ is preferably a C₁₋₆ alkylene group, -(CH₂)ₕ₁-O-(CH₂)ₕ₂- (wherein h1 is an integer of 0 to 6 such as an integer of 1 to 6, and h2 is an integer of 0 to 6 such as an integer of 1 to 6), or -(CH₂)ₕ₃-phenylene-(CH₂)ₕ₄-(wherein h3 is an integer of 0 to 6 such as an integer of 1 to 6, and h4 is an integer of 0 to 6 such as an integer of 1 to 6). Such a C₁₋₆ alkylene group may be linear or may be branched, and is preferably linear. These groups may be substituted with, for example, one or more substituents selected from, a fluorine atom, a C₁₋₆ alkyl group, a C₂₋₆ alkenyl group, and a C₂₋₆ alkynyl group, and are preferably unsubstituted.

In a preferable embodiment, R⁶⁵ is a C₁₋₆ alkylene group or -(CH₂)ₕ₃-phenylene-(CH₂)ₕ₄-, and preferably - phenylene-(CH₂)ₕ₄-.

In another preferable embodiment, R⁶⁵ is a C₁₋₃ alkylene group. In one embodiment, R⁶⁵ may be -CH₂CH₂CH₂-. In another embodiment, R⁶⁵ may be -CH₂CH₂-.

In one embodiment, X²¹ is R⁶¹_{b1}R⁶²_{3-b1}C-.

In one embodiment, X²¹ is R⁶³_{b2}R⁶⁴_{3-b2}Si-.

In one embodiment, X²¹ is R⁶⁵₂N-.

X¹¹ is a single bond or a divalent organic group.

The divalent organic group is preferably a divalent hydrocarbon group.

The hydrocarbon group in X¹¹ is preferably a hydrocarbon group having 1 to 30 carbon atoms.

The hydrocarbon group may preferably be an alkylene group or an arylene group.

The alkylene group may be linear or may be branched. The alkylene group may preferably be an alkylene group having 1 to 30 carbon atoms.

In one embodiment, the alkylene group may be, for example, a C₁₋₁₀ alkylene group, a C₁₋₈ alkylene group, a C₁₋₆ alkylene group, a C₂₋₁₀ alkylene group, a C₂₋₈ alkylene group, or a C₂₋₆ alkylene group.

In one embodiment, the alkylene group may be, for example, a C₁₁₋₃₀ alkylene group. The number of carbon atoms of the alkylene group may preferably be 12 or more, more preferably 16 or more, even more preferably 18 or more, and yet more preferably 22 or more. The number of carbon atoms of the alkylene group in X¹ and X¹⁰ may preferably be 60 or less, more preferably 40 or less, even more preferably 30 or less, and yet more preferably 24 or less. The number of carbon atoms of the alkylene group in X¹ and X¹⁰ may preferably be 11 to 60, more preferably 12 to 40, and even more preferably 18 to 30.

The arylene group may be monocyclic or may be polycyclic. The arylene group is preferably an arylene group having 6 to 20 carbon atoms, and more preferably an arylene group having 6 to 10 carbon atoms. The arylene group is particularly preferably a phenylene group.

In one embodiment, X¹ is a group represented by:

-X¹³-X¹²-X¹⁴-

wherein
X¹³ is an alkylene group, an oxyalkylene group, -O-SiR⁴⁷₂-, -SiR⁴⁷₂-, or -(CⱼH₂ⱼ)ₖ₁-(O-CⱼH₂ⱼ)ₖ₂ wherein j is an integer of 1 to 6, k1 is 1 or 0, and k2 is an integer of 1 to 20,
   R⁴⁷ is a C₁₋₆ alkyl group, preferably a C₁₋₄ alkyl group, and more preferably a methyl group,
X¹² is -CO-, -COO-, -OCO-, -NR⁴¹-, -CONR⁴¹-, -NR⁴¹CO-, -OCONR⁴¹-, -NR⁴¹COO-, -NR⁴¹-CO-NR⁴¹-, -O-, or -S-, preferably -CO-, -NR⁴¹-, -CONR⁴¹-, or -NR⁴¹CO-, and more preferably -CONR⁴¹- or -NR⁴¹CO-,
   R⁴¹ is a hydrogen atom or a C₁₋₆ alkyl group, and preferably a hydrogen atom, and
X¹⁴ is a single bond or an alkylene group.

X¹³ is an alkylene group, an oxyalkylene group, -O-SiR⁴⁷₂-, -SiR⁴⁷₂-, or -(CⱼH₂ⱼ)ₖ₁-(O-CⱼH₂ⱼ)ₖ₂ wherein j is an integer of 1 to 6, k1 is 1 or 0, and k2 is an integer of 1 to 20.

The alkylene group may be linear or may be branched. The alkylene group may preferably be an alkylene group having 1 to 30 carbon atoms.

In one embodiment, the alkylene group may be, for example, a C₁₋₁₀ alkylene group, a C₁₋₈ alkylene group, a C₁₋₆ alkylene group, a C₂₋₁₀ alkylene group, a C₂₋₈ alkylene group, or a C₂₋₆ alkylene group.

In one embodiment, the alkylene group may be, for example, a C₁₁₋₃₀ alkylene group. The number of carbon atoms of the alkylene group may preferably be 12 or more, more preferably 16 or more, even more preferably 18 or more, and yet more preferably 22 or more. The number of carbon atoms of the alkylene group in X¹ and X¹⁰ may preferably be 60 or less, more preferably 40 or less, even more preferably 30 or less, and yet more preferably 24 or less. The number of carbon atoms of the alkylene group in X¹ and X¹⁰ may preferably be 11 to 60, more preferably 12 to 40, and even more preferably 18 to 30.

The oxyalkylene group is a group having an oxygen atom at the left terminal (the R¹ side) of the alkylene group, i.e., an -O-alkylene group.

j is an integer of 1 to 6, and preferably an integer of 2 to 4.

k1 is 1 or 0, and preferably 0.

k2 is an integer of 1 to 20, preferably an integer of 2 to 10, and more preferably an integer of 2 to 6.

X¹⁴ is an alkylene group.

The alkylene group may be linear or may be branched. The alkylene group may be an alkylene group preferably having 1 to 30 carbon atoms, preferably a C₁₋₁₀ alkylene group, more preferably a C₁₋₈ alkylene group, and even more preferably a C₁₋₆ alkylene group, such as a C₂₋₁₀ alkylene group, a C₂₋₈ alkylene group, or a C₂₋₆ alkylene group.

In one embodiment, X¹ is a group represented by the formula:

-O-R^{S}-X¹³-X¹²-X¹⁴-

wherein
R^{S} is a group represented by the following formula: 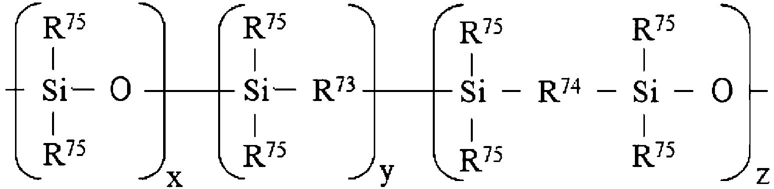 (wherein
R⁷³ is each independently a single bond, a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹- ,
R⁷⁴ is each independently a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
   R⁷⁶ is each independently a C₁₋₆ alkylene group,
   R⁷⁷ is each independently an optionally substituted phenylene group or naphthylene group,
   R⁷⁸ is each independently a single bond or a C₁₋₆ alkylene group,
   R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula),
X¹² is -CO-, -COO-, -OCO-, -NR⁴¹-, -CONR⁴¹-, -NR⁴¹CO-, -OCONR⁴¹-, -NR⁴¹COO-, -NR⁴¹-CO-NR⁴¹-, -O-, or -S-, preferably -CO-, -NR⁴¹-, -CONR⁴¹-, or -NR⁴¹CO-, and more preferably -CONR⁴¹- or -NR⁴¹CO-,
   R⁴¹ is a hydrogen atom or a C₁₋₆ alkyl group, and preferably a hydrogen atom,
X¹³ is an alkylene group, an oxyalkylene group, or - (CⱼH₂ⱼ)ₖ₁-(O-CⱼH₂ⱼ)ₖ₂ wherein j is an integer of 1 to 6, k1 is 1 or 0, and k2 is an integer of 1 to 20, and
X¹⁴ is a single bond or an alkylene group.

In one embodiment, X¹ is a group represented by the formula:

-X¹⁵-R^{S}-X¹³-X¹²-X¹⁴-

wherein
R^{S} is a group represented by the following formula: 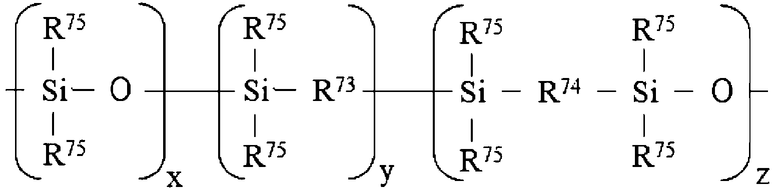 (wherein
R⁷³ is each independently a single bond, a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
   R⁷⁶ is each independently a C₁₋₆ alkylene group,
   R⁷⁷ is each independently an optionally substituted phenylene group or naphthylene group,
   R⁷⁸ is each independently a single bond or a C₁₋₆ alkylene group,
   R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula),
X¹² is -CO-, -COO-, -OCO-, -NR⁴¹-, -CONR⁴¹-, -NR⁴¹CO-, -OCONR⁴¹-, -NR⁴¹COO-, -NR⁴¹-CO-NR⁴¹-, -O-, or -S-, preferably -CO-, -NR⁴¹-, -CONR⁴¹-, or -NR⁴¹CO-, and more preferably -CONR⁴¹- or -NR⁴¹CO-,
   R⁴¹ is a hydrogen atom or a C₁₋₆ alkyl group, and preferably a hydrogen atom,
X¹³ is an alkylene group, an oxyalkylene group, or - (CⱼH₂ⱼ)ₖ₁-(O-CⱼH₂ⱼ)ₖ₂ wherein j is an integer of 1 to 6, k1 is 1 or 0, and k2 is an integer of 1 to 20,
X¹⁴ is a single bond or an alkylene group, and
X¹⁵ is an alkylene group, an oxyalkylene group, or - (CₚH₂ₚ)_{q1}-(O-CₚH₂ₚ)_{q2} wherein p is an integer of 1 to 6, q1 is 1 or 0, and q2 is an integer of 1 to 20.
X¹⁵ is an alkylene group, an oxyalkylene group, or - (CₚH₂ₚ)_{q1}-(O-CₚH₂ₚ)_{q2} wherein p is an integer of 1 to 6, q1 is 1 or 0, and q2 is an integer of 1 to 20.

The alkylene group may be linear or may be branched. The alkylene group may preferably be an alkylene group having 1 to 30 carbon atoms.

In one embodiment, the alkylene group may be, for example, a C₁₋₁₀ alkylene group, a C₁₋₈ alkylene group, a C₁₋₆ alkylene group, a C₂₋₁₀ alkylene group, a C₂₋₈ alkylene group, or a C₂₋₆ alkylene group.

The oxyalkylene group is a group having an oxygen atom at the left terminal (the R¹ side) of the alkylene group, i.e., an -O-alkylene group.

p is an integer of 1 to 6, and preferably an integer of 2 to 4.

q1 is 1 or 0, and preferably 0.

q2 is an integer of 1 to 20, preferably an integer of 2 to 10, and more preferably an integer of 2 to 6.

In one embodiment, X¹ may be a group represented by the following formula (X^{A1}): 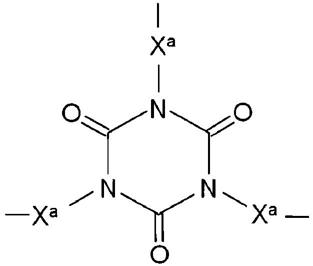 wherein X^{a} is a single bond or a divalent organic group.

X^{a} is a single bond or divalent linking group directly bonded to the isocyanuric ring. X^{a} is preferably a single bond, an alkylene group, or a divalent group containing at least one bond selected from the group consisting of an ether bond, an ester bond, an amide bond, and a sulfide bond, and more preferably a single bond, an alkylene group having 1 to 10 carbon atoms, or a divalent hydrocarbon group having 1 to 10 carbon atoms and containing at least one bond selected from the group consisting of an ether bond, an ester bond, an amide bond, and a sulfide bond.

X^{a} is even more preferably a group represented by the following formula:

-(CX¹²¹X¹²²)ₓ₁-(X^{a1})_{y1}-(CX¹²³X¹²⁴)_{z1}-

wherein X¹²¹ to X¹²⁴ are each independently H, OH, or - OSi(OR¹²¹)₃, where three R¹²¹ are each independently an alkyl group having 1 to 4 carbon atoms,
x^{a1} is -C(=O)NH-, -NHC(=O)-, -O-, -C(=O)O-, -OC(=O)-, -OC(=O) O-, -NH-, or -NHC(=O)NH- (left side of each bond binds to CX¹²¹X¹²²), and
x1 is an integer of 0 to 10, y1 is 0 or 1, and z1 is an integer of 1 to 10.

X^{a1} is preferably -O- or -C(=O)O-.

X^{a} is particularly preferably
a group represented by the following formula:

   -(CH₂)ₘ₁₂-O-(CH₂)ₘ₁₃-

   wherein m12 is an integer of 1 to 3, and m13 is an integer of 1 to 3,
a group represented by

   -(CH₂)ₘ₁₅-O-CH₂CH(OH)-(CH₂)ₘ₁₆-

   wherein m15 is an integer of 1 to 3, and m16 is an integer of 1 to 3,
a group represented by

   -(CH₂)ₘ₁₈-

   wherein m18 is an integer of 1 to 3, and
a group represented by

   -(CH₂)ₘ₂₀-O-CH₂CH(OSi(OCH₃)₃)-(CH₂)ₘ₂₁-

   wherein m20 is an integer of 1 to 3, and m21 is an integer of 1 to 3.

X^{a} is not limited, and specific examples include -CH₂-, -C₂H₄-, -C₃H₆-, -C₄H₈-, -C₄H₈-O-CH₂-, -CO-O-CH₂-CH(OH)-CH₂-, -S-, -NR¹²¹-, -(CH₂)ₘ₂₂-C(=O)-O-(CH₂)ₘ₂₃-, - (CH₂)ₘ₂₂-O-C(=O)-(CH₂)ₙ₂₃-, -(CH₂)ₘ₂₂-C(=O)-NR¹²¹-(CH₂)ₘ₂₃-, and -(CH₂)ₘ₂₂-NR¹²¹-C(=O)-(CH₂)ₘ₂₃-CH₂OCH₂CH(OSi(OCH₃)₃)CH₂-, wherein R¹²¹ is a hydrogen atom or a C₁₋₆ hydrocarbon chain, m22 is an integer of 1 to 10, and m23 is an integer of 1 to 10.

R⁵¹ is a monovalent group containing a Si atom to which a hydroxyl group or a hydrolyzable group is bonded.

In a preferable embodiment, R^{Si} is a group represented by the following formula (S1), (S2), (S3), (S4), or (S5):

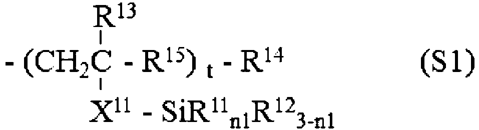

- SiR¹¹ₙ₁R¹²₃₋ₙ₁ (S2)

- SiR^{a1}ₖ₁R^{b1}ₗ₁R^{c1}ₘ₁ (S3)

- CR^{d1}ₖ₂R^{e1}ₗ₂R^{f1}ₘ₂ (S4)

- NR^{g1}R^{h1} (S5)

wherein
R¹¹ is each independently a hydroxyl group or a hydrolyzable group,
R¹² is each independently a monovalent organic group,
n1 is each independently an integer of 0 to 3 for each (SiR¹¹ₙ₁R¹²₃₋ₙ₁) unit,
X¹¹ is each independently a single bond or a divalent organic group,
R¹³ is each independently a hydrogen atom or a monovalent organic group,
t is each independently an integer of 2 or more,
R¹⁴ is each independently a hydrogen atom, a halogen atom, or -X¹¹-SiR¹¹ₙ₁R¹²₃₋ₙ₁,
R¹⁵ is each independently a single bond, an oxygen atom, an alkylene group having 1 to 6 carbon atoms, or an alkyleneoxy group having 1 to 6 carbon atoms,
R^{a1} is each independently -Z¹-SiR²¹ₚ₁R²²_{q1}R²³ᵣ₁,
Z¹ is each independently a divalent organic group,
R²¹ is each independently -Z^{1'}-SiR^{21'}_{p1'}R^{22'}_{q1'}R^{23'}_{r1'},
R²² is each independently a hydroxyl group or a hydrolyzable group,
R²³ is each independently a monovalent organic group,
p1 is each independently an integer of 0 to 3,
q1 is each independently an integer of 0 to 3,
r1 is each independently an integer of 0 to 3,
Z^{1'} is each independently a divalent organic group,
R^{21'} is each independently -Z^{1"}-SiR^{22"}_{q1"}R^{23"}_{r1"},
R^{22'} is each independently a hydroxyl group or a hydrolyzable group,
R^{23'} is each independently a monovalent organic group,
p1' is each independently an integer of 0 to 3,
q1' is each independently an integer of 0 to 3,
r1' is each independently an integer of 0 to 3,
Z^{1"} is each independently a divalent organic group,
R^{22"} is each independently a hydroxyl group or a hydrolyzable group,
R^{23"} is each independently a monovalent organic group,
q1" is each independently an integer of 0 to 3,
r1" is each independently an integer of 0 to 3,
R^{b1} is each independently a hydroxyl group or a hydrolyzable group,
R^{c1} is each independently a monovalent organic group,
k1 is each independently an integer of 0 to 3,
l1 is each independently an integer of 0 to 3,
m1 is each independently an integer of 0 to 3,
provided that, in the formula (S3), at least two Si atoms to which a hydroxyl group or a hydrolyzable group is bonded are present,
R^{d1} is each independently -Z²-CR³¹ₚ₂R³²_{q2}R³³ᵣ₂,
Z² is each independently a single bond, an oxygen atom, or a divalent organic group,
R³¹ is each independently -Z^{2'}-CR^{32'}_{q2'}R^{33'}_{r2'},
R³² is each independently -Z³-SiR³⁴ₙ₂R³⁵₃₋ₙ₂,
R³³ is each independently a hydrogen atom, a hydroxyl group, or a monovalent organic group,
p2 is each independently an integer of 0 to 3,
q2 is each independently an integer of 0 to 3,
r2 is each independently an integer of 0 to 3,
Z^{2'} is each independently a single bond, an oxygen atom, or a divalent organic group,
R^{32'} is each independently -Z³-SiR^{3'}ₙ₂R³⁵₃₋ₙ₂,
R^{33'} is each independently a hydrogen atom, a hydroxyl group, or a monovalent organic group,
q2' is each independently an integer of 0 to 3,
r2' is each independently an integer of 0 to 3,
Z³ is each independently a single bond, an oxygen atom, or a divalent organic group,
R³⁴ is each independently a hydroxyl group or a hydrolyzable group,
R³⁵ is each independently a monovalent organic group,
n2 is each independently an integer of 0 to 3,
R^{e1} is each independently -Z³-SiR³⁴ₙ₂R³⁵₃₋ₙ₂,
R^{f1} is each independently a hydrogen atom, a hydroxyl group, or a monovalent organic group,
k2 is each independently an integer of 0 to 3,
l2 is each independently an integer of 0 to 3,
m2 is each independently an integer of 0 to 3,
provided that, in the formula (S4), at least two Si atoms to which a hydroxyl group or a hydrolyzable group is bonded are present,
R^{g1} and R^{h1} are each independently -Z⁴-SiR¹¹ₙ₁R¹²₃₋ₙ₁, - Z⁴-SiR^{a1}ₖ₁R^{b1}ₗ₁R^{c1}ₘ₁, or -Z⁴-CR^{d1}ₖ₂R^{e1}ₗ₂R^{f1}ₘ₂, and
Z⁴ is each independently a single bond, an oxygen atom, or a divalent organic group,
provided that, in the formula (S5), at least two Si atoms to which a hydroxyl group or a hydrolyzable group is bonded are present.

In the formulae, R¹¹ is each independently a hydroxyl group or a hydrolyzable group.

R¹¹ is preferably, each independently, a hydrolyzable group.

R¹¹ is preferably, each independently, -OR^{h}, -OCOR^{h}, -O-N=CR^{h}₂, -NR^{h}₂, -NHR^{h}, -NCO, or a halogen (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

In the formulae, R¹² is each independently a monovalent organic group. Such a monovalent organic group is a monovalent organic group excluding the above hydrolyzable group.

In R¹², the monovalent organic group is preferably a C₁₋₂₀ alkyl group, more preferably a C₁₋₆ alkyl group, and even more preferably a methyl group.

In the formulae, n1 is each independently an integer of 0 to 3 for each (SiR¹¹ₙ₁R¹²₃₋ₙ₁) unit, provided that, in the formula (S1), at least two (SiR¹¹ₙ₁R¹²₃₋ₙ₁) units wherein n1 is 1 to 3 are present. In other words, in the formula (S1), at least two Si atoms to which a hydroxyl group or a hydrolyzable group is bonded are present.

n1 is each independently an integer of preferably 1 to 3, more preferably 2 to 3, and even more preferably 3 for each (SiR¹¹ₙ₁R¹²₃₋ₙ₁) unit.

In the formula, X¹¹ is each independently a single bond or a divalent organic group. Such a divalent organic group is preferably -R²⁸-Oₓ-R²⁹-, wherein R²⁸ and R²⁹ are each independently a single bond or a C₁₋₂₀ alkylene group, and x is 0 or 1. Such a C₁₋₂₀ alkylene group may be linear or may be branched, and is preferably linear. Such a C₁₋₂₀ alkylene group is preferably a C₁₋₁₀ alkylene group, more preferably a C₁₋₆ alkylene group, and even more preferably a C₁₋₃ alkylene group.

In one embodiment, X¹¹ is each independently a -C₁₋₆ alkylene-O-C₁₋₆ alkylene- or a -O-C₁₋₆ alkylene-.

In a preferable embodiment, X¹¹ is each independently a single bond or a linear C₁₋₆ alkylene group, preferably a single bond or a linear C₁₋₃ alkylene group, more preferably a single bond or a linear C₁₋₂ alkylene group, and even more preferably a linear C₁₋₂ alkylene group.

In the formula, R¹³ is each independently a hydrogen atom or a monovalent organic group. Such a monovalent organic group is preferably a C₁₋₂₀ alkyl group.

In a preferable embodiment, R¹³ is each independently a hydrogen atom or a linear C₁₋₆ alkyl group, preferably a hydrogen atom or a linear C₁₋₃ alkyl group, and preferably a hydrogen atom or a methyl group.

In the formula, R¹⁵ is each independently a single bond, an oxygen atom, an alkylene group having 1 to 6 carbon atoms, or an alkyleneoxy group having 1 to 6 carbon atoms.

In one embodiment, R¹⁵ is each independently an oxygen atom, an alkylene group having 1 to 6 carbon atoms, or an alkyleneoxy group having 1 to 6 carbon atoms.

In a preferable embodiment, R¹⁵ is a single bond.

In the formula, t is each independently an integer of 2 or more.

In a preferable embodiment, t is each independently an integer of 2 to 10, and preferably an integer of 2 to 6.

In the formula, R¹⁴ is each independently a hydrogen atom, a halogen atom, or -X¹¹-SiR¹¹ₙ₁R¹²₃₋ₙ₁. Such a halogen atom is preferably an iodine atom, a chlorine atom, or a fluorine atom, and more preferably a fluorine atom. In a preferable embodiment, R¹⁴ is a hydrogen atom.

In one embodiment, the formula (S1) is the following formula (S1-a): 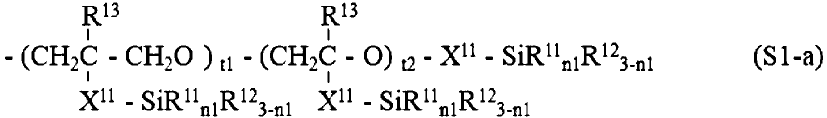 wherein
R¹¹, R¹², R¹³, X¹¹, and n1 have the same meanings as those described for the formula (S1),
t1 and t2 are each independently an integer of 1 or more, preferably an integer of 1 to 10, and more preferably an integer of 2 to 10, such as an integer of 1 to 5 or an integer of 2 to 5, and
the occurrence order of the respective repeating units enclosed in parentheses provided with t1 and t2 is not limited in the formula.

In a preferable embodiment, the formula (S1) is the following formula (S1-b): 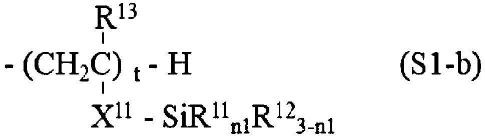 R¹¹, R¹², R¹³, X¹¹, n1, and t have the same meanings as those described for the formula (S1).

R^{a1} is each independently -Z¹-SiR²¹ₚ₁R²²_{q1}R²³ᵣ₁.

Z¹ is each independently an oxygen atom or a divalent organic group. Below, the right side of the structure denoted as Z¹ binds to (SiR²¹ₚ₁R²²_{q1}R²³ᵣ₁).

In a preferable embodiment, Z¹ is a divalent organic group.

In a preferable embodiment, Z¹ does not include a group that forms a siloxane bond with the Si atom to which Z¹ is bonded. Preferably, in the formula (S3), (Si-Z¹-Si) does not include a siloxane bond.

Z¹ is preferably a C₁₋₃₀ alkylene group, -(CH₂)_{z1}-O-(CH₂)_{z2}- (wherein z1 is an integer of 0 to 6 such as an integer of 1 to 6, and z2 is an integer of 0 to 6 such as an integer of 1 to 6), or -(CH₂)_{z3}-phenylene-(CH₂)_{z4}-(wherein z3 is an integer of 0 to 6 such as an integer of 1 to 6, and z4 is an integer of 0 to 6 such as an integer of 1 to 6). Such a C₁₋₆ alkylene group may be linear or may be branched, and is preferably linear. These groups may be substituted with, for example, one or more substituents selected from, a fluorine atom, a C₁₋₆ alkyl group, a C₂₋₆ alkenyl group, and a C₂₋₆ alkynyl group, and are preferably unsubstituted.

In a preferable embodiment, Z¹ is a C₁₋₃₀ alkylene group or -(CH₂)_{z3}-phenylene-(CH₂)_{z4}-, and preferably - phenylene-(CH₂)_{z4}-.

In another preferable embodiment, Z¹ is a C₁₋₃₀ alkylene group such as a C₁₋₆ alkylene group or a C₁₋₃ alkylene group. In one embodiment, Z¹ may be -CH₂CH₂CH₂-. In another embodiment, Z¹ may be -CH₂CH₂-. In yet another embodiment, Z^{2'} may be -CH₂CH₂CH₂CH₂CH₂CH₂CH₂CH₂CH₂CH₂CH₂-.

R²¹ is each independently -Z^{1'}-SiR^{21'}_{p1'}R^{22'}_{q1'}R^{23'}_{r1'}.

Z^{1'} is each independently an oxygen atom or a divalent organic group. Below, the right side of the structure denoted as Z^{1'} binds to (SiR^{21'}_{p1'}R^{22'}_{q1'}R^{23'}_{r1'}).

In a preferable embodiment, Z^{1'} is a divalent organic group.

In a preferable embodiment, Z^{1'} does not include a group that forms a siloxane bond with the Si atom to which Z^{1'} is bonded. Preferably, in the formula (S3), (Si-Z^{1'}-Si) does not include a siloxane bond.

Z^{1'} is preferably a C₁₋₃₀ alkylene group, -(CH₂)_{z1'}-O-(CH₂)_{z2'}- (wherein z1' is an integer of 0 to 6 such as an integer of 1 to 6, and z2' is an integer of 0 to 6 such as an integer of 1 to 6), or -(CH₂)_{z3'}-phenylene-(CH₂)_{z4'}-(wherein z3' is an integer of 0 to 6 such as an integer of 1 to 6, and z4' is an integer of 0 to 6 such as an integer of 1 to 6). Such a C₁₋₆ alkylene group may be linear or may be branched, and is preferably linear. These groups may be substituted with, for example, one or more substituents selected from, a fluorine atom, a C₁₋₆ alkyl group, a C₂₋₆ alkenyl group, and a C₂₋₆ alkynyl group, and are preferably unsubstituted.

In a preferable embodiment, Z^{1'} is a C₁₋₃₀ alkylene group or -(CH₂)_{z3'}-phenylene-(CH₂)_{z4'}-, and preferably - phenylene-(CH₂)_{z4'}-.

In another preferable embodiment, Z^{1'} is a C₁₋₃₀ alkylene group such as a C₁₋₆ alkylene group or a C₁₋₃ alkylene group. In one embodiment, Z^{1'} may be -CH₂CH₂CH₂-. In another embodiment, Z^{1'} may be -CH₂CH₂-. In yet another embodiment, Z^{2'} may be - CH₂CH₂CH₂CH₂CH₂CH₂CH₂CH₂CH₂CH₂CH₂-.

R^{21'} is each independently -Z^{1"}-SiR^{22"}_{q1"}R^{23"}_{r1"}.

Z^{1"} is each independently an oxygen atom or a divalent organic group. Below, the right side of the structure denoted as Z^{1"} binds to (SiR^{22"}_{q1"}R^{23"}_{r1"}).

In a preferable embodiment, Z^{1"} is a divalent organic group.

In a preferable embodiment, Z^{1"} does not include a group that forms a siloxane bond with the Si atom to which Z^{1"} is bonded. Preferably, in the formula (S3), (Si-Z^{1"}-Si) does not include a siloxane bond.

Z^{1"} is preferably a C₁₋₃₀ alkylene group, -(CH₂)_{z1"}-O-(CH₂)_{z2"}- (wherein z1" is an integer of 0 to 6 such as an integer of 1 to 6, and z2" is an integer of 0 to 6 such as an integer of 1 to 6), or -(CH₂)_{z3"}-phenylene-(CH₂)_{z4"}-(wherein z3" is an integer of 0 to 6 such as an integer of 1 to 6, and z4" is an integer of 0 to 6 such as an integer of 1 to 6). Such a C₁₋₆ alkylene group may be linear or may be branched, and is preferably linear. These groups may be substituted with, for example, one or more substituents selected from, a fluorine atom, a C₁₋₆ alkyl group, a C₂₋₆ alkenyl group, and a C₂₋₆ alkynyl group, and are preferably unsubstituted.

In a preferable embodiment, Z^{1"} is a C₁₋₃₀ alkylene group or -(CH₂)_{z3"}-phenylene-(CH₂)_{z4"}-, and preferably - phenylene-(CH₂)_{z4"}-. When Z^{1"} is such a group, light resistance, in particular ultraviolet resistance, can be more increased.

In another preferable embodiment, Z^{1"} is a C₁₋₃₀ alkylene group such as a C₁₋₆ alkylene group or a C₁₋₃ alkylene group. In one embodiment, Z^{1"} may be - CH₂CH₂CH₂-. In another embodiment, Z^{1"} may be -CH₂CH₂-. In yet another embodiment, Z^{2'} may be - CH₂CH₂CH₂CH₂CH₂CH₂CH₂CH₂CH₂CH₂CH₂-.

R^{22"} is each independently a hydroxyl group or a hydrolyzable group.

R^{22"} is preferably, each independently, a hydrolyzable group.

R^{22"} is preferably, each independently, -OR^{h}, -OCOR^{h}, -O-N=CR^{h}₂, -NR^{h}₂, -NHR^{h}, or -NCO (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R^{23"} is each independently a monovalent organic group. Such a monovalent organic group is a monovalent organic group excluding the above hydrolyzable group.

In R^{23"}, the monovalent organic group is preferably a C₁₋₂₀ alkyl group, more preferably a C₁₋₆ alkyl group, and even more preferably a methyl group.

q1" is each independently an integer of 0 to 3, and r1" is each independently an integer of 0 to 3. The sum of q1" and r1" is 3 in the (SiR^{22"}_{q1"}R^{23"}_{r1"}) unit.

q1" is preferably, each independently, an integer of 1 to 3, more preferably 2 to 3, and even more preferably 3 for each (SiR^{22"}_{q1"}R^{23"}_{r1"}) unit.

R^{22"} is each independently a hydroxyl group or a hydrolyzable group.

R^{22'} is preferably, each independently, a hydrolyzable group.

R^{22'} is preferably, each independently, -OR^{h}, -OCOR^{h}, -O-N=CR^{h}₂, -NR^{h}₂, -NHR^{h}, or -NCO (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R^{23'} is each independently a monovalent organic group. Such a monovalent organic group is a monovalent organic group excluding the above hydrolyzable group.

In R^{23'}, the monovalent organic group is preferably a C₁₋₂₀ alkyl group, more preferably a C₁₋₆ alkyl group, and even more preferably a methyl group.

p1' is each independently an integer of 0 to 3, q1' is each independently an integer of 0 to 3, and r1' is each independently an integer of 0 to 3. The sum of p', q1', and r1' is 3 in the (SiR^{21'}_{p1'}R^{22'}_{q1'}R^{23'}_{r1'}) unit.

In one embodiment, p1' is 0.

In one embodiment, p1' may be each independently an integer of 1 to 3, an integer of 2 to 3, or 3 for each (SiR^{21'}_{p1'}R^{22'}_{q1'}R^{23'}_{r1'}) unit. In a preferable embodiment, p1' is 3.

In one embodiment, q1' is each independently an integer of 1 to 3, preferably an integer of 2 to 3, and more preferably 3 for each (SiR^{21'}_{p1'}R^{22'}_{q1'}R^{23'}_{r1'}) unit.

In one embodiment, p1' is 0, and q1' is each independently an integer of 1 to 3, preferably an integer of 2 to 3, and even more preferably 3 for each (SiR^{21'}_{p1'}R^{22'}_{q1'}R^{23'}_{r1'}) unit.

R²² is each independently a hydroxyl group or a hydrolyzable group.

R²² is preferably, each independently, a hydrolyzable group.

R²² is preferably, each independently, -OR^{h}, -OCOR^{h}, -O-N=CR^{h}₂, -NR^{h}₂, -NHR^{h}, or -NCO (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R²³ is each independently a monovalent organic group. Such a monovalent organic group is a monovalent organic group excluding the above hydrolyzable group.

In R²³, the monovalent organic group is preferably a C₁₋₂₀ alkyl group, more preferably a C₁₋₆ alkyl group, and even more preferably a methyl group.

p1 is each independently an integer of 0 to 3, q1 is each independently an integer of 0 to 3, and r1 is each independently an integer of 0 to 3. The sum of p1, q1, and r1 is 3 in the (SiR²¹ₚ₁R²²_{q1}R²³ᵣ₁) unit.

In one embodiment, p1 is 0.

In one embodiment, p1 may be each independently an integer of 1 to 3, an integer of 2 to 3, or 3 for each (SiR²¹ₚ₁R²²_{q1}R²³ᵣ₁) unit. In a preferable embodiment, p1 is 3.

In one embodiment, q1 is each independently an integer of 1 to 3, preferably an integer of 2 to 3, and more preferably 3 for each (SiR²¹ₚ₁R²²_{q1}R²³ᵣ₁) unit.

In one embodiment, p1 is 0, and q1 is each independently an integer of 1 to 3, preferably an integer of 2 to 3, and even more preferably 3 for each (SiR²¹ₚ₁R²²_{q1}R²³ᵣ₁) unit.

In the formula, R^{b1} is each independently a hydroxyl group or a hydrolyzable group.

R^{b1} is preferably, each independently, a hydrolyzable group.

R^{b1} is preferably, each independently, -OR^{h}, -OCOR^{h}, -O-N=CR^{h}₂, -NR^{h}₂, -NHR^{h}, or -NCO (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

In the formula, R^{c1} is each independently a monovalent organic group. Such a monovalent organic group is a monovalent organic group excluding the above hydrolyzable group.

In R^{c1}, the monovalent organic group is preferably a C₁₋₂₀ alkyl group, more preferably a C₁₋₆ alkyl group, and even more preferably a methyl group.

k1 is each independently an integer of 0 to 3, l1 is each independently an integer of 0 to 3, and m1 is each independently an integer of 0 to 3. The sum of k1, l1, and m1 is 3 in the (SiR^{a1}ₖ₁R^{b1}ₗ₁R^{c1}ₘ₁) unit.

In one embodiment, k1 is each independently an integer of 1 to 3, preferably 2 or 3, and more preferably 3 for each (SiR^{a1}ₖ₁R^{b1}ₗ₁R^{c1}ₘ₁) unit. In a preferable embodiment, k1 is 3.

In the formula (S3), at least two Si atoms to which a hydroxyl group or a hydrolyzable group is bonded are present.

In a preferable embodiment, in the terminal moiety of the formula (S3), at least two Si atoms to which a hydroxyl group or a hydrolyzable group is bonded are present.

In a preferable embodiment, the group represented by the formula (S3) has any one of -Z¹-SiR²²_{q1}R²³ᵣ₁ (wherein q1 is an integer of 1 to 3, preferably 2 or 3, and more preferably 3, and r1 is an integer of 0 to 2), -Z^{1'}-SiR^{22'}_{q1'}R^{23'}_{r1'} (wherein q1' is an integer of 1 to 3, preferably 2 or 3, and more preferably 3, and r1' is an integer of 0 to 2), and -Z^{1"}-SiR^{22"}_{q1"}R^{23"}_{r1"} (wherein q1" is an integer of 1 to 3, preferably 2 or 3, and more preferably 3, and r1" is an integer of 0 to 2). Z¹, z^{1'}, Z^{1"}, R²², R²³, R^{22'}, R^{23'}, R^{22"}, and R^{23"} have the same meanings as those described above.

In a preferable embodiment, when R^{21'} is present in the formula (S3), q1" is an integer of 1 to 3, preferably 2 or 3, and more preferably 3 in at least one and preferably all R^{21'} groups.

In a preferable embodiment, when R²¹ is present in the formula (S3), p1' is 0, and q1' is an integer of 1 to 3, preferably 2 or 3, and more preferably 3 in at least one and preferably all R²¹ groups.

In a preferable embodiment, when R^{a1} is present in the formula (S3), p1 is 0, and q1 is an integer of 1 to 3, preferably 2 or 3, and more preferably 3 in at least one and preferably all R^{a1} groups.

In a preferable embodiment, in the formula (S3), k1 is 2 or 3 and is preferably 3, p1 is 0, q1 is 2 or 3 and is preferably 3.

R^{d1} is each independently -Z²-CR³¹ₚ₂R³²_{q2}R³³ᵣ₂.

Z² is each independently a single bond, an oxygen atom, or a divalent organic group. Below, the right side of the structure denoted as Z² binds to (CR³¹ₚ₂R³²_{q2}R³³ᵣ₂).

In a preferable embodiment, Z² is a divalent organic group.

In a preferable embodiment, Z² does not include a siloxane bond.

Z² is preferably a C₁₋₃₀ alkylene group, -(CH₂)_{z5}-O-(CH₂)_{z6}- (wherein z5 is an integer of 0 to 6 such as an integer of 1 to 6, and z6 is an integer of 0 to 6 such as an integer of 1 to 6), or -(CH₂)_{z7}-phenylene-(CH₂)_{z8}-(wherein z7 is an integer of 0 to 6 such as an integer of 1 to 6, and z8 is an integer of 0 to 6 such as an integer of 1 to 6). Such a C₁₋₆ alkylene group may be linear or may be branched, and is preferably linear. These groups may be substituted with, for example, one or more substituents selected from, a fluorine atom, a C₁₋₆ alkyl group, a C₂₋₆ alkenyl group, and a C₂₋₆ alkynyl group, and are preferably unsubstituted.

In a preferable embodiment, Z² is a C₁₋₃₀ alkylene group or -(CH₂)_{z7}-phenylene-(CH₂)_{z8}-, and preferably - phenylene-(CH₂)_{z8}-. When Z² is such a group, light resistance, in particular ultraviolet resistance, can be more increased.

In another preferable embodiment, Z² is a C₁₋₃₀ alkylene group such as a C₁₋₆ alkylene group or a C₁₋₃ alkylene group. In one embodiment, Z² may be -CH₂CH₂CH₂-. In another embodiment, Z² may be -CH₂CH₂-. In yet another embodiment, Z^{2'} may be -CH₂CH₂CH₂CH₂CH₂CH₂CH₂CH₂CH₂CH₂CH₂-.

R³¹ is each independently -Z^{2'}-CR^{32'}_{q2'}R^{33'}_{r2'}.

Z^{2'} is each independently a single bond, an oxygen atom, or a divalent organic group. Below, the right side of the structure denoted as Z^{2'} binds to (CR^{32'}_{q2'}R^{33'}_{r2'}).

In a preferable embodiment, Z^{2'} does not include a siloxane bond.

Z^{2'} is preferably a C₁₋₃₀ alkylene group, -(CH₂)_{z5'}-O-(CH₂)_{z6'}- (wherein z5' is an integer of 0 to 6 such as an integer of 1 to 6, and z6' is an integer of 0 to 6 such as an integer of 1 to 6), or -(CH₂)_{z7'}-phenylene-(CH₂)_{z8'}-(wherein z7' is an integer of 0 to 6 such as an integer of 1 to 6, and z8' is an integer of 0 to 6 such as an integer of 1 to 6). Such a C₁₋₆ alkylene group may be linear or may be branched, and is preferably linear. These groups may be substituted with one or more substituents selected from, for example, a fluorine atom, a C₁₋₆ alkyl group, a C₂₋₆ alkenyl group, and a C₂₋₆ alkynyl group, and are preferably unsubstituted.

In a preferable embodiment, Z^{2'} is a C₁₋₃₀ alkylene group or -(CH₂)_{7'}-phenylene-(CH₂)_{8'}-, and preferably - phenylene-(CH₂)_{z8'}-. When Z^{2'} is such a group, light resistance, in particular ultraviolet resistance, can be more increased.

In another preferable embodiment, Z^{2'} is a C₁₋₃₀ alkylene group such as a C₁₋₆ alkylene group or a C₁₋₃ alkylene group. In one embodiment, Z^{2'} may be -CH₂CH₂CH₂-. In another embodiment, Z^{2'} may be -CH₂CH₂-. In yet another embodiment, Z^{2'} may be - CH₂CH₂CH₂CH₂CH₂CH₂CH₂CH₂CH₂CH₂CH₂-.

R^{32'} is each independently -Z³-SiR³ₙ₂R³⁵₃₋ₙ₂.

Z³ is each independently a single bond, an oxygen atom, or a divalent organic group. Below, the right side of the structure denoted as Z³ binds to (SiR³⁴ₙ₂R³⁵₃₋ₙ₂).

In one embodiment, Z³ is an oxygen atom.

In one embodiment, Z³ is a divalent organic group.

In a preferable embodiment, Z³ does not include a siloxane bond.

Z³ is preferably a C₁₋₃₀ alkylene group, -(CH₂)_{z5"}-O-(CH₂)_{z6"}- (wherein z5" is an integer of 0 to 6 such as an integer of 1 to 6, and z6" is an integer of 0 to 6 such as an integer of 1 to 6), or -(CH₂)_{z7"}-phenylene-(CH₂)_{z8"}-(wherein z7" is an integer of 0 to 6 such as an integer of 1 to 6, and z8" is an integer of 0 to 6 such as an integer of 1 to 6). Such a C₁₋₆ alkylene group may be linear or may be branched, and is preferably linear. These groups may be substituted with, for example, one or more substituents selected from a fluorine atom, a C₁₋₆ alkyl group, a C₂₋₆ alkenyl group, and a C₂₋₆ alkynyl group, and are preferably unsubstituted.

In a preferable embodiment, Z³ is a C₁₋₃₀ alkylene group or -(CH₂)_{z7"}-phenylene-(CH₂)_{z8"}-, and preferably - phenylene-(CH₂)_{z8"}-. When Z³ is such a group, light resistance, in particular ultraviolet resistance, can be more increased.

In another preferable embodiment, Z³ is a C₁₋₃₀ alkylene group such as a C₁₋₆ alkylene group or a C₁₋₃ alkylene group. In one embodiment, Z³ may be -CH₂CH₂CH₂-. In another embodiment, Z³ may be -CH₂CH₂-. In yet another embodiment, Z^{2'} may be -CH₂CH₂CH₂CH₂CH₂CH₂CH₂CH₂CH₂CH₂CH₂-.

R³⁴ is each independently a hydroxyl group or a hydrolyzable group.

R³⁴ is preferably, each independently, a hydrolyzable group.

R³⁴ is preferably, each independently, -OR^{h}, -OCOR^{h}, -O-N=CR^{h}₂, -NR^{h}₂, -NHR^{h}, -NCO, or a halogen (in these formulae, R^{h} represents a substituted or unsubstituted C_{1- 4} alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R³⁵ is each independently a monovalent organic group. Such a monovalent organic group is a monovalent organic group excluding the above hydrolyzable group.

In R³⁵, the monovalent organic group is preferably a C₁₋₂₀ alkyl group, more preferably a C₁₋₆ alkyl group, and even more preferably a methyl group.

n2 is each independently an integer of 0 to 3 for each (SiR³⁴ₙ₂R³⁵₃₋ₙ₂) unit, provided that, in the terminal moiety of the formula (S3), at least two (SiR³⁴ₙ₂R³⁵₃₋ₙ₂) units wherein n2 is 1 to 3 are present. In other words, in the terminal moiety of the formula (S4), at least two Si atoms to which a hydroxyl group or a hydrolyzable group is bonded are present.

n2 is each independently an integer of preferably 1 to 3, more preferably 2 to 3, and even more preferably 3 for each (SiR³⁴ₙ₂R³⁵₃₋ₙ₂) unit.

R^{33'} is each independently a hydrogen atom, a hydroxyl group, or a monovalent organic group. Such a monovalent organic group is a monovalent organic group excluding the hydrolyzable group.

In R^{33'}, the monovalent organic group is preferably a C₁₋₂₀ alkyl group or - (CₛH₂ₛ)ₜ₁-(O-CₛH₂ₛ)ₜ₂ (wherein s is an integer of 1 to 6, preferably an integer of 2 to 4, t1 is 1 or 0 and preferably 0, and t2 is an integer of 1 to 20, preferably an integer of 2 to 10, and more preferably an integer of 2 to 6), more preferably a C₁₋₂₀ alkyl group, even more preferably a C₁₋₆ alkyl group, and particularly preferably a methyl group.

In one embodiment, R^{33'} is a hydroxyl group.

In another embodiment, R^{33'} is a monovalent organic group, preferably a C₁₋₂₀ alkyl group, and more preferably a C₁₋₆ alkyl group.

q2' is each independently an integer of 0 to 3, and r2' is each independently an integer of 0 to 3. The sum of q2' and r2' is 3 in the (CR^{32'}_{q2'}R^{33'}_{r2'}) unit.

q2' is each independently an integer of preferably 1 to 3, more preferably 2 to 3, and even more preferably 3 for each (CR^{32'}_{q2'}R^{33'}_{r2'}) unit.

R³² is each independently -Z³-SiR³⁴ₙ₂R³⁵₃₋ₙ₂. Such -Z³-SiR³⁴ₙ₂R³⁵₃₋ₙ₂ has the same meanings as those described for R^{32'}.

R³³ is each independently a hydrogen atom, a hydroxyl group, or a monovalent organic group. Such a monovalent organic group is a monovalent organic group excluding the above hydrolyzable group.

In R³³, the monovalent organic group is preferably a C₁₋₂₀ alkyl group or - (CₛH₂ₛ)ₜ₁-(O-CₛH₂ₛ)ₜ₂ (wherein s is an integer of 1 to 6, preferably an integer of 2 to 4, t1 is 1 or 0 and preferably 0, and t2 is an integer of 1 to 20, preferably an integer of 2 to 10, and more preferably an integer of 2 to 6), more preferably a C₁₋₂₀ alkyl group, even more preferably a C₁₋₆ alkyl group, and particularly preferably a methyl group.

In one embodiment, R³³ is a hydroxyl group.

In another embodiment, R³³ is a monovalent organic group, preferably a C₁₋₂₀ alkyl group, and more preferably a C₁₋₆ alkyl group.

p2 is each independently an integer of 0 to 3, q2 is each independently an integer of 0 to 3, and r2 is each independently an integer of 0 to 3. The sum of p2, q2, and r2 is 3 in the (CR³¹ₚ₂R³²_{q2}R³³ᵣ₂) unit.

In one embodiment, p2 is 0.

In one embodiment, p2 may be each independently an integer of 1 to 3, an integer of 2 to 3, or 3 for each (CR³¹ₚ₂R³²_{q2}R³³ᵣ₂) unit. In a preferable embodiment, p2 is 3.

In one embodiment, q2 is each independently an integer of 1 to 3, preferably an integer of 2 to 3, and more preferably 3 for each (CR³¹ₚ₂R³²_{q2}R³³ᵣ₂) unit.

In one embodiment, p2 is 0, and q2 is each independently an integer of 1 to 3, preferably an integer of 2 to 3, and even more preferably 3 for each (CR³¹ₚ₂R³²_{q2}R³³ᵣ₂) unit.

R^{e1} is each independently -Z³-SiR³⁴ₙ₂R³⁵₃₋ₙ₂. Such -Z³-SiR³⁴ₙ₂R³⁵₃₋ₙ₂ has the same meanings as those described for R^{32'}.

R^{f1} is each independently a hydrogen atom, a hydroxyl group, or a monovalent organic group. Such a monovalent organic group is a monovalent organic group excluding the above hydrolyzable group.

In R^{f1}, the monovalent organic group is preferably a C₁₋₂₀ alkyl group or - (CₛH₂ₛ)ₜ₁-(O-CₛH₂ₛ)ₜ₂ (wherein s is an integer of 1 to 6, preferably an integer of 2 to 4, t1 is 1 or 0 and preferably 0, and t2 is an integer of 1 to 20, preferably an integer of 2 to 10, and more preferably an integer of 2 to 6), more preferably a C₁₋₂₀ alkyl group, even more preferably a C₁₋₆ alkyl group, and particularly preferably a methyl group.

In one embodiment, R^{f1} is a hydroxyl group.

In another embodiment, R^{f1} is a monovalent organic group, preferably a C₁₋₂₀ alkyl group, and more preferably a C₁₋₆ alkyl group.

k2 is each independently an integer of 0 to 3, l2 is each independently an integer of 0 to 3, and m2 is each independently an integer of 0 to 3. The sum of k2, l2, and m2 is 3 in the (CR^{d1}ₖ₂R^{e1}ₗ₂R^{f1}ₘ₂) unit.

In one embodiment, two or more such as 2 to 27, preferably 2 to 9, more preferably 2 to 6, even more preferably 2 to 3, and particularly preferably 3 (SiR³⁴ₙ₂R³⁵₃₋ₙ₂) units in which n2 is 1 to 3, preferably 2 or 3, and more preferably 3 are present in each terminal moiety of the formula (S4).

In a preferable embodiment, when R^{32'} is present in the formula (S4), n2 is an integer of 1 to 3, preferably 2 or 3, and more preferably 3 in at least one and preferably all R^{32'} groups.

In a preferable embodiment, when R³² is present in the formula (S4), n2 is an integer of 1 to 3, preferably 2 or 3, and more preferably 3 in at least one and preferably all R³² groups.

In a preferable embodiment, when R^{e1} is present in the formula (S4), n2 is an integer of 1 to 3, preferably 2 or 3, and more preferably 3 in at least one and preferably all R^{a1} groups.

In a preferable embodiment, in the formula (S4), k2 is 0, l2 is 2 or 3 and is preferably 3, and n2 is 2 or 3 and is preferably 3.

R^{g1} and R^{h1} are each independently -Z⁴-SiR¹¹ₙ₁R¹²₃₋ₙ₁, - Z⁴-SiR^{a1}ₖ₁R^{b1}ₗ₁R^{c1}ₘ₁, or -Z⁴-CR^{d1}ₖ₂R^{e1}ₗ₂R^{f1}ₘ₂. Here, R¹¹, R¹², R^{a1}, R^{b2}, R^{c1}, R^{d1}, R^{e1}, R^{f1}, n1, k1, l1, m1, k2, l2, and m2 have the same meanings as above.

In a preferable embodiment, R^{g1} and R^{h1} are each independently -Z⁴-SiR¹¹ₙ₁R¹²₃₋ₙ₁.

Z⁴ is each independently a single bond, an oxygen atom, or a divalent organic group. Below, the right side of the structure denoted as Z⁴ binds to (SiR¹¹ₙ₁R¹²₃₋ₙ₁).

In one embodiment, Z⁴ is an oxygen atom.

In one embodiment, Z⁴ is a divalent organic group.

In a preferable embodiment, Z⁴ does not include a siloxane bond.

Z⁴ is preferably a C₁₋₃₀ alkylene group, -(CH₂)_{z5"}-O-(CH₂)_{z6"}- (wherein z5" is an integer of 0 to 6 such as an integer of 1 to 6, and z6" is an integer of 0 to 6 such as an integer of 1 to 6), or - (CH₂)_{z7"}-phenylene-(CH₂)_{z8"}-(wherein z7" is an integer of 0 to 6 such as an integer of 1 to 6, and z8" is an integer of 0 to 6 such as an integer of 1 to 6). Such a C₁₋₆ alkylene group may be linear or may be branched, and is preferably linear. These groups may be substituted with, for example, one or more substituents selected from a fluorine atom, a C₁₋₆ alkyl group, a C₂₋₆ alkenyl group, and a C₂₋₆ alkynyl group, and are preferably unsubstituted.

In a preferable embodiment, Z⁴ is a C₁₋₃₀ alkylene group or -(CH₂)_{z7"}-phenylene-(CH₂)_{z8"}-, and preferably - phenylene-(CH₂)_{z8"}-. When Z³ is such a group, light resistance, in particular ultraviolet resistance, can be more increased.

In another preferable embodiment, Z⁴ is a C₁₋₃₀ alkylene group such as a C₁₋₆ alkylene group or a C₁₋₃ alkylene group. In one embodiment, Z⁴ may be -CH₂CH₂CH₂-. In another embodiment, Z⁴ may be -CH₂CH₂-. In yet another embodiment, Z^{2'} may be -CH₂CH₂CH₂CH₂CH₂CH₂CH₂CH₂CH₂CH₂CH₂-.

In one embodiment, none of the formulae (S1), (S2), (S3), and (S4) contains a siloxane bond.

In one embodiment, R^{Si} is a group represented by the formula (S2), (S3), (S4), or (S5).

In one embodiment, R^{Si} is a group represented by the formula (S2), (S3), or (S4).

In one embodiment, R^{Si} is a group represented by the formula (S3), (S4), or (S5).

In one embodiment, R^{Si} is a group represented by the formula (S3) or (S4).

In one embodiment, R^{Si} is a group represented by the formula (S4) or (S5).

In one embodiment, R^{Si} is a group represented by the formula (S2).

In one embodiment, R^{Si} is a group represented by the formula (S1). In a preferable embodiment, n1 is 1 to 3, preferably 2 to 3, and even more preferably 3.

In one embodiment, R^{Si} is a group represented by the formula (S2). In a preferable embodiment, n1 is 1 to 3, preferably 2 to 3, and even more preferably 3.

In a preferable embodiment, the formula (S2) is the following formulae. In the following formulae, * represents the point of attachment to X¹.

*** -Si(OCH₃)₃**

*** -Si(OCH₂CH₃)₃**

In one embodiment, R^{Si} is a group represented by the formula (S3). In a preferable embodiment, the formula (S3) is -SiR^{a1}₂R^{c1} or -SiR^{a1}₃, R^{a1} is -Z¹-SiR²²_{q1}R²³ᵣ₁, Z¹ is a C₁₋₆ alkylene group, -(CH₂)_{z1}-O-(CH₂)_{z2}- (wherein z1 is an integer of 0 to 6 such as an integer of 1 to 6, and z2 is an integer of 0 to 6 such as an integer of 1 to 6), or - (CH₂)_{z3}-phenylene- (CH₂)_{z4}- (wherein z3 is an integer of 0 to 6 such as an integer of 1 to 6, and z4 is an integer of 0 to 6 such as an integer of 1 to 6), preferably a C₁₋₆ alkylene group, and q1 is 1 to 3, preferably 2 to 3, and even more preferably 3.

In a preferable embodiment, the formula (S3) is the following formulae. In the following formulae, * represents the point of attachment to X¹.

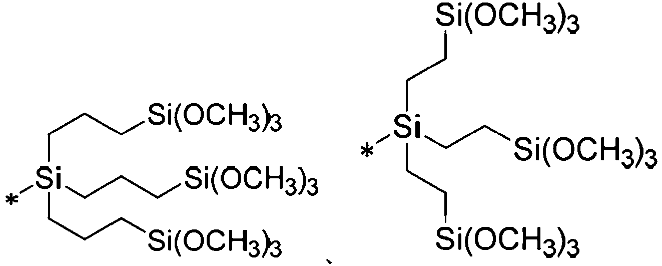

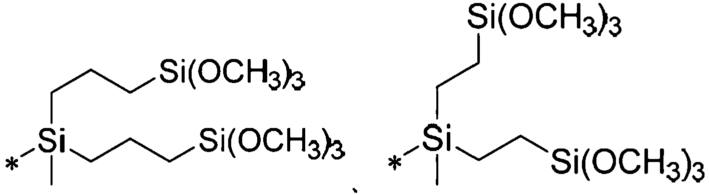

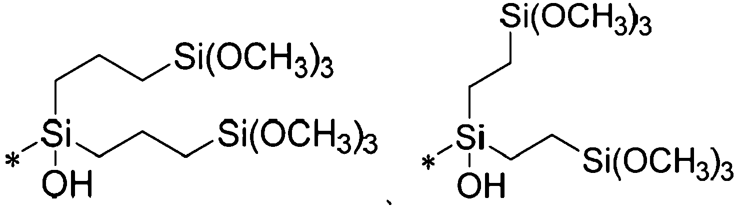

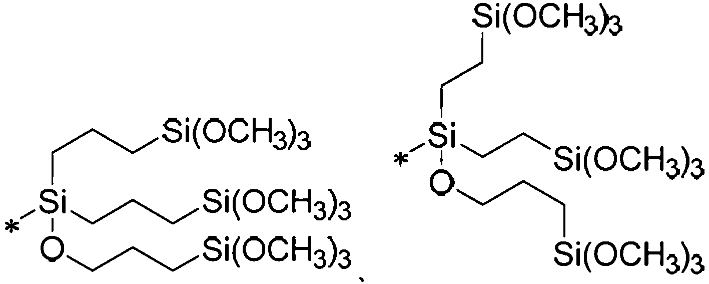

In one embodiment, R^{Si} is a group represented by the formula (S4). In a preferable embodiment, the formula (S4) is -CR^{e1}₂R^{f1} or -CR^{e1}₃, R^{e1} is -Z³-SiR³⁴ₙ₂R³⁵₃₋ₙ₂, Z³ is a C₁₋₆ alkylene group, - (CH₂)_{z5"}-O-(CH₂)_{z6"}- (wherein z5" is an integer of 0 to 6 such as an integer of 1 to 6, and z6" is an integer of 0 to 6 such as an integer of 1 to 6), or -(CH₂)_{z7"}-phenylene-(CH₂)_{z8"}- (wherein z7" is an integer of 0 to 6 such as an integer of 1 to 6, and z8" is an integer of 0 to 6 such as an integer of 1 to 6), preferably a C₁₋₆ alkylene group, and n2 is 1 to 3, preferably 2 to 3, and even more preferably 3.

In a preferable embodiment, the formula (S4) is the following formulae. In the following formulae, * represents the point of attachment to X¹.

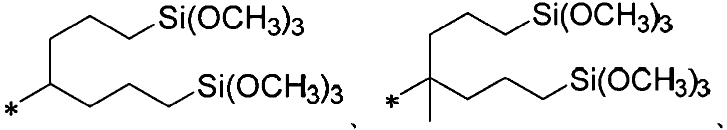

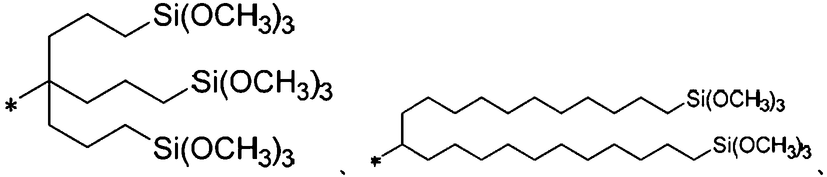

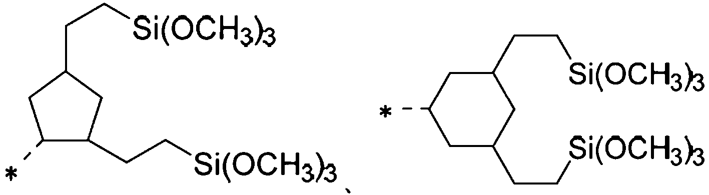

In one embodiment, R^{Si} is a group represented by the formula (S5). In a preferable embodiment, R^{g1} and R^{h1} are -Z⁴-SiR¹¹ₙ₁R¹²₃₋ₙ₁, Z⁴ is a C₁₋₆ alkylene group, -(CH₂)_{z5"}-O-(CH₂)_{z6"}- (wherein z5" is an integer of 0 to 6 such as an integer of 1 to 6, and z6" is an integer of 0 to 6 such as an integer of 1 to 6), or -(CH₂)_{z7"}-phenylene-(CH₂)_{z8"}-(wherein z7" is an integer of 0 to 6 such as an integer of 1 to 6, and z8" is an integer of 0 to 6 such as an integer of 1 to 6), preferably a C₁₋₆ alkylene group, and n1 is 1 to 3, preferably 2 to 3, and even more preferably 3.

In a preferable embodiment, formula (S5) is the following formulae. In the following formulae, * represents the point of attachment to X¹.

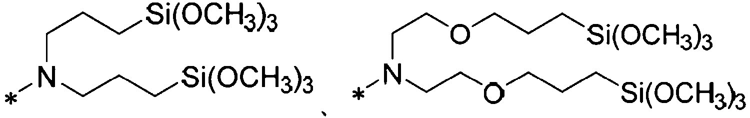

In a preferable embodiment, the silane compound of the present disclosure is a silane compound represented by the following formula (1):

**R^{A}_{α}-X¹-R^{si}_{β}** **(1)**

wherein
R^{A} is a group selected from the following groups: 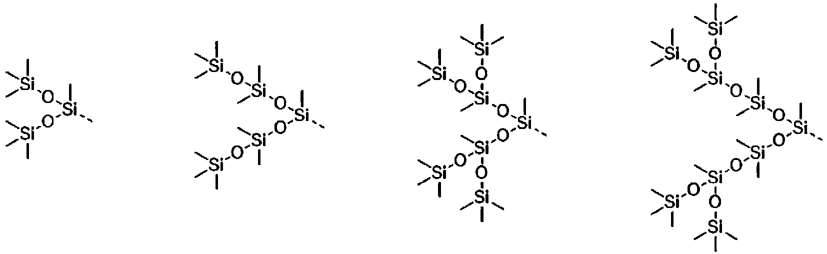 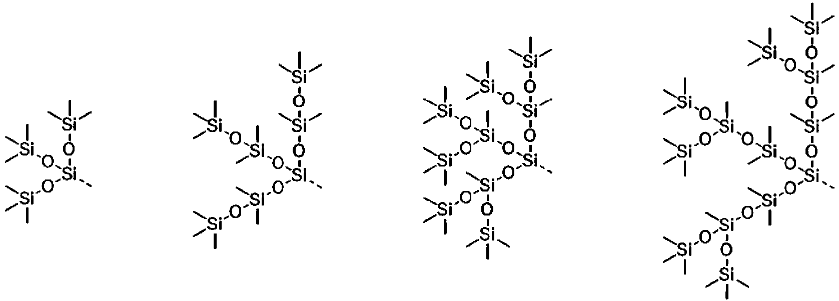 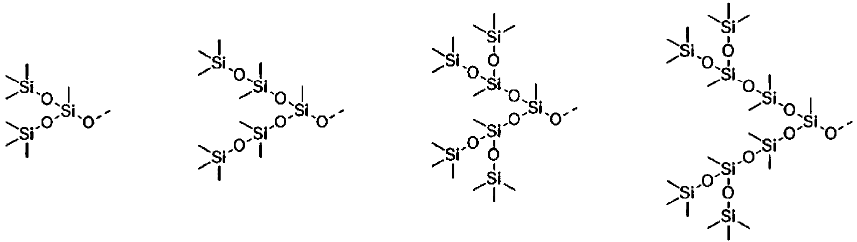 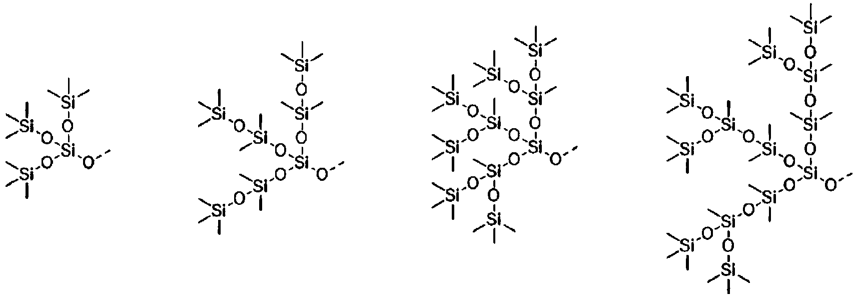
preferably a group selected from the following groups: 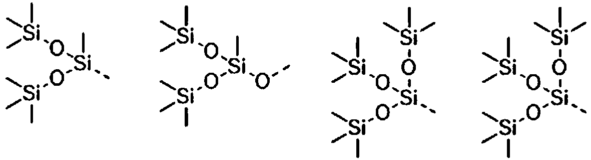 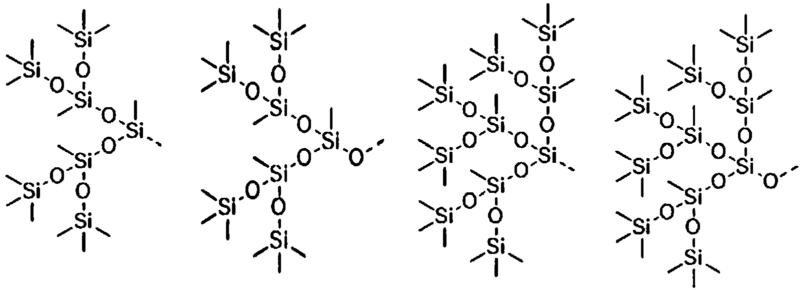
and more preferably a group selected from the following groups: 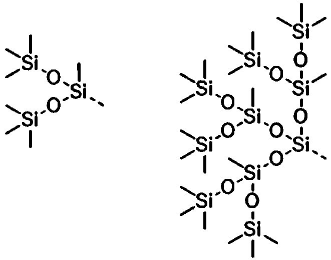 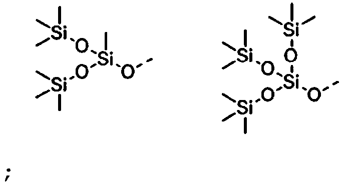
X¹ is the following group:
   C₁₋₃₀ alkylene,
   C₁₋₃₀ alkylene-CONH-C₁₋₃₀ alkylene,
   C₁₋₃₀ alkylene-OCO-C₁₋₃₀ alkylene,
   -OCO-C₁₋₃₀ alkylene,
   -OSi(CH₃)₂-C₁₋₃₀ alkylene-CONH-C₁₋₃₀ alkylene,
   -OSi(CH₃)₂-C₁₋₃₀ alkylene-OCO-C₁₋₃₀ alkylene,
   -Si(CH₃)₂-C₁₋₃₀ alkylene-CONH-C₁₋₃₀ alkylene,
   -Si(CH₃)₂-C₁₋₃₀ alkylene-OCO-C₁₋₃₀ alkylene,
   C₁₋₃₀ alkylene-CO-,
   (C₁₋₁₀ alkylene)₃C-C₁₋₃₀ alkylene-CONH-C₁₋₃₀ alkylene,
   (C₁₋₁₀ alkylene)₃C-C₁₋₃₀ alkylene-OCO-C₁₋₃₀ alkylene, or
   [C₁₋₁₀ alkylene-O-]₂phenyl-CONH-C₁₋₃₀ alkylene; and
   R^{Si} is -Si(OCH₃)₃, -Si(CH₃)(CH₂CH₂CH₂-Si(OCH₃)₃)₂, - CH(CH₂CH₂CH₂-Si (OCH₃)₃)₂, -C(CH₂CH₂CH₂-Si(OCH₃)₃)₃, and - N(CH₂CH₂CH₂-Si(OCH₃)₃)₂;
   α is an integer of 1 to 3; and
   β is 1.

The silane compound of the present disclosure includes the following compounds.

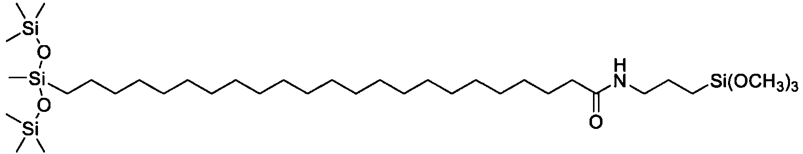

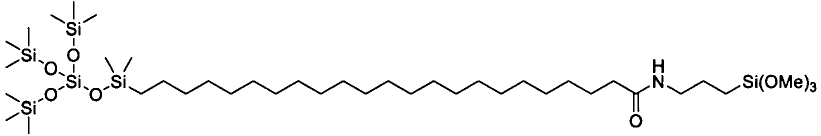

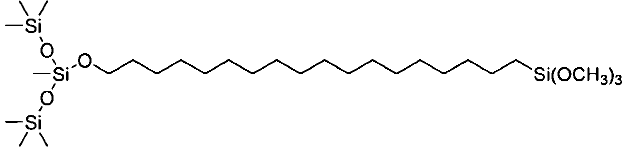

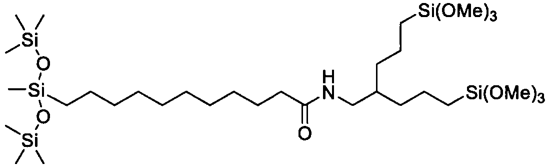

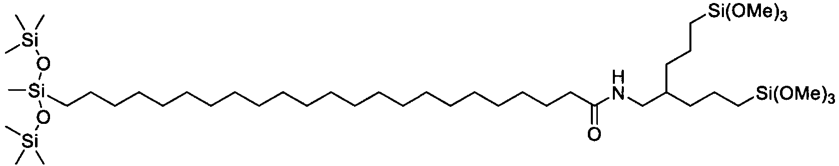

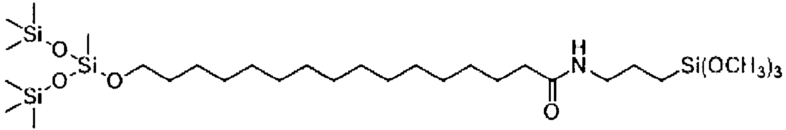

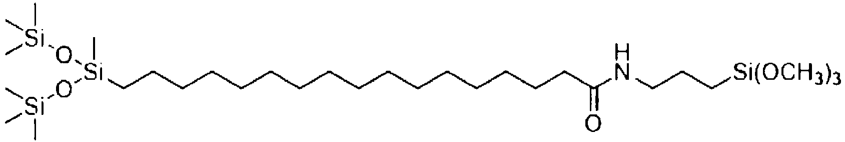

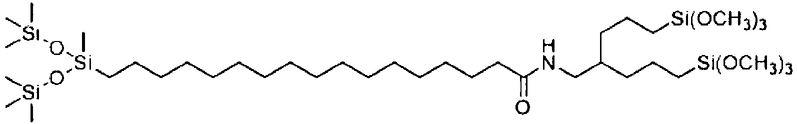

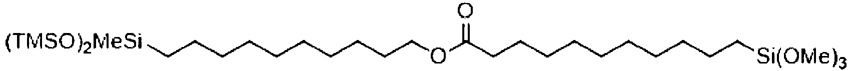

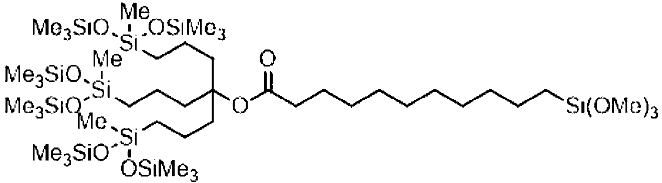

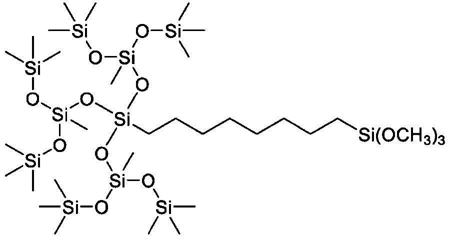

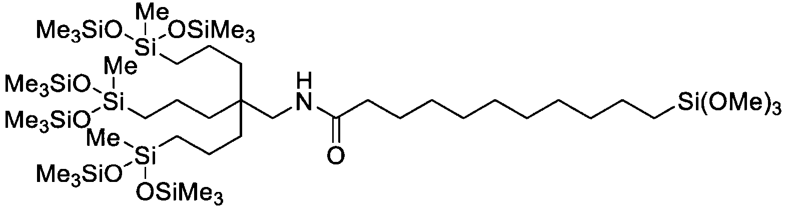

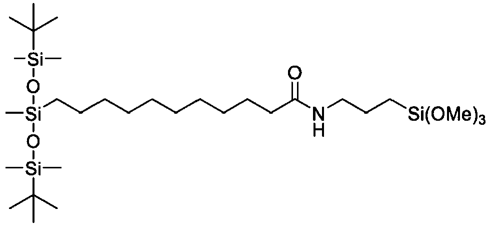

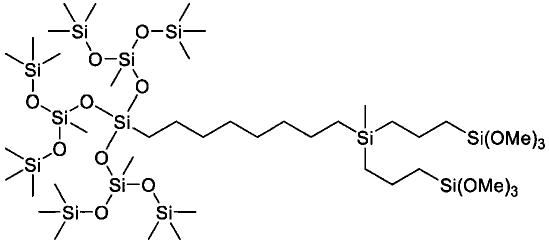

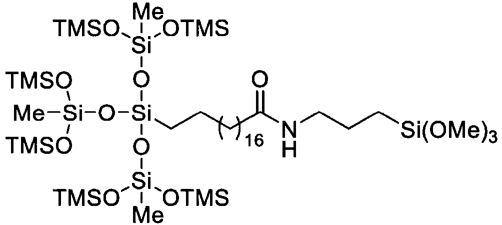

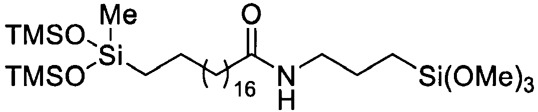

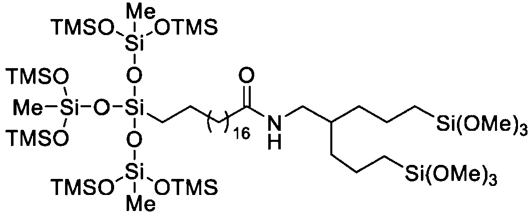

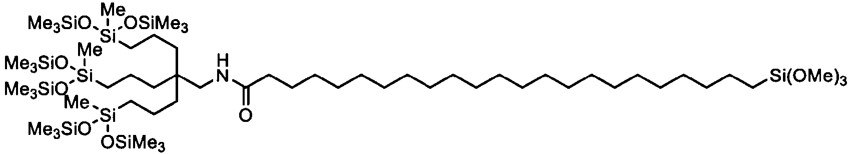

((CH₃)₃SiO)₂SiCH₃(CH₂)₂₂CON(CH₂)₃Si(OCH₃)₃)₂

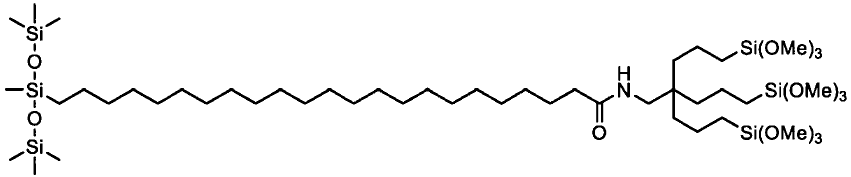

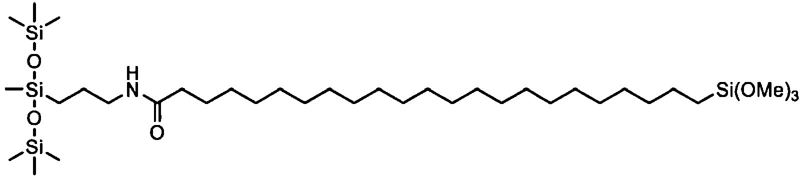

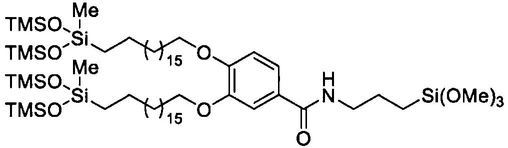

((CH₃)₃SiO)₂SiCH₃(CH₂)₂₁CONH(CH₂)₃Si(OCH₃)₃

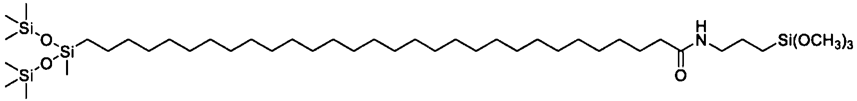

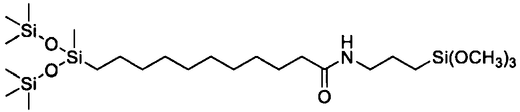

[(CH₃)₃SiO]₂CH₃Si(CH₃)₂O(Si(CH₃)₂O)ₙSi(CH₃)₂CH₂CH₂CH₂CH₂CH₂CH₂ CH₂CH₂CH₂CH₂CH₂CH₂CH₂CH₂CH₂CH₂CH₂CH₂CH₂CH₂CH₂CH₂CONHCH₂CH₂CH₂Si (OCH₃)₃ wherein n is an integer of 2 to 20 such as 9 [(CH₃)₃SiO]₃Si(CH₃)₂O(Si(CH₃)₂O)ₙSi(CH₃)₂CH₂CH₂CH₂CH₂CH₂CH₂CH₂ CH₂CH₂CH₂CH₂CH₂CH₂CH₂CH₂CH₂CH₂CH₂CH₂CH₂CH₂CH₂CONHCH₂CH₂CH₂Si(OC H₃)₃ wherein n is an integer of 2 to 20 such as 8

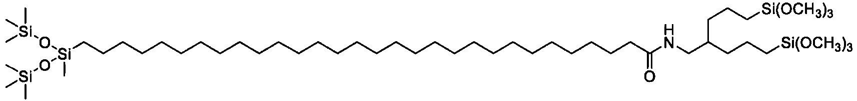

### [Production Method]

Below, the method for producing the silane compound of the present disclosure will now be described in detail. Note that the method for producing the silane compound of the present disclosure is not limited to the following methods.

### (Production Method 1)

In this present production method, a carbonyl group (-C(=O)-)-containing compound having terminal R¹ is reacted with an olefin (-CH=CH₂)-containing amine compound to produce an olefin-containing amide compound, and the silane compound of the present disclosure can be synthesized from this olefin-containing amide compound. For example, an amide compound containing a terminal olefin is reacted with a compound represented by the following formula:

HSiR^{j27}ₘ₃R^{j28}₃₋ₘ₃

wherein
R^{j27} is each independently a hydroxyl group or a hydrolyzable group,
R^{j28} is each independently a monovalent organic group, and
m3 is 1 to 3,
and thereby the silane compound can be obtained. The monovalent organic group does not include a hydrolyzable group.

The olefin-containing amine compound is a compound having H₂N- and -CH=CH₂, and is, for example, H₂N (CH₂)ₓ₃₁Q((CH₂)ₓ₃₂CH=CH₂)ₓ₃₃R^{x3}ₓ₃₄ (wherein x31 is an integer of 0 to 30, x32 is an integer of 0 to 6, x33 is an integer of 1 or more, x34 is an integer of 0 or more, the sum of x33 and x34 is the valence of Q minus 1, Q is N, Si or C, and R^{x3} is a hydrogen atom, a hydroxyl group, or a monovalent organic group).

Examples of the olefin-containing amine compound include allylamine, diallylamine, 2-allylpent-4-en-1-amine (H₂NCH₂CH(CH₂CH=CH₂)₂), 2,2-diallylpent-4-en-1-amine (H₂N-CH₂C(CH₂CH=CH₂)₃), 3-buten-1-amine, 4-penten-1-amine, 5-hexen-1-amine, 6-hepten-1-amine, 7-octen-1-amine, 8-nonen-1-amine, 9-decen-1-amine, 10-undecen-1-amine, 11-dodecen-1-amine, 12-tridecen-1-amine, 13-tetradecene-1-amine, 14-pentadecen-1-amine, 15-hexadecen-1-amine, 16-heptadecen-1-amine, 17-octadecen-1-amine, 18-nonadecen-1-amine, 19-icosen-1-amine, 20-henicosen-1-amine, 23-tetracosen-1-amine, and 29-triaconten-1-amine.

A carbonyl group-containing compound is a compound containing R¹- and a C(=O) group. Examples of the carbonyl group-containing compound include a compound obtained by the synthesis method described below, or a compound represented by the formula:

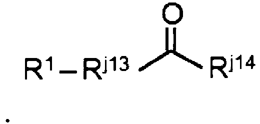

In the above formula, R¹ has the same meanings as those described for the formula (1); R^{j13} is a single bond or a divalent group; and R^{j14} is a hydroxyl group, a fluorine atom, a chlorine atom, an electron-withdrawing (electron-deficient) oxygen atom or nitrogen atom, or an -O-lower alkyl group (i.e., an alkoxy group), is, for example, a hydrogen atom, a methoxy group, an ethoxy group, a 4-nitrophenol group, or an imidazole group, and is specifically a hydrogen atom, a methoxy group, or an imidazole group.

When the carbonyl group-containing compound has an acid chloride (C(=O)Cl), the olefin-containing amide compound can be obtained by reacting it with an olefin-containing amine compound in the presence of a trialkylamine. Examples of the trialkyl amine include triethylamine.

When the carbonyl group-containing compound has a carboxylic acid, the olefin-containing amide compound can be obtained by reacting it with a condensing agent.

The condensing agent may be preferably 1-(3-dimethylaminopropyl)-3-ethylcarbodiimide (EDC), 1-(3-dimethylaminopropyl)-3-ethylcarbodiimide hydrochloride (EDC·HCl), N,N'-dicyclohexylcarbodiimide (DCC), 1-[bis(dimethylamino)methylene]-1H-1,2,3-triazolo[4,5-b]pyridinium 3-oxide hexafluorophosphate (HATU), 1-[bis(dimethylamino)methylene]-1H-benzotriazolium 3-oxide hexafluorophosphate (HBTU), 1-[bis(dimethylamino)methylene]-1H-1,2,3-triazolo[4,5-b]pyridinium 3-oxide tetrafluoroborate (TATU), 1-[bis(dimethylamino)methylene]-1H-benzotriazolium 3-oxide tetrafluoroborate (TBTU), (1-cyano-2-ethoxy-2-oxoethylideneaminooxy)dimethylaminomorpholinocarbenium hexafluorophosphate (COMU), O-[(ethoxycarbonyl)cyanomethyleneamino]-N,N,N',N'-tetramethyluronium hexafluorophosphate (HOTU), 1H-benzotriazol-1-yloxytripyrrolidinophosphonium hexafluorophosphate (PyBOP), 1H-benzotriazol-1-yloxytris(dimethylamino)phosphonium hexafluorophosphate (BOP), bromotripyrrolidinophosphonium hexafluorophosphate (PyBroP), diphenylphosphoryl azide (DPPA), 4-(4,6-dimethoxy-1,3,5-triazin-2-yl)-4-methylmorpholinium chloride (DMT-MM), 1-hydroxybenzotriazole (HOBt), 1-hydroxy-7-azabenzotriazole (HOAt), 1,1'-carbonyldiimidazole (CDI), or 1,1'-carbonyldi(1,2,4-triazole) (CDT), and preferably 1-(3-dimethylaminopropyl)-3-ethylcarbodiimide hydrochloride, N,N'-dicyclohexylcarbodiimide, or 1-hydroxybenzotriazole. Moreover, a catalyst such as 4-dimethylaminopyridine (DMAP) may be added.

When the carbonyl group-containing compound has an ester, the olefin-containing amide compound can be obtained by reacting it in the presence of a base.

The base may be preferably 1,5,7-triazabicyclo[4.4.0]dec-5-ene (TBD), 1,2,4-triazole, 1,8-diazabicyclo[5.4.0]-7-undecene (DBU), sodium methoxide, or sodium tert-butoxide, and more preferably 1,5,7-triazabicyclo[4.4.0]dec-5-ene.

When the carbonyl group-containing compound has an electron-withdrawing (electron-deficient) oxygen atom or nitrogen atom at R^{j14}, the olefin-containing amide compound can be obtained by reacting it with an olefin-containing amine compound.

The carbonyl group-containing compound having an electron-withdrawing (electron-deficient) oxygen atom or nitrogen atom at R^{j14} can be obtained by reacting a carbonyl group-containing compound having a carboxylic acid with a condensing agent or with an alcohol substituted with an electron-withdrawing group and a condensing agent.

The condensing agent may be preferably 1-(3-dimethylaminopropyl)-3-ethylcarbodiimide (EDC), 1-(3-dimethylaminopropyl)-3-ethylcarbodiimide hydrochloride (EDC·HCl), N,N'-dicyclohexylcarbodiimide (DCC), 1-[bis(dimethylamino)methylene]-1H-1,2,3-triazolo[4,5-b]pyridinium 3-oxide hexafluorophosphate (HATU), 1-[bis(dimethylamino)methylene]-1H-benzotriazolium 3-oxide hexafluorophosphate (HBTU), 1-[bis(dimethylamino)methylene]-1H-1,2,3-triazolo[4,5-b]pyridinium 3-oxide tetrafluoroborate (TATU), 1-[bis(dimethylamino)methylene]-1H-benzotriazolium 3-oxide tetrafluoroborate (TBTU), (1-cyano-2-ethoxy-2-oxoethylideneaminooxy)dimethylaminomorpholinocarbenium hexafluorophosphate (COMU), O-[(ethoxycarbonyl)cyanomethyleneamino]-N,N,N',N'-tetramethyluronium hexafluorophosphate (HOTU), 1H-benzotriazol-1-yloxytripyrrolidinophosphonium hexafluorophosphate (PyBOP), 1H-benzotriazol-1-yloxytris(dimethylamino)phosphonium hexafluorophosphate (BOP), bromotripyrrolidinophosphonium hexafluorophosphate (PyBroP), diphenylphosphoryl azide (DPPA), 4-(4,6-dimethoxy-1,3,5-triazin-2-yl)-4-methylmorpholinium chloride (DMT-MM), 1-hydroxybenzotriazole (HOBt), 1-hydroxy-7-azabenzotriazole (HOAt), 1,1'-carbonyldiimidazole (CDI), or 1,1'-carbonyldi(1,2,4-triazole) (CDT), and preferably 1,1'-carbonyldiimidazole or 1,1'-carbonyldi(1,2,4-triazole).

The alcohol substituted with an electron-withdrawing group may be preferably 4-nitrophenol, N-hydroxysuccinimide, or pentafluorophenol.

The reaction temperature is not limited. For example, the reaction temperature may be 0 to 150°C, 0 to 100°C, or 0 to 50°C.

The solvent may be, for example, at least one selected from the group consisting of diethyl ether, tetrahydrofuran, cyclopentyl methyl ether, ethylene glycol, dichloromethane, chloroform, benzene, toluene, and 1,3-bis(trifluoromethyl)benzene. Preferable are acetonitrile, dichloromethane, chloroform, toluene, diethyl ether, and tetrahydrofuran. Also, the reaction may be carried out without a solvent.

### (Production Method 2)

In this production method, an olefin group-containing compound is used as a raw material to produce the silane compound.

The olefin group-containing compound is a compound having R¹- and an olefin group (-CH=CH₂). Examples of the olefin group-containing compound include a compound obtained by the synthesis method described below.

For example, by a method comprising reacting an olefin group with HSiM₃ (wherein M is each independently a halogen atom or a C₁₋₆ alkoxy group) and further reacting the resulting compound with a compound represented by the formula: Hal-J-CH=CH₂ (wherein J represents Mg, Cu, Pd, or Zn, and Hal represents a halogen atom) and, as desired, a compound represented by the formula: R^{c}_{h'}L (wherein R^{c} has the same meanings as above, L represents a group capable of bonding with R^{c}, and h' is an integer of 1 to 3) to give the following compound:

R¹ - R^{j21} - CH₂CH₂ - SiR^{c'}ₘ (CH=CH₂)_{k'}

(wherein R¹ has the same meanings as those described for the formula (1); and -R^{j21}-CH₂CH₂- corresponds to X¹, or for example, -Rⁱ²¹-CH₂CH₂- is an alkylene group or an alkylene group containing an ether bond, such as a C₁₋₃₀ alkylene group or a C₁₋₃₀ alkylene group containing an ether bond, specifically a C₁₀₋₂₅ alkylene group or a C₁₀₋₂₅ alkylene group containing an ether bond); and
reacting the above compound with HSiM₃ (wherein M is each independently a halogen atom or a C₁₋₆ alkoxy group) and, as desired
a compound represented by the formula: R²³_{i'}L' (wherein R²³ has the same meanings as above, L' represents a group capable of bonding with R²³, and i' is an integer of 1 to 3) and, as desired,

a compound represented by the formula: R²⁴_{j'}L" (wherein R²⁴ has the same meanings as above, L" represents a group capable of bonding with R²⁴, and j' is an integer of 1 to 3),
the formula:

   R¹-R^{j22}₋R^{Si}
(wherein R¹ has the same meanings as those described for the formula (1), R^{j22} is a divalent organic group and corresponds to -R^{j21}-CH₂CH₂-, and R^{Si} has the same meanings as above)
can be produced. The above description is also be applicable to other olefin group-containing compounds.

### (Production Method 3)

In this production method, the silane compound is produced by reacting a carbonyl group-containing compound with an amine-containing silane compound.

A carbonyl group-containing compound is a compound containing R¹- and C(=O). Examples of the carbonyl group-containing compound include a compound obtained by the synthesis method described below.

The amine-containing silane compound is a compound having an H₂N- group and an R^{Si} group. Examples of the amine-containing silane compound include H₂N-R^{j23}-R^{Si}, and may specifically be aminopropyltrimethoxysilane. The R^{j23} is an alkylene group such as a C₁₋₄ alkylene group, and is specifically a methylene group, an ethylene group, or a propylene group; and R^{Si} has the same meanings as above and, for example, R^{Si} is represented by the formula (S2).

The reaction temperature is preferably 0°C to 150°C, and more preferably 20°C to 100°C.

Usable solvents may be the same as those in Production Method 1, and preferably toluene, dichloromethane, chloroform, methanol, and ethanol are usable.

### (Production Method 4)

In this production method, the silane compound is produced by reacting an olefin group-containing compound.

Specifically, the silane compound can be obtained by reacting an olefin group-containing compound with a compound represented by the following formula:

HSiR^{j25}ₘ₃R^{j26}₃₋ₘ₃

wherein
R^{j25} is each independently a hydroxyl group or a hydrolyzable group,
R^{j26} is each independently a monovalent organic group, and
m3 is 1 to 3.
The above description is also be applicable to other olefin group-containing compounds.

The olefin group-containing compound is a compound having R¹- and an olefin group. Examples of the olefin group-containing compound include a compound obtained by the synthesis method described below.

The carbonyl group-containing compound having terminal R¹ can be produced by the following method.

First, an unsaturated carboxylic acid or an unsaturated carboxylic acid ester such as a compound represented by the formula:

CH₂=CH-R⁸¹-COOR⁸²

(wherein
R⁸¹ is an alkylene group optionally containing an ether bond, and
R⁸² is a hydrogen atom or a C₁₋₆ alkyl group) is reacted with a silane compound such as a compound represented by the formula:

   R¹-(SiR⁸⁴₂O)ₙ-SiR⁸⁴₂-H

   (wherein
   R¹ has the same meanings as those described for the formula (1),
   R⁸⁴ is each independently a C₁₋₁₂ alkyl group, and
   n is 0 to 1,500)
      to give a compound represented by the formula:

      R¹-(SiR⁸⁴₂O)ₙ-SiR⁸⁴₂-CH₂CH₂-R⁸¹-COOR⁸².

The unsaturated carboxylic acid or the unsaturated carboxylic acid ester is an unsaturated carboxylic acid or an unsaturated carboxylic acid having 10 to 30 carbon atoms, and specific examples include 22-tricosenoic acid, methyl 22-tricosenoate, 10-undecenoic acid, and methyl 10-undecenoate.

The unsaturated carboxylic acid or the unsaturated carboxylic acid ester may contain an ether structure, and specific examples include the following structures:

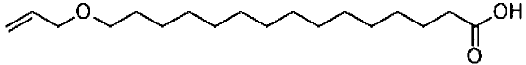

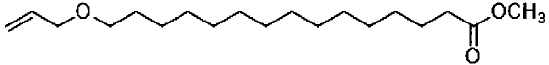

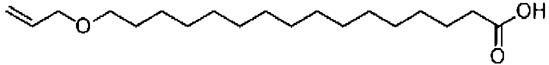

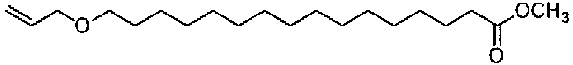

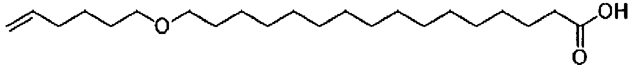

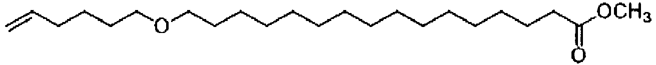

Specific examples of the silane compound include 1,1,1,3,5,5,5-heptamethyltrisiloxane, tris(trimethylsilyloxy)silane, and the following structure: 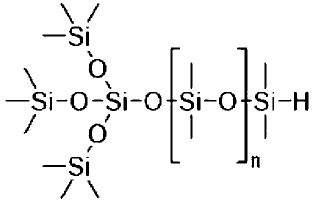 wherein, n is 0 to 500, and preferably 0 to 200;
in one embodiment, n is 0;
in one embodiment, n is 1 to 200, preferably 10 to 100, and more preferably 10 to 50; and
in one embodiment, n is preferably 1 to 10, and more preferably 1 to 6.

Alternatively, the carbonyl group-containing compound having terminal R¹ can be produced by the following method.

First, a carboxylic acid or a carboxylic acid ester having a terminal hydroxyl group, such as a compound represented by the formula:

HO-CH₂-R⁸¹-COOR⁸²

(wherein
R⁸² is an alkylene group optionally containing an ether bond, and
R⁸² is a hydrogen atom or a C₁₋₆ alkyl group) is reacted with a silane compound such as a compound represented by the formula:

   R¹-(SiR⁸⁴₂O)ₙ-SiR⁸⁴₂-H

   (wherein
   R¹ has the same meanings as those described for the formula (1),
   R⁸⁴ is each independently a C₁₋₁₂ alkyl group, and
   n is 0 to 1,500) to give a compound represented by the formula:

      R¹-(SiR⁸⁴₂O)ₙ-SiR⁸⁴₂-O-CH₂-R⁸¹-COOR⁸².

Specific examples of the carboxylic acid or the carboxylic acid ester having a terminal hydroxyl group include 15-hydroxypentadecanoic acid, methyl 15-hydroxypentadecanoate, 16-hydroxyhexadecanoic acid, and methyl 16-hydroxyhexadecanoate.

Specific examples of the silane compound include 1,1,1,3,5,5,5-heptamethyltrisiloxane, tris(trimethylsilyloxy)silane, and the following structure: 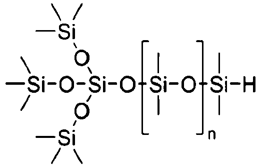 wherein, n is an integer of 0 to 500, and preferably 0 to 200;
in one embodiment, n is 0;
in one embodiment, n is 1 to 200, preferably 10 to 100, and more preferably 10 to 50; and
in one embodiment, n is preferably 1 to 10, and more preferably 1 to 6.

Alternatively, the carbonyl group-containing compound having terminal R¹ can be produced by, for example, the following method.

First, a carboxylic acid or a carboxylic acid ester having terminal chlorosilane, such as a compound represented by the formula:

Cl-Si(CH₃)₂-R⁸¹-COO⁸²

(wherein
R⁸¹ is an alkylene group optionally containing an ether bond, and
R⁸² is a hydrogen atom or a C₁₋₆ alkyl group) is reacted with a silane compound such as a compound represented by the formula:

   R¹-(SiR⁸⁴₂O)ₙ-SiR⁸⁴₂-OH

   (wherein
   R¹ has the same meanings as those described for the formula (1),
   R⁸⁴ is each independently a C₁₋₁₂ alkyl group, and
   n is 0 to 1,500) to give a compound represented by the formula:

      R¹-(SiR⁸⁴₂O)ₙ-SiR⁸⁴₂-O-Si(CH₃)₂-R⁸¹-COOR⁸².

Specific examples of the carboxylic acid or the carboxylic acid ester having terminal chlorosilane include the following structures:

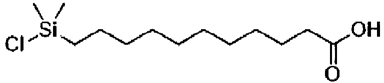

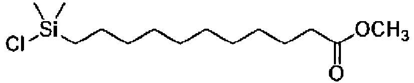

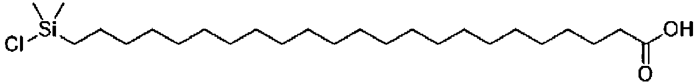

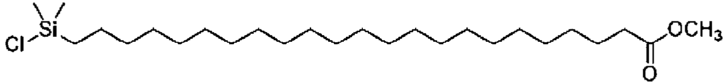

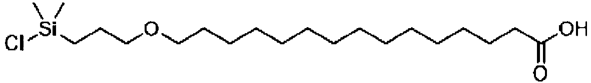

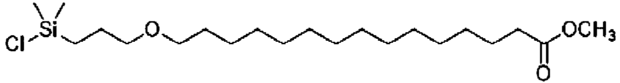

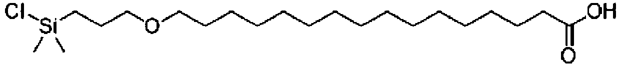

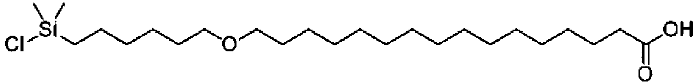

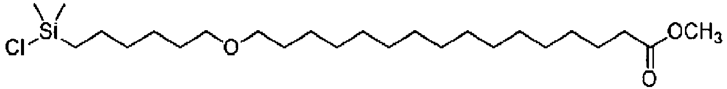

Specific examples of the silane compound include the following structures: 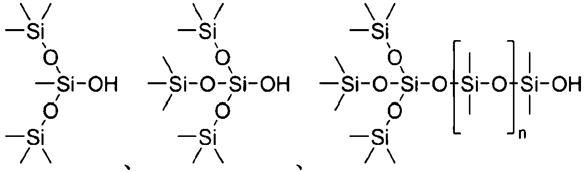 wherein, n is an integer of 0 to 500, and preferably 0 to 200;
in one embodiment, n is 0;
in one embodiment, n is 1 to 200, preferably 10 to 100, and more preferably 10 to 50; and
in one embodiment, n is preferably 1 to 10, and more preferably 1 to 6.

Alternatively, the carbonyl group-containing compound having terminal R¹ can be produced by the following method.

First, a carboxylic acid or a carboxylic acid ester having a terminal hydroxyl group such as a compound represented by the formula:

XO-[Si(CH₃)₂]ₙ-Si(CH₃)₂-R⁸¹-COOR⁸²

(wherein
R⁸¹ is an alkylene group optionally containing an ether bond,
R⁸² is a hydrogen atom or a C₁₋₆ alkyl group, and
X is hydrogen or lithium) is reacted with a silane compound such as a compound represented by the formula:

   R¹-(SiR⁸⁴₂O)ₙ-SiR⁸⁴₂-Cl

   (wherein
   R¹ has the same meanings as those described for the formula (1),
   R⁸⁴ is each independently a C₁₋₁₂ alkyl group, and
   n is 0 to 1,500) to give a compound represented by the formula:

      R¹-(SiR⁸⁴₂O)ₙ-SiR⁸⁴₂-O-[Si(CH₃)₂]ₙ-Si(CH₃)₂-R⁸¹-COOR⁸²

Specific examples of the carboxylic acid or the carboxylic acid ester having a terminal hydroxyl group include 15-hydroxypentadecanoic acid, methyl 15-hydroxypentadecanoate, 16-hydroxyhexadecanoic acid, and methyl 16-hydroxyhexadecanoate.

Specific examples of the silane compound include the following structures: 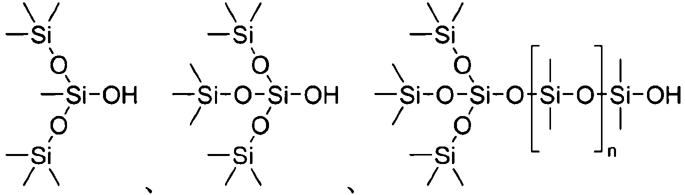 wherein, n is an integer of 0 to 500, and preferably 0 to 200;
in one embodiment, n is 0;
in one embodiment, n is 1 to 200, preferably 10 to 100, and more preferably 10 to 50; and
in one embodiment, n is preferably 1 to 10, and more preferably 1 to 6.

The olefin group-containing compound can be produced by the following method.

First, an olefin having a terminal hydroxyl group, such as a compound represented by the formula:

HO-CH₂-R⁸¹-CH=CH₂

(wherein
R⁸¹ is an alkylene group optionally containing an ether bond)
is reacted with a silane compound such as a compound represented by the formula:

R¹-(SiR⁸⁴₂O)ₙ-SiR⁸⁴₂-H

(wherein
R¹ has the same meanings as those described for the formula (1),
R⁸⁴ is each independently a C₁₋₁₂ alkyl group, and
n is 0 to 1,500) to give a compound represented by the formula:

   R¹-(SiR⁸⁴₂O)ₙ-SiR⁸⁴₂-O-CH₂-R⁸¹-CH=CH₂

Specific examples of the olefin having a terminal hydroxyl group include 3-hydroxypropene, 4-hydroxy-1-butene, 5-hydroxy-1-pentene, 6-hydroxy-1-hexene, 7-hydroxy-1-heptene, 8-hydroxy-1-octene, 9-hydroxy-1-nonene, 10-hydroxy-1-decene, 11-hydroxy-1-undecene, 12-hydroxy-1-dodecene, 13-hydroxy-1-tridecene, 14-hydroxy-1-tetradecene, 15-hydroxy-1-pentadecene, 16-hydroxy-1-hexadecene, 17-hydroxy-1-heptadecene, 18-hydroxy-1-octadecene, 19-hydroxy-1-nonadecene, 20-hydroxy-1-icosene, 21-hydroxy-1-henicosene, 24-hydroxy-1-tetracosene, and 30-hydroxy-1-triacontene.

Specific examples of the silane compound include 1,1,1,3,5,5,5-heptamethyltrisiloxane, tris(trimethylsilyloxy)silane, and the following structure:

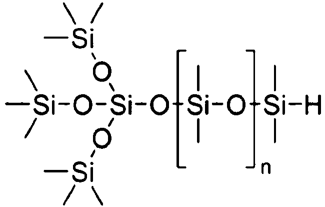

Alternatively, the olefin group-containing compound can be produced by the following method.

First, a carboxylic acid or a carboxylic acid ester having a terminal hydroxyl group such as a compound represented by the formula:

XO-[Si(CH₃)₂]ₙ-Si(CH₃)₂-R⁸¹-CH=CH₂

(wherein
R⁸¹ is an alkylene group optionally containing an ether bond, and
X is hydrogen or lithium) is reacted with a silane compound such as a compound represented by the formula:

   R¹-(SiR⁸⁴₂O)ₙ-SiR⁸⁴₂-Cl

   (wherein
   R¹ has the same meanings as those described for the formula (1),
   R⁸⁴ is each independently a C₁₋₁₂ alkyl group, and
   n is 0 to 1,500) to give a compound represented by the formula:

      R¹-(SiR⁸⁴₂O)ₙ-SiR⁸⁴₂-O-[Si(CH₃)₂]ₙ-Si(CH₃)₂-R⁸¹-CH=CH₂

Specific examples of the carboxylic acid or the carboxylatic acid ester having a terminal hydroxyl group include 15-hydroxypentadecanoic acid, methyl 15-hydroxypentadecanoate, 16-hydroxyhexadecanoic acid, and methyl 16-hydroxyhexadecanoate.

Specific examples of the silane compound include the following structures: 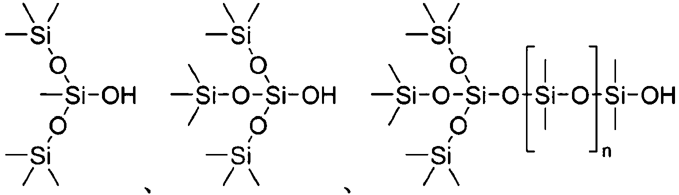 wherein, n is an integer of 0 to 500, and preferably 0 to 200;
in one embodiment, n is 0;
in one embodiment, n is 1 to 200, preferably 10 to 100, and more preferably 10 to 50; and
in one embodiment, n is preferably 1 to 10, and more preferably 1 to 6.

The present disclosure provides an intermediate for obtaining the silane compounds of the present disclosure.

The present disclosure provides a compound represented by the following formula:

CH₂=CH-(CH₂)ₙ₁₁₁COR¹¹¹

wherein n111 is an integer of 25 or more, and
R¹¹¹ is a hydrogen atom, a hydroxyl group, or a saturated or unsaturated hydrocarbon group having 1 to 12 carbon atoms and optionally substituted with a halogen.

n111 is an integer of 25 or more, and preferably an integer of 25 to 80, 25 to 60, or 25 to 30.

R¹¹¹ is a hydrogen atom, a hydroxyl group, or a saturated or unsaturated hydrocarbon group having 1 to 12 carbon atoms and optionally substituted with a halogen. The halogen is fluorine, chlorine, bromine, or iodine, preferably fluorine or chlorine, and more preferably chlorine. The hydrocarbon group is an alkyl group or an alkenyl group having 1 to 12 carbon atoms. In one embodiment, the hydrocarbon group is an alkyl group having 1 to 12 carbon atoms. The hydrocarbon group is an alkenyl group having 1 to 12 carbon atoms.

The present disclosure provides a compound represented by the following formula:

CH₂=CH-(CH₂)ₙ₁₁₂COR¹¹²

wherein n112 is an integer of 7 or more, and
R¹¹² is an electron-withdrawing group containing an oxygen atom or a nitrogen atom directly bonded to a carbonyl group.

n112 is an integer of 7 or more, and preferably an integer of 7 to 80, 11 to 60, or 11 to 30.

R¹¹² is an electron-withdrawing group containing an oxygen atom or a nitrogen atom directly bonded to a carbonyl group. The electron-withdrawing group is, for example, -NH₂, -NHR¹¹⁷, -NR¹¹⁷₂, -OH, -NHCOR¹¹⁷, or -OCOR¹¹⁷. R¹¹⁷ is a C₁₋₆ alkyl group.

The present disclosure provides a compound represented by the following formula:

R^{A}-X¹¹¹-Rⁱ

wherein
R^{A} is a group A,
the group A has the same meanings as above,
Rⁱ is COOR¹¹³, CONR¹¹⁴₂, CONR¹¹³-R¹¹⁵-CR¹¹⁴₃, or COR¹¹⁶,
   R¹¹³ is a hydrogen atom, a hydroxyl group, or a saturated or unsaturated hydrocarbon group having 1 to 12 carbon atoms and optionally substituted with a halogen,
   R¹¹⁴ is an alkenyl group having 2 to 20 carbon atoms and having a terminal double bond,
   R¹¹⁵ is a divalent organic group, and preferably an alkylene group having 2 to 20 carbon atoms,
   R¹¹⁶ is an electron-withdrawing group containing an oxygen atom or a nitrogen atom directly bonded to a carbonyl group, and
X¹¹¹ is an alkylene group having 8 or more carbon atoms.

R¹¹³ is a hydrogen atom, a hydroxyl group, or a saturated or unsaturated hydrocarbon group having 1 to 12 carbon atoms and optionally substituted with a halogen. The halogen is fluorine, chlorine, bromine, or iodine, preferably fluorine or chlorine, and more preferably chlorine. The hydrocarbon group is an alkyl group or an alkenyl group having 1 to 12 carbon atoms. In one embodiment, the hydrocarbon group is an alkyl having 1 to 12 carbon atoms. The hydrocarbon group is an alkenyl group having 1 to 12 carbon atoms.

R¹¹⁴ is an alkenyl group having 2 to 20 carbon atoms and having a terminal double bond, such as an alkenyl group having 11 to 20 carbon atoms.

R¹¹⁶ is an electron-withdrawing group containing an oxygen atom or a nitrogen atom directly bonded to a carbonyl group. The electron-withdrawing group is, for example, -NH₂, -NHR¹¹⁷, -NR¹¹⁷₂, -OH, -NHCOR¹¹⁷, or -OCOR¹¹⁷. R¹¹⁷ is a C₁₋₆ alkyl group.

X¹¹¹ is an alkylene group having 8 or more carbon atoms, such as an alkylene group having 8 to 80, 8 to 60, or 8 to 30 carbon atoms.

Next, the surface-treating agent of the present invention will now be described.

The surface-treating agent of the present disclosure contains at least one silane compound represented by the formula (1). That is to say, the surface-treating agent of the present disclosure may contain two silane compounds represented by the formula (1).

The silane compound represented by the formula (1) may contain a silane compound having one Si atom to which a hydrolyzable group is bonded, and a silane compound having two or more, such as two or three, Si atoms to which a hydrolyzable group is bonded.

The proportion, in terms of mass ratio, of the silane compound having one Si atom to which a hydrolyzable group is bonded to the silane compound having two or more Si atoms to which a hydrolyzable group is bonded may be 10:90 to 90:10, preferably 20:80 to 80:20, such as 30:70 to 70:30, 40:60 to 60:40, or 45:55 to 55:45.

In one embodiment, the surface-treating agent of the present disclosure is at least one compound itself that is represented by the formula (1).

In one embodiment, the content of the compound represented by the formula (1) is preferably 0.1 to 50.0% by mass, more preferably 1.0 to 30.0% by mass, even more preferably 5.0 to 25.0% by mass, and particularly preferably 10.0 to 20.0% by mass based on the entirety of the surface-treating agent.

In another embodiment, the content of the compound represented by the formula (1) is preferably 0.001 to 30% by mass, more preferably 0.01 to 10% by mass, even more preferably 0.05 to 5% by mass, and particularly preferably 0.05 to 2% by mass based on the entirety of the surface-treating agent.

In one embodiment, the surface-treating agent of the present disclosure may contain the compound represented by the formula (1) and a condensate in which at least a part of the compound represented by the formula (1) is condensed.

In the above embodiment, the content of the condensate may be preferably 40% by mass or less and more preferably 30% by mass or less based on the sum of the compound represented by the formula (1) and the condensate. Here, the content of the condensate can be determined from, for example, the abundance ratio of the peak position to the area in GPC (gel permeation chromatography).

The surface-treating agent of the present disclosure may further contain a compound represented by the following formula (3):

R⁵¹-R⁵²-CONR⁵⁴-R⁵³-SiR¹¹ₙ₁R¹²₃₋ₙ₁ (3)

wherein
R⁵¹ is CH₃CH₂CH₂-, CH₃CH=CH-, or R¹²₃₋ₙ₁R¹¹ₙ₁Si-,
R⁵² is a C₀₋₃₀ alkylene group,
R⁵³ is a C₁₋₁₀ alkylene group,
R⁵⁴ is a hydrogen atom, a C₁₋₆ alkyl group, or a phenyl group,
R¹¹ is each independently a hydroxyl group or a hydrolyzable group,
R¹² is each independently a hydrogen atom or a monovalent organic group, and
n1 is an integer of 1 to 3.

The surface-treating agent of the present disclosure contains the compound represented by the formula (3), and thus has more increased friction durability.

In one embodiment, R⁵¹ may be CH₃CH₂CH₂- or CH₃CH=CH-.

In one embodiment, R⁵² is a C₀ alkylene group. That is to say, it is a single bond.

In another embodiment, R⁵² may be a C₁₋₃₀ alkylene group such as a C₁₋₁₀ alkylene group, a C₃₋₆ alkylene group, a C₆₋₂₇ alkylene group, a C₇₋₂₃ alkylene group, a C₈₋₂₁ alkylene group, or a C₉₋₁₉ alkylene group.

R⁵³ is a C₁₋₁₀ alkylene group, preferably a C₂₋₆ alkylene group, and more preferably a C₂₋₄ alkylene group.

In one embodiment, R⁵⁴ is a hydrogen atom.

In another embodiment, R⁵⁴ is a C₁₋₆ alkyl group or a phenyl group.

The C₁₋₆ alkyl group in R⁵⁴ may be linear or may be branched. In one embodiment, the C₁₋₆ alkyl group is linear. In another embodiment, the C₁₋₆ alkyl group is branched. The C₁₋₆ alkyl group is preferably a C₁₋₄ alkyl group.

R¹¹, R¹², and n have the same meanings as defined in the formula (1).

The surface-treating agent of the present disclosure may contain the compound represented by the formula (3) in an amount of preferably 0.1% by mass to 30% by mass, more preferably 0.5% by mass to 20% by mass, and even more preferably 1.0% by mass to 20% by mass, based on the sum of the compound represented by the formula (1) and the compound represented by the formula (3).

In one embodiment, the surface-treating agent of the present disclosure may contain the compound represented by the formula (3) wherein R⁵⁴ is a C₁₋₆ alkyl group or a phenyl group in an amount of, for example, 0.5% by mass to 99.5% by mass, preferably 0.5% by mass to 30% by mass, more preferably 1.0% by mass to 20% by mass, or 30% by mass to 70% by mass, or 70% by mass to 99.5% by mass, based on the sum of the compound represented by the formula (1) and the compound represented by the formula (3).

In one embodiment, the surface-treating agent of the present disclosure may contain the compound represented by the formula (3) wherein R⁵⁴ is R¹²₃₋ₙ₁R¹¹ₙ₁Si- in an amount of, for example, 0.1% by mass to 99.5% by mass, preferably 0.1% by mass to 3.0% by mass, more preferably 0.1% by mass to 1.0% by mass, or 3.0% by mass to 50% by mass, 50% by mass to 99.5% by mass, 30% by mass to 70% by mass, or 70% by mass to 99.5% by mass, based on the sum of the compound represented by the formula (1) and the compound represented by the formula (3).

The composition of the present disclosure may contain a solvent, a (non-reactive) silicone compound that may be understood as a silicone oil (hereinafter, referred to as "silicone oil"), an amine compound, an alcohol, a catalyst, a surfactant, a polymerization inhibitor, a sensitizer, and the like.

In one embodiment, the surface-treating agent of the present disclosure contains a compound represented by R⁹⁰-OH.

R⁹⁰ is a monovalent organic group and is preferably a C₁₋₂₀ alkyl group or a C₃₋₂₀ alkylene group, and these groups may be substituted with one or more substituents. Examples of substituents include a hydroxyl group and - OR⁹¹ wherein R⁹¹ is a C₁₋₁₀ alkyl group, and preferably a C₁₋₃ alkyl group, such as a methyl group.

In one embodiment, the surface-treating agent of the present disclosure may contain a solvent selected from the compounds represented by R⁸¹OR⁸², R⁸³ₙ₈C₆H₆₋ₙ₈, R⁸⁴R⁸⁵R⁸⁶Si-(O-SiR⁸⁷R⁸⁸)ₘ₈-R⁸⁹, and (OSiR⁸⁷R⁸⁸)ₘ₉,
wherein
R⁸¹ to R⁸⁹ are each independently a monovalent organic group having 1 to 10 carbon atoms,
m8 is an integer of 1 to 6,
m9 is an integer of 3 to 8, and
n8 is an integer of 0 to 6.

The monovalent organic group having 1 to 10 carbon atoms may be linear or branched, and may further contain a cyclic structure.

In one embodiment, the monovalent organic group having 1 to 10 carbon atoms may contain an oxygen atom, a nitrogen atom, or a halogen atom.

In another embodiment, the monovalent organic group having 1 to 10 carbon atoms does not contain a halogen atom.

In a preferable embodiment, the monovalent organic group having 1 to 10 carbon atoms is a hydrocarbon group optionally substituted with a halogen, and preferably a hydrocarbon group not substituted with a halogen.

In one embodiment, the hydrocarbon group is linear.

In another embodiment, the hydrocarbon group is branched.

In another embodiment, the hydrocarbon group contains a cyclic structure.

In one embodiment, the solvent is R⁸¹OR⁸².

R⁸¹ and R⁸² may be, each independently, preferably a hydrocarbon group having 1 to 8 carbon atoms, and more preferably a C₁₋₆ alkyl group or a C₅₋₈ cycloalkyl group.

In one embodiment, the solvent is R⁸³ₙ₈ C₆H₆₋ₙ₈.

C₆H₆₋ₙ₈ is an n8-valent benzene ring. That is to say, R⁸³ₙ₈C₆H₆₋ₙ₈ is benzene substituted with n8 R⁸³.

R⁸³ may be each independently a halogen, or a C₁₋₆ alkyl group optionally substituted with a halogen.

n8 is preferably an integer of 1 to 3.

In one embodiment, the solvent is R⁸⁴R⁸⁵R⁸⁶Si-(O-SiR⁸⁷R⁸⁸)ₘ₈-R⁸⁹.

In one embodiment, the solvent is (OSiR⁸⁷R⁸⁸)ₘ₉. (OSiR⁸⁷R⁸⁸)ₘ₉ is a cyclic siloxane formed of multiple OSiR⁸⁷R⁸⁸ units bonded in a cyclic form.

R⁸⁴ to R⁸⁹ are each independently a hydrogen atom or a C₁₋₆ alkyl group, preferably a C₁₋₆ alkyl group, more preferably a C₁₋₃ alkyl group, and even more preferably a methyl group.

m8 is preferably an integer of 1 to 6, more preferably an integer of 1 to 5, and even more preferably 1 to 2.

m9 is preferably an integer of 3 to 6, and more preferably an integer of 3 to 5.

In one embodiment, examples of the solvent include aliphatic hydrocarbons such as hexane, cyclohexane, heptane, octane, nonane, decane, undecane, dodecane, and mineral spirits; aromatic hydrocarbons such as benzene, toluene, xylene, naphthalene, and solvent naphtha; esters such as methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl 2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, and ethyl 2-hydroxyisobutyrate; ketones such as acetone, methyl ethyl ketone, methyl isobutyl ketone, 2-hexanone, cyclohexanone, methyl amino ketone, and 2-heptanone; glycol ethers such as ethyl cellosolve, methyl cellosolve, methyl cellosolve acetate, ethyl cellosolve acetate, propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether, and ethylene glycol monoalkyl ether; alcohols such as methanol, ethanol, iso-propanol, n-butanol, isobutanol, tert-butanol, sec-butanol, 3-pentanol, octyl alcohol, 3-methyl-3-methoxybutanol, and tert-amyl alcohol; glycols such as ethylene glycol and propylene glycol; cyclic ethers such as tetrahydrofuran, tetrahydropyran, and dioxane; amides such as N,N-dimethylformamide, N,N-dimethylacetamide, and N-methylpyrrolidone; ether alcohols such as methyl cellosolve, cellosolve, isopropyl cellosolve, butyl cellosolve, and diethylene glycol monomethyl ether; diethylene glycol monoethyl ether acetate; polyfluoroaromatic hydrocarbons (for example, 1,3-bis(trifluoromethyl)benzene); polyfluoroaliphatic hydrocarbons (for example, C₆F₁₃CH₂CH₃ (for example, ASAHIKLIN(R) AC-6000 manufactured by AGC Inc.), C₆F₁₃H (for example, ASAHIKLIN(R) AC-2000 manufactured by AGC Inc.), and 1,1,2,2,3,3,4-heptafluorocyclopentane (for example, Zeorolla(R) H manufactured by ZEON Corporation); fluorine-containing hydrocarbons such as 1,1,2-trichloro-1,2,2-trifluoroethane, 1,2-dichloro-1,1,2,2-tetrafluoroethane, 1,1-dichloro-1,2,2,3,3-pentafluoropropane (HCFC 225), and 1,3-bis(trifluoromethyl)benzene; fluorine-containing alcohols such as CF₃CH₂OH, CF₃CF₂CH₂OH, and (CF₃)₂CHOH; alkyl perfluoroalkyl ethers (the perfluoroalkyl group and the alkyl group may be linear or branched) such as hydrofluoroethers (HFE) (for example, perfluoropropyl methyl ether (C₃F₇OCH₃) (for example, Novec(TM) 7000 manufactured by SUMITOMO 3M), perfluorobutyl methyl ether (C₄F₉OCH₃) (for example, Novec(TM) 7100 manufactured by SUMITOMO 3M), perfluorobutyl ethyl ether (C₄F₉OC₂H₅) (for example, Novec(TM) 7200 manufactured by SUMITOMO 3M), and perfluorohexyl methyl ether (C₂F₅CF(OCH₃)C₃F₇) (for example, Novec(TM) 7300 manufactured by SUMITOMO 3M), or CF₃CH₂OCF₂CHF₂ (for example, ASAHIKLIN(R) AE-3000 manufactured by AGC Inc.)), hydrofluoroolefins; ethers such as CF₃CH=CHCl (for example, CELEFIN(R) 1233Z manufactured by Central Glass Co., Ltd.), CHF₂CF=CHCl (for example, AMOLEA(R) AS-300 manufactured by AGC Inc.), and cyclopentyl methyl ether; siloxanes such as hexamethyldisiloxane, hexaethyldisiloxane, octamethyltrisiloxane, octamethylcyclotetrasiloxane, octamethylcyclopentasiloxane, decamethylcyclopentasiloxane, decamethyltetrasiloxane, dodecamethylpentasiloxane, and tetradecamethylhexasiloxane; and dimethylsulfoxide. Alternatively, the solvent may be a mixed solvent of two or more of such solvents. In particular, preferable are aliphatic hydrocarbons, esters, glycol ethers, alcohols, ether alcohols, and siloxanes. For example, preferable are hexane, cyclohexane, heptane, octane, nonane, decane, undecane, dodecane, mineral spirits, methyl acetate, ethyl acetate, propyl acetate, n-butyl acetate, isopropyl acetate, isobutyl acetate, propylene glycol monomethyl ether, propylene glycol monoethyl ether, propylene glycol monobutyl ether, methanol, ethanol, iso-propanol, n-butanol, isobutanol, tert-butanol, sec-butanol, diethylene glycol monomethyl ether, hexamethyldisiloxane, hexaethyldisiloxane, octamethyltrisiloxane, decamethyltetrasiloxane, dodecamethylpentasiloxane, tetradecamethylhexasiloxane, octamethylcyclotetrasiloxane, and octamethylcyclopentasiloxane.

Examples of the silicone oil include, but are not limited to, compounds represented by the following general formula (3a):

R^{1a}-(SiR^{3a}₂⁻O)ₐ₁-SiR^{3a}₂-R^{1a} (3a)

wherein
R^{1a} is each independently a hydrogen atom or a hydrocarbon group,
R^{3a} is each independently a hydrogen atom or a hydrocarbon group, and
a1 is 2 to 3,000.

R^{3a} is each independently a hydrogen atom or a hydrocarbon group. Such a hydrocarbon group may be substituted.

R^{3a} is, each independently, preferably an unsubstituted hydrocarbon group or a hydrocarbon group substituted with a halogen atom. Such a halogen atom is preferably a fluorine atom.

R^{3a} is, each independently, preferably a C₁₋₆ alkyl group or an aryl group optionally substituted with a halogen atom, and more preferably a C₁₋₆ alkyl group or an aryl group.

The C₁₋₆ alkyl group may be linear or may be branched, and is preferably linear.
The C₁₋₆ alkyl group is preferably a C₁₋₃ alkyl group, and more preferably a methyl group.

The aryl group is preferably a phenyl group.

In one embodiment, R^{3a} is each independently a C₁₋₆ alkyl group, preferably a C₁₋₃ alkyl group, and more preferably a methyl group.

In another embodiment, R^{3a} is a phenyl group.

In another embodiment, R^{3a} is a methyl group or a phenyl group, and preferably a methyl group.

R^{1a} is each independently a hydrogen atom or a hydrocarbon group, and has the same meanings as those described for R^{3a}.

R^{1a} is, each independently, preferably a C₁₋₆ alkyl group or an aryl group optionally substituted with a halogen atom, and more preferably a C₁₋₆ alkyl group or an aryl group.

In one embodiment, R^{1a} is each independently a C₁₋₆ alkyl group, preferably a C₁₋₃ alkyl group, and more preferably a methyl group.

In another embodiment, R^{1a} is a phenyl group.

In another embodiment, R^{1a} is a methyl group or a phenyl group, and preferably a methyl group.

a1 is 2 to 1,500. a1 may be preferably 5 or more, more preferably 10 or more, and even more preferably 15 or more, such as 30 or more or 50 or more. a1 may be preferably 1,000 or less, more preferably 500 or less, even more preferably 200 or less, and yet more preferably 150 or less, such as 100 or less or 80 or less.

a1 may be preferably 5 to 1,000, more preferably 10 to 500, even more preferably 15 to 200, and yet more preferably 15 to 150.

Other examples of the silicone oil include compounds represented by (3b) below:

R^{1a}-R^{SO2}-R^{3a} (3b)

wherein
R^{1a} is each independently a hydrocarbon group,
R^{3a} is each independently a hydrocarbon group, and
R^{SO2} is -R^{S}-SiR⁵₂-, wherein R^{S} and R⁵ have the same meanings as above.

The silicone oil may have an average molecular weight of 500 to 1,000,000, and preferably 1,000 to 100,000. The molecular weight of the silicone oil may be measured using GPC.

The silicone oil may be, for example, a linear or cyclic silicone oil in which a1 in -(SiR^{3a}₂-O)ₐ₁- is 30 or less. The linear silicone oil may be a so-called straight silicone oil or modified silicone oil. Examples of the straight silicone oil include dimethyl silicone oil, methyl phenyl silicone oil, and methyl hydrogen silicone oil. Examples of the modified silicone oil include those obtained by modifying a straight silicone oil with alkyl, aralkyl, polyether, higher fatty acid ester, fluoroalkyl, amino, epoxy, carboxyl, alcohol, or the like. The cyclic silicone oil may be, for example, cyclic dimethylsiloxane oil.

The silicone oil may be contained in an amount of, for example, 0 to 50% by mass, preferably 0.001 to 30% by mass, and more preferably 0.1 to 5% by mass, based on the composition of the present disclosure.

In the composition of the present disclosure, such a silicone oil may be contained in an amount of, for example, 0 to 300 parts by mass, preferably 0 to 100 parts by mass, more preferably 0 to 50 parts by mass, and even more preferably 0 to 10 parts by mass, based on total 100 parts by mass of the compound of the present disclosure (in the case of two or more kinds, the total thereof, and the same applies below).

The silicone oil contributes to increasing the surface lubricity of the surface-treating layer.

Examples of the alcohol include methanol, ethanol, iso-propanol, n-butanol, isobutanol, tert-butanol, sec-butanol, 3-pentanol, octyl alcohol, 3-methyl-3-methoxybutanol, and tert-amyl alcohol. Such an alcohol added to the composition improves the stability of the composition.

Examples of the catalyst include acids (for example, acetic acid, hydrochloric acid, nitric acid, sulfuric acid, phosphoric acid, sulfonic acid, p-toluenesulfonic acid, trifluoroacetic acid, and the like), bases (for example, sodium hydroxide, potassium hydroxide, ammonia, triethylamine, diethylamine, and the like), transition metals (for example, Ti, Ni, Sn, Zr, Al, B, Si, Ta, Nb, Mo, W, Cr, Hf, V, and the like), and sulfur-containing compounds or nitrogen-containing compounds having an unshared electron pair in the molecular structure (for example, sulfoxide compounds, aliphatic amine compounds, aromatic amine compounds, phosphoric acid amide compounds, amide compounds, and urea compounds).

Examples of the aliphatic amine compound include diethylamine and triethylamine. Examples of the aromatic amine compound include aniline and pyridine.

In a preferable embodiment, the transition metal is contained as a transition metal compound represented by M-R, wherein M is a transition metal atom and R is a hydrolyzable group. By using a compound obtained by bonding a transition metal and a hydrolyzable group as the transition metal compound, the transition metal atom can be contained in the surface-treating layer more efficiently, and the abrasion durability and the chemical resistance of the surface-treating layer can be more increased.

The hydrolyzable group means a group that can undergo a hydrolysis reaction in the same manner as the hydrolyzable group concerning the above compound, i.e., means a group that can be removed from the transition metal atom by a hydrolysis reaction. Examples of the hydrolyzable group include -OR^{m}, -OCOR^{m}, -O-N=CR^{m}₂, -NR^{m}₂, -NHR^{m}, -NCO, and a halogen (in these formulae, R^{m} represents a substituted or unsubstituted C₁₋₄ alkyl group).

In a preferable embodiment, the hydrolyzable group is -OR^{m}, and preferably methoxy or ethoxy. By using an alkoxy group as the hydrolyzable group, the transition metal atom can be contained in the surface-treating layer more efficiently, and the abrasion durability and the chemical resistance of the surface-treating layer can be more increased.

In one embodiment, the hydrolyzable group may be the same as the hydrolyzable group contained in the above compound. By causing the hydrolyzable groups in the compound and in the transition metal compound to be the same group, the influence of such hydrolyzable groups being mutually exchanged, if ever, can be minimized.

In another embodiment, the hydrolyzable group may be different from the hydrolyzable group contained in the above compound. By causing the hydrolyzable groups in the above compound and in the transition metal compound to be different, the reactivity of hydrolysis can be controlled.

In one embodiment, the above hydrolyzable group and the hydrolyzable group contained in the above compound may be mutually exchanged in the composition.

In a preferable embodiment, the transition metal compound may be Ta(OR^{m})₅ (wherein R^{m} is a substituted or unsubstituted C₁₋₄ alkyl group), preferably Ta(OCH₂CH₃)₅ or Si(OR^{m})₁₋ₘ₁R^{m'}ₘ₁ (wherein R^{m} is a substituted or unsubstituted C₁₋₄ alkyl group, R^{m'} is a C₁₋₄ alkyl group, and m1 is 0 or 1), and preferably tetraethoxysilane, methyltrimethoxysilane, methyltriethoxysilane, tetraisopropoxysilane, dimethyldiethoxysilane, or dimethyldimethoxysilane.

The catalyst may be contained in an amount of, for example, 0.0002% by mass or more based on the entirety of the composition. The catalyst may be contained in an amount of preferably 0.02% by mass or more, and more preferably 0.04% by mass or more, based on the entirety of the composition. The catalyst may be contained in an amount of, for example, 10% by mass or less based on the entirety of the composition and, in particular, is contained in an amount of 1% by mass or less. The composition of the present disclosure can contribute to the formation of a surface-treating layer having better durability when the catalyst is contained in the concentration as described above.

The content of the catalyst is preferably 0 to 10% by mass, more preferably 0 to 5% by mass, and particularly preferably 0 to 1% by mass, based on the compound of the present disclosure.

The catalyst promotes hydrolysis and dehydrative condensation of the compound of the present disclosure, and promotes formation of a layer formed of the composition of the present disclosure.

Examples of other components include, in addition to those described above, tetraethoxysilane, methyltrimethoxysilane, 3-aminopropyltrimethoxysilane, 3-glycidoxypropyltrimethoxysilane, and methyltriacetoxysilane.

The composition of the present disclosure may contain, in addition to the components described above, trace amounts of Pt, Rh, Ru, 1,3-divinyltetramethyldisiloxane, triphenylphosphine, NaCl, KCl, silane condensates, and the like as impurities.

In one embodiment, the composition of the present disclosure is for a dry coating method, and preferably for vacuum deposition.

In one embodiment, the composition of the present disclosure is for a wet coating method, and preferably for dip coating.

The composition of the present disclosure can be formed into pellets by impregnating a porous material such as a porous ceramic material or a metal fiber such as a fiber obtained by, for example, solidifying steel wool in a cotton-like form with composition. Such pellets can be used in, for example, vacuum deposition.

The composition of the present disclosure is preferably used as a surface-treating agent or as a component of a surface-treating agent.

Below, the article of the present disclosure will now be described.

The article of the present disclosure includes a substrate and a layer (a surface-treating layer) on the substrate surface, the layer being formed of the surface-treating agent of the present disclosure.

The substrate usable in the present disclosure may be composed of any suitable material such as glass, resin (which may be natural or synthetic resin such as a commonly used plastic material), metal, ceramics, semiconductors (such as silicon and germanium), fiber (such as woven fabric and nonwoven fabric), fur, leather, wood, pottery, stone, building materials, and sanitary articles.

For example, when the article to be produced is an optical member, the material constituting the surface of the substrate may be a material for an optical member, such as glass or a transparent plastic. When the article to be produced is an optical member, some layer (or film), such as a hard coat layer or an antireflection layer, may be formed on the surface (the outermost layer) of the substrate. The antireflection layer may be any of a single-layer antireflection layer and a multi-layer antireflection layer. Examples of inorganic substances usable in the antireflection layer include SiO₂, SiO, ZrO₂, TiO₂, TiO, Ti₂O₃, Ti₂O₅, Al₂O₃, Ta₂O₅, Ta₃O₅, Nb₂O₅, HfO₂, Si₃N₄, CeO₂, MgO, Y₂O₃, SnO₂, MgF₂, and WO₃. One of these inorganic substances may be used singly, or two or more kinds thereof may be used in combination (for example, as a mixture). In the case of a multi-layer antireflection layer, SiO₂ and/or SiO is preferably used in the outermost layer thereof. When the article to be produced is an optical glass component for a touch panel, a part of the surface of the substrate (glass) may have a transparent electrode such as a thin film in which indium tin oxide (ITO), indium zinc oxide, or the like is used. The substrate, according to its specific configuration or the like, may have an insulating layer, an adhesive layer, a protecting layer, a decorated frame layer (ICON), an atomizing film layer, a hard coating layer, a polarizing film, a phase difference film, a liquid crystal display module, or the like.

The form of the substrate is not limited, and may be, for example, a plate, a film, or the like. The surface region of the substrate on which a surface-treating layer is to be formed may be at least a portion of the substrate surface, and may be suitably determined according to the application, specific configuration, and the like of an article to be produced.

In one embodiment, the substrate, or at least the surface portion thereof, may be composed of a material originally having a hydroxyl group. Examples of the material include glass, as well as metal (in particular, base metal) that forms a natural oxidized film or a thermal oxidized film on its surface, ceramics, and semiconductors. Alternatively, when the substrate has an insufficient amount of hydroxyl groups or when the substrate originally has no hydroxyl group as in resin and the like, a pre-treatment may be performed on the substrate to thereby introduce or increase hydroxyl groups on the surface of the substrate. Examples of such a pre-treatment include a plasma treatment (for example, corona discharge) and ion beam irradiation. The plasma treatment can be suitably utilized to not only introduce or increase hydroxyl groups on the substrate surface, but also clean the substrate surface (remove foreign matter and the like). Another example of such a pre-treatment is a method wherein a monolayer of a surface adsorbent having a carbon-carbon unsaturated bonding group is formed on the surface of the substrate by a LB method (a Langmuir-Blodgett method), a chemical adsorption method, or the like beforehand, and thereafter cleaving the unsaturated bond under an atmosphere containing oxygen, nitrogen, or the like.

In another embodiment, the substrate, or at least the surface portion thereof, may be composed of a material comprising another reactive group such as a silicone compound having one or more Si-H groups or alkoxysilane.

In a preferable embodiment, the substrate is glass. Such glass is preferably sapphire glass, soda-lime glass, alkali aluminosilicate glass, borosilicate glass, alkali-free glass, crystal glass, quartz glass, or crystallized glass, and is particularly preferably chemically strengthened soda-lime glass, chemically strengthened alkali aluminosilicate glass, or chemically bonded borosilicate glass.

In one embodiment, the article of the present disclosure may include a silicon oxide-containing intermediate layer between glass and the surface-treating layer. By providing such an intermediate layer, adhesion between glass and the surface-treating layer is increased, and durability is increased.

In a preferable embodiment, the intermediate layer may contain an alkali metal in addition to silicon oxide.

Examples of the alkali metal include lithium, sodium, and potassium. The alkali metal is preferably sodium.

The thickness of the intermediate layer is not limited, and is preferably 1 to 200 nm and particularly preferably 1 to 20 nm. By causing the thickness of the intermediate layer to be at the lower limit of the above range or greater, the effect of increasing adhesion provided by the intermediate layer is more increased.

The concentration of alkali metal atoms in the intermediate layer can be measured by various surface analysis apparatuses such as TOF-SIMS, XPS, and XRF.

The proportion of alkali metal atoms to all atoms in the entirety of the intermediate layer can be obtained by XPS depth profile analysis using ion sputtering, wherein measurement by XPS and surface etching by ion sputtering using an ion gun provided in an XPS apparatus are alternately performed.

In the intermediate layer, the average alkali metal concentration in a region having a depth of 1 nm or less from the surface that is in contact with the surface-treating layer is determined by obtaining a depth profile of the alkali metal atom concentration by TOF-SIMS (time-of-flight secondary ion mass spectrometry) depth analysis using ion sputtering, and then calculating the average alkali metal atom concentration in the profile. TOF-SIMS depth profile analysis by ion sputtering is performed by alternately repeating measurement by TOF-SIMS and surface etching by ion sputtering using an ion gun provided in a TOF-SIMS apparatus.

The article of the present disclosure can be produced by forming a layer of the surface-treating agent of the present disclosure on the surface of the substrate and post-treating this layer as necessary, thereby forming a layer from the surface-treating agent of the present disclosure.

The layer of the surface-treating agent of the present disclosure can be formed by applying the surface-treating agent to the surface of the substrate so as to coat the surface. The coating method is not limited. For example, a wet coating method and a dry coating method can be used.

Examples of the wet coating method include dip coating, spin coating, flow coating, spray coating, roll coating, gravure coating, wipe coating, squeegee coat method, die coat, inkjet, cast method, Langmuir-Blodgett method, and similar methods.

Examples of the dry coating method include deposition (usually, vacuum deposition), sputtering, CVD, and similar methods. Specific examples of the deposition method (usually, a vacuum deposition method) include resistive heating, high-frequency heating using electron beam, microwave, or the like, ion beam, and similar methods. Specific examples of the CVD method include plasma-CVD, optical CVD, thermal CVD, and similar methods.

Furthermore, coating by an atmospheric pressure plasma method can be performed.

When using the wet coating method, the surface-treating agent of the present disclosure can be applied to the substrate surface after being diluted with a solvent. From the viewpoint of the stability of the composition of the present disclosure and the volatility of the solvent, the following solvents are preferably used: aliphatic hydrocarbons such as hexane, cyclohexane, heptane, octane, nonane, decane, undecane, dodecane, and mineral spirits; aromatic hydrocarbons such as benzene, toluene, xylene, naphthalene, and solvent naphtha; esters such as methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl 2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, and ethyl 2-hydroxyisobutyrate; ketones such as acetone, methyl ethyl ketone, methyl isobutyl ketone, 2-hexanone, cyclohexanone, methyl amino ketone, and 2-heptanone; glycol ethers such as ethyl cellosolve, methyl cellosolve, methyl cellosolve acetate, ethyl cellosolve acetate, propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether, and ethylene glycol monoalkyl ether; alcohols such as methanol, ethanol, iso-propanol, n-butanol, isobutanol, tert-butanol, sec-butanol, 3-pentanol, octyl alcohol, 3-methyl-3-methoxybutanol, and tert-amyl alcohol; glycols such as ethylene glycol and propylene glycol; cyclic ethers such as tetrahydrofuran, tetrahydropyran, and dioxane; amides such as N,N-dimethylformamide, N,N-dimethylacetamide, and N-methylpyrrolidone; ether alcohols such as methyl cellosolve, cellosolve, isopropyl cellosolve, butyl cellosolve, and diethylene glycol monomethyl ether; diethylene glycol monoethyl ether acetate; polyfluoroaromatic hydrocarbons (for example, 1,3-bis(trifluoromethyl)benzene); polyfluoroaliphatic hydrocarbons (for example, C₆F₁₃CH₂CH₃ (for example, ASAHIKLIN(R) AC-6000 manufactured by AGC Inc.), C₆F₁₃H (for example, ASAHIKLIN(R) AC-2000 manufactured by AGC Inc.), and 1,1,2,2,3,3,4-heptafluorocyclopentane (for example, Zeorolla(R) H manufactured by ZEON Corporation); fluorine-containing hydrocarbons such as 1,1,2-trichloro-1,2,2-trifluoroethane, 1,2-dichloro-1,1,2,2-tetrafluoroethane, 1,1-dichloro-1,2,2,3,3-pentafluoropropane (HCFC 225), and 1,3-bis(trifluoromethyl)benzene; fluorine-containing alcohols such as CF₃CH₂OH, CF₃CF₂CH₂OH, and (CF₃)₂CHOH; alkyl perfluoroalkyl ethers (the perfluoroalkyl group and the alkyl group may be linear or branched) such as hydrofluoroethers (HFE) (for example, perfluoropropyl methyl ether (C₃F₇OCH₃) (for example, Novec(TM) 7000 manufactured by SUMITOMO 3M), perfluorobutyl methyl ether (C₄F₉OCH₃) (for example, Novec(TM) 7100 manufactured by SUMITOMO 3M), perfluorobutyl ethyl ether (C₄F₉OC₂H₅) (for example, Novec(TM) 7200 manufactured by SUMITOMO 3M), and perfluorohexyl methyl ether (C₂F₅CF(OCH₃)C₃F₇) (for example, Novec(TM) 7300 manufactured by SUMITOMO 3M), or CF₃CH₂OCF₂CHF₂ (for example, ASAHIKLIN(R) AE-3000 manufactured by AGC Inc.)), hydrofluoroolefins; ethers such as CF₃CH=CHCl (for example, CELEFIN(R) 1233Z manufactured by Central Glass Co., Ltd.), CHF₂CF=CHCl (for example, AMOLEA(R) AS-300 manufactured by AGC Inc.), and cyclopentyl methyl ether; siloxanes such as hexamethyldisiloxane, hexaethyldisiloxane, octamethyltrisiloxane, octamethylcyclotetrasiloxane, octamethylcyclopentasiloxane, decamethylcyclopentasiloxane, decamethyltetrasiloxane, dodecamethylpentasiloxane, and tetradecamethylhexasiloxane; and dimethylsulfoxide. One of these solvents may be used singly, or two or more may be used as a mixture. In particular, preferable are aliphatic hydrocarbons, esters, glycol ethers, alcohols, ether alcohols, and siloxanes. For example, particularly preferable are hexane, cyclohexane, heptane, octane, nonane, decane, undecane, dodecane, mineral spirits, methyl acetate, ethyl acetate, propyl acetate, n-butyl acetate, isopropyl acetate, isobutyl acetate, propylene glycol monomethyl ether, propylene glycol monoethyl ether, propylene glycol monobutyl ether, methanol, ethanol, iso-propanol, n-butanol, isobutanol, tert-butanol, sec-butanol, diethylene glycol monomethyl ether, hexamethyldisiloxane, hexaethyldisiloxane, octamethyltrisiloxane, decamethyltetrasiloxane, dodecamethylpentasiloxane, tetradecamethylhexasiloxane, octamethylcyclotetrasiloxane, and octamethylcyclopentasiloxane.

In one embodiment, the solvent when the wet coating method is used may be, for example, a compound represented by R⁹⁰-OH. R⁹⁰ is a monovalent organic group and is preferably a C₁₋₂₀ alkyl group or a C₃₋₂₀ alkylene group, and these groups may be substituted with one or more substituents. Examples of substituents include a hydroxyl group and -OR⁹¹ wherein R⁹¹ is a C₁₋₁₀ alkyl group, and preferably a C₁₋₃ alkyl group, such as a methyl group.

When using the dry coating method, the surface-treating agent of the present disclosure may be directly subjected to the dry coating method, or may be diluted with the solvent before being subjected to the dry coating method.

A layer of the surface-treating agent is preferably formed such that the surface-treating agent of the present disclosure coexists in the layer with a catalyst for hydrolysis and dehydrative condensation. Conveniently, in the case of a wet coating method, the surface-treating agent of the present disclosure is diluted with a solvent, and then, immediately before application to the substrate surface, a catalyst may be added to the diluted solution of the surface-treating agent of the present disclosure. In the case of a dry coating method, the surface-treating agent of the present disclosure to which a catalyst has been added is directly used in a deposition (usually vacuum deposition) treatment, or a pellet-like material may be used in a deposition (usually vacuum deposition) treatment, wherein pellets are obtained by impregnating a porous body of metal such as iron or copper with the surface-treating agent of the present disclosure to which the catalyst has been added.

The catalyst may be any suitable acid or base, transition metal (such as Ti, Ni, Sn, Zr, Al, or B), sulfur-containing compound or nitrogen-containing compound having an unshared electron pair in the molecular structure (such as a sulfoxide compound, an aliphatic amine compound, an aromatic amine compound, a phosphoric acid amide compound, an amide compound, or an urea compound), or the like. The acid catalyst may be, for example, acetic acid, formic acid, trifluoroacetic acid, hydrochloric acid, nitric acid, sulfuric acid, phosphoric acid, sulfonic acid, methanesulfonic acid, or p-toluenesulfonic acid. Also, the base catalyst may be, for example, ammonia, sodium hydroxide, potassium hydroxide, or an organic amine such as triethylamine or diethylamine. Examples of the transition metal, the aliphatic amine compound, and the aromatic amine compound include those described above.

The surface-treating layer contained in the article of the present disclosure may have high abrasion durability. Moreover, the surface-treating layer may have not only high abrasion durability but also have, depending on the composition of the surface-treating agent used, water-repellency, oil-repellency, antifouling properties (e.g., preventing grime such as fingerprints from adhering), waterproof properties (preventing water from entering electronic components and the like), surface lubricity (or lubricity, for example, such as removability by wiping of grime such as fingerprints, and excellent tactile sensations to the fingers), chemical resistance, and the like, and may be suitably used as a functional thin film.

Accordingly, the present disclosure further relates to an optical material having the surface-treating layer as the outermost layer.

The optical material preferably includes a wide variety of optical materials, in addition to optical materials relating to displays and the like as exemplified below: for example, displays such as cathode ray tubes (CRTs; for example, PC monitors), liquid crystal displays, plasma displays, organic EL displays, inorganic thin-film EL dot matrix displays, rear projection displays, vacuum fluorescent displays (VFDs), field emission displays (FEDs); protective plates for such displays; and those obtained by performing an antireflection film treatment on their surfaces.

The article of the present disclosure may be, but is not limited to, an optical member. Examples of the optical member include lenses of glasses or the like; front surface protective plates, antireflection plates, polarizing plates, and anti-glare plates for displays such as PDPs and LCDs; touch panel sheets for equipment such as cell phones and portable information terminals; disc surfaces of optical discs such as Blu-ray(R) discs, DVD discs, CD-Rs, and MOs; optical fibers; and display surfaces of watches and clocks.

The article of the present disclosure may be medical equipment or a medical material. The article having a layer that is obtained according to the present disclosure may be an automobile interior or exterior member. Examples of the exterior material are as follows: windows, light covers, and external camera covers. Examples of the interior material are as follows: instrument panel covers, navigation system touch panels, and decorative interior materials.

The thickness of the layer is not limited. The thickness of the layer in the case of an optical member may be in the range of, for example, 1 to 50 nm, preferably 1 to 30 nm, and more preferably 1 to 15 nm, from the viewpoint of optical performance, abrasion durability, and antifouling properties.

The apparatus for performing X-ray photoelectron spectroscopy for measuring the atomic composition and the ratio of constitutional atoms of the surface-treating layer may be XPS or PHI 5000 VersaProbe II manufactured by ULVAC-PHI, Inc. Usable measurement conditions for XPS analysis may be an X-ray source of 25 W monochromatic AlKα radiation, a photoelectron detection surface of 1,400 µm × 300 µm, a photoelectron detection angle in a range of 20° to 90° (for example, 20°, 45°, 90°), a pass energy of 23.5 eV, and sputtering with a gas cluster ion beam or Ar ions. The compositions of the surface-treating layer and the intermediate layer can be determined by observing the peak areas of C1s, O1s, and Si2p under the above apparatus and measurement conditions, and calculating the atomic ratio of carbon, oxygen, and silicon.

Also, depth profile analysis may be performed as well. Usable measurement conditions for XPS analysis may be an X-ray source of 25 W monochromatic AlKα radiation, a photoelectron detection surface of 1,400 µm × 300 µm, a photoelectron detection angle in a range of 20° to 90° (for example, 20°, 45°, 90°), a pass energy of 23.5 eV, and Ar ions, gas cluster ions, C60 ions, or the like as sputtering ions. Etching may be performed to 1 to 100 nm by sputtering, and the composition in the coating film at each etching depth may be obtained as well.

By adjusting the photoelectron detection angle of the XPS analysis, the detection depth can be suitably adjusted. For example, a shallow angle close to 20 degrees allows a detection depth of about 3 nm, while a deep angle close to 90 degrees allows a detection depth of about 10 nm.

The silicon oxide-containing intermediate layer described above can be formed by applying a silicon oxide precursor to the substrate surface. When the intermediate layer contains an alkali metal, the intermediate layer can be formed by applying a composition containing a silicon oxide precursor and an alkali metal source to the substrate surface.

Examples of the silicon oxide precursor include silicic acid, a partial condensate of silicic acid, an alkali metal silicate, a silane compound having a hydrolyzable group that is bonded to a silicon atom, and a partially hydrolyzed condensate of such a silane compound. Silicic acid and a partial condensate thereof can be converted to silicon oxide by dehydrative condensation, and an alkali metal silicate can be converted to silicon oxide by being converted first to silicic acid or a partial condensate thereof with an acid or a cation exchange resin and then dehydratively condensing the resulting silicic acid or partial condensate thereof. Examples of the hydrolyzable group in the silane compound having a hydrolyzable group that is bonded to a silicon atom include an alkoxy group and a chlorine atom. The hydrolyzable group of the silane compound can be hydrolyzed to give a hydroxyl group, and the resulting silanol compound can be dehydratively condensed to give silicon oxide. Examples of the silane compound having a hydrolyzable group that is bonded to a silicon atom include alkoxysilanes such as tetraalkoxysilane and alkyltrialkoxysilane, and tetrachlorosilane.

The alkali metal source includes alkali metal hydroxides, water-soluble alkali metal salts, and the like. Examples of the water-soluble alkali metal salts include alkali metal carbonates, alkali metal hydrogen carbonates, alkali metal hydrochlorides, and alkali metal nitrates. The alkali metal source is preferably an alkali metal hydroxide and an alkali metal carbonate.

Note that the alkali metal silicate can be used as a silicon oxide precursor and an alkali metal source. The alkali metal silicate can be converted to silicon oxide via silicic acid, and in this process, a small amount of alkali metal may remain in the produced silicon oxide. Accordingly, regulating the amount of the remaining alkali metal enables silicon oxide containing a predetermined amount of alkali metal atoms to be obtained.

The thickness of the intermediate layer is not limited, and is in the range of, for example, 1 to 50 nm, preferably 1 to 30 nm, more preferably 2 to 15 nm, and even more preferably 3 to 10 nm.

So far, the compound, the composition, and the article of the present disclosure have been described in detail. The compound, the composition, the article, and the like of the present disclosure are not limited to those exemplified above.

### Examples

Hereinafter, the present disclosure will now be described by way of Examples, but the present disclosure is not limited to the following Examples.

### (Synthetic Example 1)

First, 3.02 g of 22-tricosenoic acid, 26 mL of toluene, and 17 mL of methanol were each added, then 20 mL of trimethylsilyldiazomethane was added dropwise, and the mixture was stirred at room temperature for 3 hours. Thereafter, the mixture was concentrated under reduced pressure to give 3.11 g of compound (1).
¹H-NMR (CDCl₃, 400 MHz) δ [ppm]: 1.249 - 1.649 (m), 2.005 - 2.061 (m), 2.279 - 2.316 (t), 1.567 - 1.622 (m), 3.662 (s), 4.904 - 5.015 (m), 5.760 - 5.862 (m)

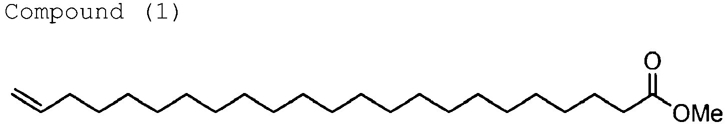

### (Synthetic Example 2)

First, 0.50 g of compound (1) obtained in Synthetic Example 1, 10.0 mL of toluene, 0.05 mL of pyridine, and 0.3 mL of a xylene solution containing a 2% Pt complex of 1,3-divinyl-1,1,3,3-tetramethyldisiloxane were each added, and then 1.2 mL of 1,1,1,3,5,5,5-heptamethyltrisiloxane was added dropwise. After being stirred at room temperature for 17 hours, the mixture was purified to give 0.87 g of the following compound (2).
¹H-NMR (CDCl₃, 400 MHz) δ [ppm]: 0.033 - 0.241 (m), 0.438 - 0.550 (m), 1.191 - 1.413 (m), 1.607 - 1.642 (m), 2.242 - 2.325 (m), 3.669 (s)

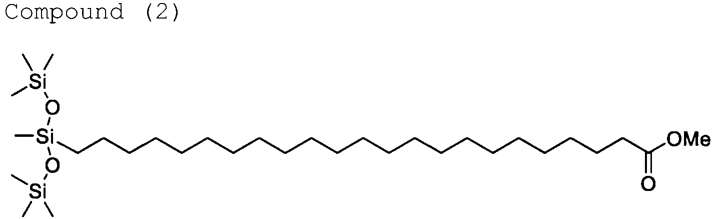

### (Synthetic Example 3)

First, 0.86 g of compound (2) obtained in Synthetic Example 2, 5.0 mL of allylamine, and 0.20 g of 1,5,7-triazabicyclo[4.4.0]dec-5-ene were each added, and the mixture was then stirred at 75°C for 3 hours. Thereafter, the mixture was washed with an aqueous hydrochloric acid solution, dehydrated over magnesium sulfate, and concentrated under reduced pressure to give 0.72 g of compound (3).
¹H-NMR (CDCl₃, 400 MHz) δ [ppm]: 0.076 - 0.128 (m), 0.413 - 0.465 (t), 1.183 - 1.1.404 (m), 1.604 - 1.677 (m), 2.173 - 2.248 (t), 3.841 - 3.942 (m), 5.122 - 5.210 (m), 5.809 - 5.877 (m)

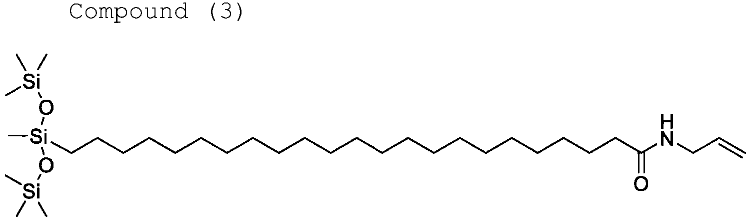

### (Synthetic Example 4)

First, 0.72 g of compound (3) obtained in Synthetic Example 3, 6.0 mL of toluene, 0.04 mL of pyridine, and 0.26 mL of a xylene solution containing a 2% Pt complex of 1,3-divinyl-1,1,3,3-tetramethyldisiloxane were each added, then 1.4 mL of trimethoxysilane was added, and the mixture was stirred at room temperature overnight. Thereafter, the mixture was purified to give 0.48 g of the following compound having a terminal trimethoxysilyl group (4).
¹H-NMR (CDCl₃, 400 MHz) δ [ppm]: 0.054 - 0.149 (m), 0.425 - 0.464 (t), 0.628 - 0.681 (m), 1.181 - 1.402 (m), 1.544 - 1.768 (m), 2.125 - 2.164 (t), 3.558 - 3.646 (m)

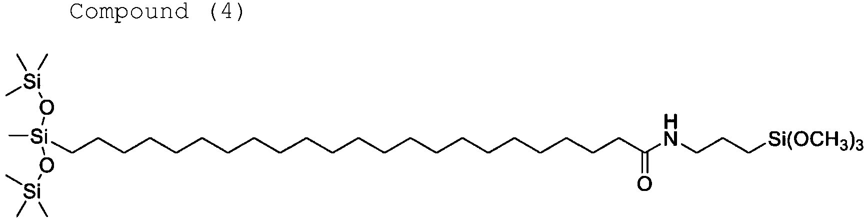

### (Surface-treating agent 1)

Compound 4 obtained above was diluted so as to be a 20 wt% ethanol solution, and thus a surface-treating agent 1 was obtained.

### (Synthetic Example 5)

First, 1.0 g of compound (1) obtained in Synthetic Example 1, 5.5 mL of toluene, 0.9 mL of chlorodimethylsilane, and 0.14 mL of a xylene solution containing a 2% Pt complex of 1,3-divinyl-1,1,3,3-tetramethyldisiloxane were each added, and the mixture was then stirred at 40°C for 4 hours. Thereafter, the mixture was purified to give 1.12 g of a compound having a terminal chlorodimethylsilyl group (101). Subsequently, in a different flask, 3 g of palladium/carbon (Pd 10%) (an approximately 55% product wet with water), 44 mL of tetrahydrofuran, 9 mL of water, and 10 mL of 1,1,1,3,5,5,5-heptamethyltrisiloxane were added, and the mixture was stirred at 70°C for 2 hours. Thereafter, the mixture was purified to give 2.2 g of a compound having terminal silanol groups (102). Compound (101) and compound (102) were dissolved in toluene and stirred at room temperature overnight, pyridine was added, and the mixture was further stirred for 1 hour. Thereafter, the mixture was subjected to purification by liquid separation and silica gel column purification to give 0.401 g of compound (5).
¹H-NMR (CDCl₃, 400 MHz) δ [ppm]: 0.359 - 0.477 (m), 0.790 - 0.830 (m), 1.251 - 1.439 (m), 1.578 - 1.632 (t), 2.277 - 2.315 (t), 3.659 (s)

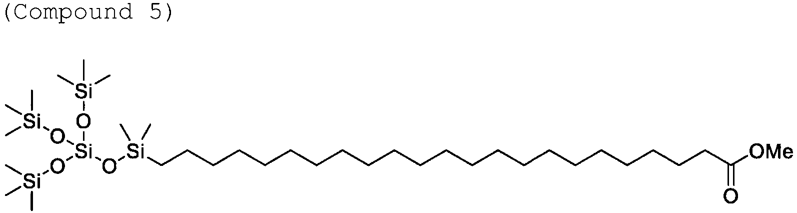

### (Synthetic Example 6)

First, 0.401 g of compound (5) obtained in Synthetic Example 5, 0.085 g of 1,5,7-triazabicyclo[4.4.0]dec-5-ene, and 1.55 g of allylamine were each added, and the mixture was then stirred at 75°C for 4 hours. Thereafter, the mixture was diluted with diethyl ether and washed with an aqueous hydrochloric acid solution. Subsequently, the mixture was dehydrated over magnesium sulfate and concentrated under reduced pressure to give 0.374 g of compound (6).
¹H-NMR (CDCl₃, 400 MHz) δ [ppm]: 0.057 - 0.269 (m), 0.512 - 0.552 (m), 1.150 - 1.431 (m), 1.599 - 1.672 (m), 2.173 - 2.211 (m), 3.889 (s), 5.115 - 5.125 (m), 5.482 (bs), 5.792 - 5.889 (m)

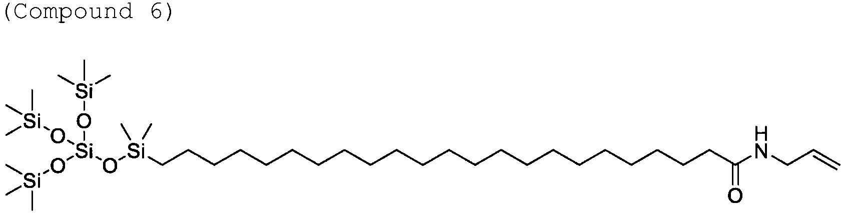

### (Compound 7)

First, 0.374 g of compound (6) obtained in Synthetic Example 6, 3.6 mL of toluene, 13.5 µL of aniline, and 28 µL of a xylene solution containing a 2% Pt complex of 1,3-divinyl-1,1,3,3-tetramethyldisiloxane were each added, then 0.13 mL of trimethoxysilane was added, and the mixture was stirred at 45°C for 4 hours. Thereafter, the mixture was purified to give 0.384 g of the following compound having a terminal trimethoxysilyl group (7).
¹H-NMR (CDCl₃, 400 MHz) δ [ppm]: 0.010 - 0.209 (m), 0.450 - 0.560 (m), 0.628 - 0.668 (m), 1.180 - 1.367 (m), 1.581 - 1.674 (m), 2.123 - 2.162 (t), 3.220 - 3.269 (q), 3.561 - 3.618 (m), 5.636 (bs)

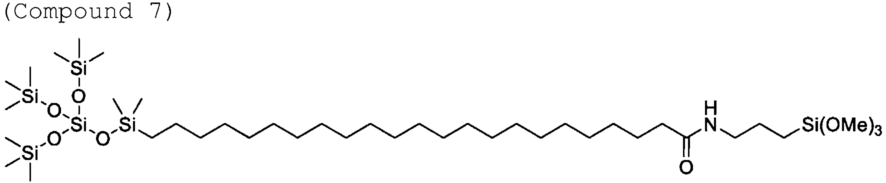

### (Surface-treating agent 2)

Compound 7 obtained above was diluted so as to be a 20 wt% ethanol solution, and thus a surface-treating agent 2 was obtained.

### (Compound 8)

A flask was charged with tris(trimethylsilyloxy)silane (0.7 g), 18-octadecen-1-ol (1.0 g), tris(pentafluorophenyl)borane (0.24 g), and toluene (10 mL), and the solution was heated in an oil bath (set at 70°C) for 2 hours while being stirred with a magnetic stirrer. Thereafter, the reaction solution was subjected to filtration through a silica gel column, and the filtrate was concentrated to give 1.2 g of a terminal olefin compound (8) as a colorless oil.
¹H-NMR (400 MHz, chloroform-D) δ 5.87 - 5.76 (m, 1H), 5.02 - 4.91 (m, 2H), 3.64 (t, J=6.6 Hz, 2H), 2.07 - 2.01 (m, 2H), 1.55 - 1.50 (m, 2H), 1.41 - 1.26 (m, 26H), 0.15 - 0.07 (m, 18H), 0.03 (s, 3H)

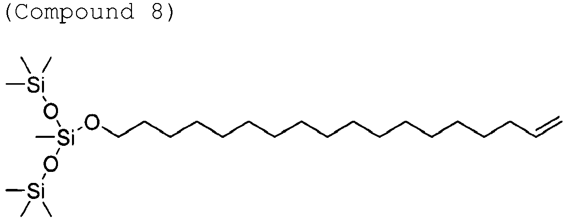

### (Synthetic Example 9)

A flask was charged with the terminal olefin compound (8) (1.0 g) obtained in Synthetic Example 8, Karstedt's catalyst (0.13 g, a xylene solution containing platinum in an amount of 2%), trimethoxysilane (0.75 g), pyridine (22 mg), and toluene (10 mL) and the mixture was stirred at room temperature for 4 hours and then concentrated under reduced pressure to give 1.09 g of compound (9) as a slightly yellow oil.
¹H-NMR (400 MHz, chloroform-D) δ 3.74 - 3.53 (m, 11H), 1.56 - 1.50 (m, 2H), 1.43 - 1.25 (m, 30H), 0.67 - 0.62 (m, 2H), 0.26 - 0.07 (m, 18H), 0.04 (q, J=4.4 Hz, 3H)

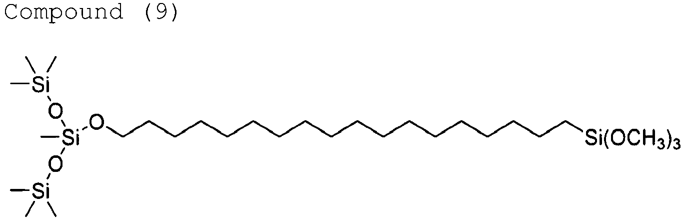

### (Surface-treating agent 3)

Compound 9 obtained above was diluted so as to be a 20 wt% ethanol solution, and thus a surface-treating agent 3 was obtained.

### (Synthetic Example 10)

First, 1.54 g of methyl 10-undecenoate, 38.8 mL of toluene, 0.25 mL of pyridine, and 1.77 mL of a xylene solution containing a 2% Pt complex of 1,3-divinyl-1,1,3,3-tetramethyldisiloxane were each added, and then 6.32 mL of 1,1,1,3,5,5,5-heptamethyltrisiloxane was added dropwise. After being stirred at room temperature for 2 hours, the mixture was purified to give 3.2 g of the following compound (10).
¹H-NMR (CDCl₃, 400 MHz) δ [ppm]: 0.033 - 0.241 (m), 0.438 - 0.550 (m), 1.191 - 1.413 (m), 1.607 - 1.642 (m), 2.242 - 2.325 (m), 3.669 (s)

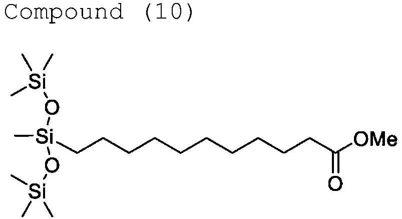

### (Synthetic Example 11)

First, 0.7 g of compound (10) obtained in Synthetic Example 10, 0.81 g of 2-allylpent-4-en-1-amine, and 0.23 g of 1,5,7-triazabicyclo[4.4.0]dec-5-ene were each added, and the mixture was then stirred at 75°C for 3 hours. Thereafter, the mixture was washed with an aqueous hydrochloric acid solution, dehydrated over magnesium sulfate, and concentrated under reduced pressure to give 0.32 g of compound (11).
¹H-NMR (CDCl₃, 400 MHz) δ [ppm]: 0.076 - 0.128 (m), 0.413 - 0.465 (t), 1.183 - 1.1.404 (m), 1.604 - 1.677 (m), 1.704 - 1.769 (m), 1.994 - 2.093 (m), 2.103 - 2.285 (m), 3.161 - 3.328 (t), 4.997 - 5.195 (m), 5.397 - 5.595 (s), 5.708 - 5.975 (m)

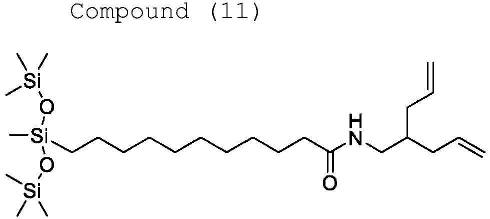

### (Synthetic Example 12)

First, 0.3 g of compound (11) obtained in Synthetic Example 11, 3 mL of toluene, 0.012 mL of pyridine, and 0.086 mL of a xylene solution containing a 2% Pt complex of 1,3-divinyl-1,1,3,3-tetramethyldisiloxane were each added, then 0.45 mL of trimethoxysilane was added, and the mixture was stirred at room temperature for 3 hours. Thereafter, the mixture was purified to give 0.44 g of the following compound having a terminal trimethoxysilyl group (12).
¹H-NMR (CDCl₃, 400 MHz) δ [ppm]: 0.054 - 0.149 (m), 0.425 - 0.464 (t), 0.628 - 0.681 (t), 1.181 - 1.402 (m), 1.544 - 1.768 (m), 2.125 - 2.164 (t), 3.135 - 3.203 (t), 3.558 - 3.646 (m), 5.449 - 5.528 (s)

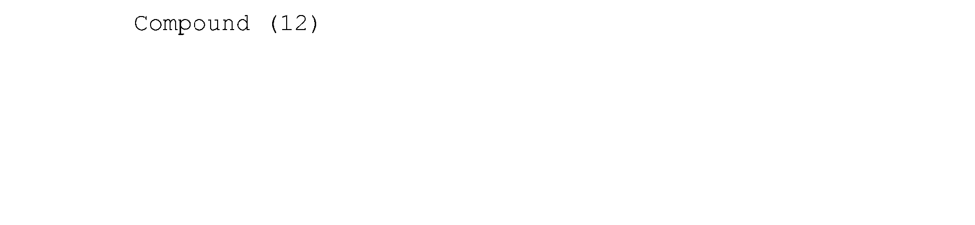

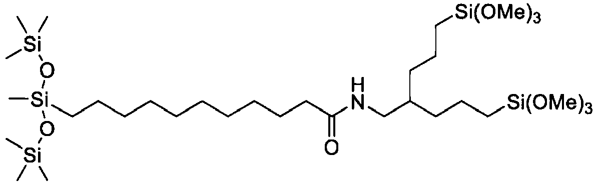

### (Surface-treating agent 4)

Compound 12 obtained above was diluted so as to be a 20 wt% ethanol solution, and thus a surface-treating agent 4 was obtained.

### (Synthetic Example 13)

First, 1.8 g of compound (2) obtained in Synthetic Example 2, 2.01 mL of 2-allylpent-4-en-1-amine, and 0.43 g of 1,5,7-triazabicyclo[4.4.0]dec-5-ene were each added, and the mixture was then stirred at 75°C for 3 hours. Thereafter, the mixture was washed with an aqueous hydrochloric acid solution, dehydrated over magnesium sulfate, and concentrated under reduced pressure to give 1.92 g of compound (13).
¹H-NMR (CDCl₃, 400 MHz) δ [ppm]: 0.076 - 0.128 (m), 0.413 - 0.465 (t), 1.183 - 1.1.404 (m), 1.604 - 1.677 (m), 1.704 - 1.769 (m), 1.994 - 2.093 (m), 2.103 - 2.285 (m), 3.161 - 3.328 (t), 4.997 - 5.195 (m), 5.397 - 5.595 (s), 5.708 - 5.975 (m)

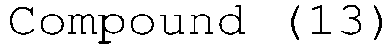

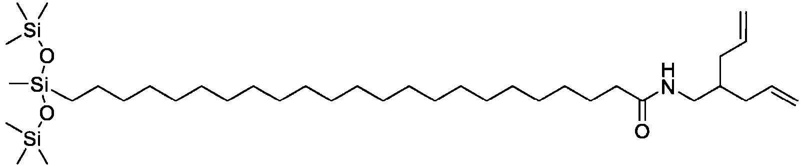

### (Synthetic Example 14)

First, 0.47 g of compound (13) obtained in Synthetic Example 13, 3.5 mL of toluene, 0.014 mL of pyridine, and 0.1 mL of a xylene solution containing a 2% Pt complex of 1,3-divinyl-1,1,3,3-tetramethyldisiloxane were each added, then 0.52 mL of trimethoxysilane was added, and the mixture was stirred at room temperature for 3 hours. Thereafter, the mixture was purified to give 0.48 g of the following compound having a terminal trimethoxysilyl group (14).
¹H-NMR (CDCl₃, 400 MHz) δ [ppm]: 0.054 - 0.149 (m), 0.425 - 0.464 (t), 0.628 - 0.681 (t), 1.181 - 1.402 (m), 1.544 - 1.768 (m), 2.125 - 2.164 (t), 3.135 - 3.203 (t), 3.558 - 3.646 (m), 5.449 - 5.528 (s)

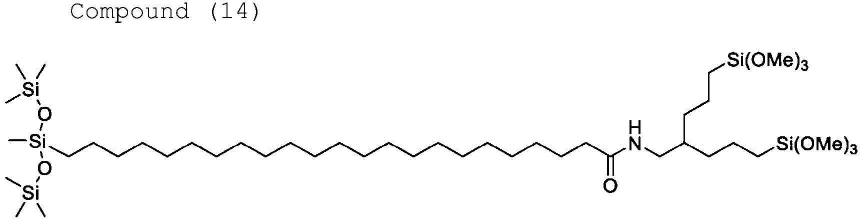

### (Surface-treating agent 5)

Compound 14 obtained above was diluted so as to be a 20 wt% ethanol solution, and thus a surface-treating agent 5 was obtained.

### (Surface-treating agent A)

(CH₃)₃Si-O-(CH₂)₁₀-Si(OCH₃)₃ was diluted so as to be a 20 wt% ethanol solution, and thus a surface-treating agent A was obtained.

### (Synthetic Example 15)

Tricosanoic acid (2.16 g), allylamine (1.47 g), 1-(3-dimethylaminopropyl)-3-ethylcarbodiimide hydrochloride (1.85 g), 4-dimethylaminopyridine (83.2 mg), and dichloromethane (21.6 g) were mixed, and the mixture was stirred at room temperature overnight. The mixture was diluted with dichloromethane, washed with hydrochloric acid and water, and then concentrated under reduced pressure to give CH₃(CH₂)₂₁CONHCH₂CH=CH₂ (1.39 g).
¹H-NMR (CDCl₃, 400 MHz) δ [ppm]: 0.86 - 0.90 (m), 1.25 - 1.29 (m), 1.62 - 1.67 (m), 2.17 - 2.21 (m), 3.87 - 3.91 (m) 3.87 - 3.91 (m), 5.12 - 5.21 (m), 5.44 (m), 5.79 - 5.89 (m)

### (Synthetic Example 16)

First, 1.0 g of CH₃(CH₂)₂₁CONHCH₂CH=CH₂ obtained in Synthetic Example 15, 3.0 g of toluene, 0.1 mL of pyridine, and a xylene solution of Karstedt's catalyst (2%, 0.3 mL) were each added, then 1.0 mL of trimethoxysilane was added, and the mixture was stirred at room temperature overnight. Thereafter, the mixture was purified to give 1.10 g of compound (16) having a terminal trimethoxysilyl group CH₃(CH₂)₂₁CONHCH₂CH₂CH₂Si(OCH₃)₃.
¹H-NMR (CDCl₃, 400 MHz) δ [ppm]: 0.014 - 0.146 (m), 0.49 - 0.59 (m), 0.63 - 0.69 (m), 0.86 - 0.95 (m), 1.16 - 1.40 (m), 1.47 - 1.67 (m), 2.12 - 2.17 (m), 3.19 - 3.27 (m), 3.57 - 3.64 (m)

### (Surface-treating agent 6)

A mixture of compound 4 and compound 16 in a weight ratio of 95:5 was diluted so as to be a 20 wt% heptane solution, and thus a surface-treating agent 6 was obtained.

### (Surface-treating agent 7)

A mixture of compound 4 and compound 16 in a weight ratio of 90:10 was diluted so as to be a 20 wt% heptane solution, and thus a surface-treating agent 7 was obtained.

### (Surface-treating agent 8)

A mixture of compound 4 and compound 16 in a weight ratio of 80:20 was diluted so as to be a 20 wt% heptane solution, and thus a surface-treating agent 8 was obtained.

### (Synthetic Example 17)

Tricosanoic acid (2.16 g), diallylamine (1.47 g), 1-(3-dimethylaminopropyl)-3-ethylcarbodiimide hydrochloride (1.85 g), 4-dimethylaminopyridine (83.2 mg), and dichloromethane (21.6 g) were mixed, and the mixture was stirred at room temperature overnight. The mixture was diluted with dichloromethane, washed with hydrochloric acid and water, and then concentrated under reduced pressure to give CH₃(CH₂)₂₁CON(CH₂CH=CH₂)₂ (1.39 g).
¹H-NMR (CDCl₃, 400 MHz) δ [ppm]: 0.86 - 0.90 (m), 1.25 - 1.29 (m), 1.62 - 1.67 (m), 2.
17 - 2.21 (m), 3.87 - 3.91 (m), 5.12 - 5.21 (m), 5.44 (m), 5.79 - 5.89 (m)

### (Synthetic Example 18)

CH₃(CH₂)₂₁-CON(CH₂CH=CH₂)₂ (2.1 g) obtained in Synthetic Example 17, toluene (20 mL), a xylene solution of Karstedt's catalyst (2%, 1.8 mL), aniline (0.3 g), and trimethoxysilane (6.3 mL) were mixed, and the mixture was stirred at room temperature overnight and then concentrated under reduced pressure to give 2.2 g of compound (18): CH₃(CH₂)₂₁-CON{CH₂CH₂CH₂Si(OCH₃)₃}₂.
¹H-NMR (CDCl₃, 400 MHz) δ [ppm]: 0.83 - 0.92 (m), 1.22 - 26 (m), 1.56 - 1.65 (m), 2.20 - 2.26 (m), 3.15 - 3.27 (m), 3.53 - 3.67 (m)

### (Surface-treating agent 9)

A mixture of compound 14 and compound 18 in a weight ratio of 80:20 was diluted so as to be a 20 wt% heptane solution, and thus a surface-treating agent 9 was obtained.

### (Synthetic Example 19)

A glass flask was charged with a stirrer tip, 2.0 g of 16-hydroxyhexadecanoic acid, 3.6 g of potassium carbonate, 1.5 g of methyl iodide, and 10 mL of dimethyl sulfoxide and immersed in an oil bath at 60°C, and the mixture was stirred with a magnetic stirrer for 18 hours. Thereafter, toluene and water were added to the flask, the mixture was stirred, the liquid in the flask was transferred to a separatory funnel and allowed to stand still for separation, and the lower layer (the aqueous layer) was removed. Toluene and water were similarly added, the organic layer was washed twice with water, dried over magnesium sulfate, and then concentrated under reduced pressure to give 1.9 g of methyl 16-hydroxyhexadecanoate as a colorless oil.
¹H-NMR (400 MHz, chloroform-D) δ 3.66 - 3.62 (m, 5H), 2.36 - 2.28 (m, 2H), 1.65 - 1.53 (m, 4H), 1.33 - 1.25 (m, 22H)

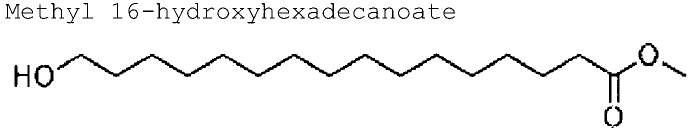

### (Synthetic Example 20)

A glass flask was charged with a stirrer tip, 0.93 g of methyl 16-hydroxyhexadecanoate obtained in Synthetic Example 19, 0.46 g of 1,5,7-triazabicyclo[4.4.0]dec-5-ene, and 2.5 mL of allylamine, and the mixture was stirred at room temperature for 2 hours with a magnetic stirrer. Thereafter, chloroform and an aqueous hydrochloric acid solution were added to the flask, the mixture was stirred, the liquid in the flask was transferred to a separatory funnel and allowed to stand still for separation, and the upper layer (the aqueous layer) was removed. Chloroform and an aqueous hydrochloric acid solution were similarly added, the organic layer was washed twice with water, dried over magnesium sulfate, and then concentrated under reduced pressure to give 0.88 g of N-allyl-16-hydroxyhexadecanamide as a white solid.
¹H-NMR (400 MHz, chloroform-D) δ 5.89 - 5.79 (m, 1H), 5.49 (s, 1H), 5.20 - 5.12 (m, 2H), 3.89 (td, J=5.7, 1.4 Hz, 2H), 3.64 (dd, J=12.1, 5.3 Hz, 2H), 2.21 - 2.17 (m, 2H), 1.65 - 1.53 (m, 4H), 1.40 - 1.25 (m, 22H)

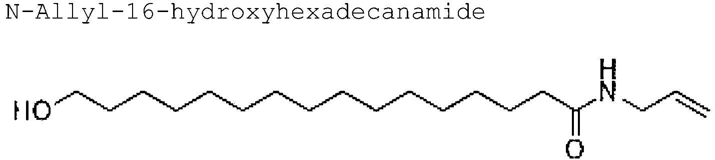

### (Synthetic Example 21)

A glass flask was charged with a stirrer tip, 0.77 g of N-allyl-16-hydroxyhexadecanamide obtained in Synthetic Example 20, 0.5 g of 1,1,1,3,5,5,5-heptamethyltrisiloxane, 0.11 g of tris(pentafluorophenyl)borane, and 14 mL of toluene, and immersed in an oil bath at 70°C, and the mixture was stirred with a magnetic stirrer for 2 hours. Then, 5 g of silica gel was added to the flask, the mixture was stirred at room temperature and then subjected to filtration, the filtrate was concentrated under reduced pressure to give 0.86 g of compound (21) as a white solid.
¹H-NMR (400 MHz, chloroform-D) δ 5.89 - 5.79 (m, 1H), 5.45 (s, 1H), 5.21 - 5.12 (m, 2H), 3.89 (tt, J=5.7, 1.4 Hz, 2H), 3.65 (q, J=6.9 Hz, 2H), 2.18 (q, J=7.3 Hz, 2H), 1.67 - 1.50 (m, 4H), 1.29 - 1.25 (m, 22H), 0.16 - 0.09 (m, 18H), 0.03 (s, 3H)

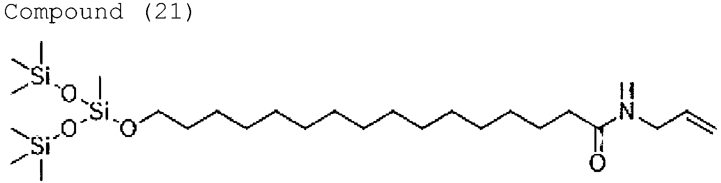

### (Synthetic Example 22)

A glass flask was charged with a stirrer tip, 0.86 g of compound (21) obtained in Synthetic Example 21, 0.1 mL of a xylene solution containing a 2% Pt complex of 1,3-divinyl-1,1,3,3-tetramethyldisiloxane, 14 µL of pyridine, 0.50 mL of trimethoxysilane, and 10 mL of toluene, and the mixture was stirred at room temperature for 4 hours with a magnetic stirrer. Thereafter, the mixture was concentrated under reduced pressure to give 0.94 g of compound (22) as a light yellow oil.
¹H-NMR (400 MHz, chloroform-D) δ 5.62 (s, 1H), 3.65 - 3.54 (m, 11H), 3.25 (q, J=6.7 Hz, 2H), 2.20 - 2.12 (m, 2H), 1.68 - 1.50 (m, 6H), 1.27 (d, J=12.8 Hz, 22H), 0.67 - 0.63 (m, 2H), 0.15 - 0.07 (m, 18H), 0.01 (s, 3H)

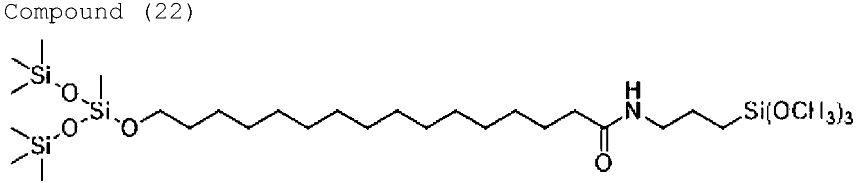

### (Surface-treating agent 10)

Compound (22) obtained above was diluted so as to be a 20 wt% ethanol solution, and thus a surface-treating agent 10 was obtained.

### (Synthetic Example 23)

First, 1.00 g of 16-heptadecenoic acid, 11.2 mL of toluene, and 7.50 mL of methanol were each added, then 7.60 mL of trimethylsilyldiazomethane was added dropwise, and the mixture was stirred at room temperature for 1 hour. Thereafter, the mixture was concentrated under reduced pressure to give 1.15 g of compound (23).
¹H-NMR (CDCl₃, 400 MHz) δ [ppm]: 1.252 - 1.371 (m), 1.597 - 1.615 (m), 2.010 - 2.061 (m), 2.279 - 2.316 (t), 3.662 (s), 4.910 - 5.012 (dd), 5.777 - 5.846 (m)°

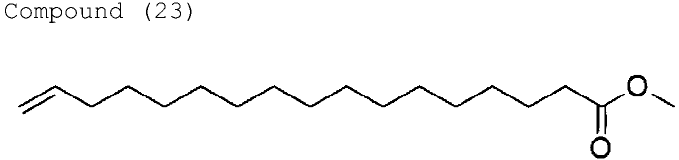

### (Synthetic Example 24)

First, 1.06 g of compound (23) obtained in Synthetic Example 23, 18.8 mL of toluene, 0.12 mL of pyridine, and 0.43 mL of a xylene solution containing a 2% Pt complex of 1,3-divinyl-1,1,3,3-tetramethyldisiloxane were each added, then 3.06 mL of 1,1,1,3,5,5,5-heptamethyltrisiloxane was added dropwise, and the mixture was stirred at room temperature for 6 hours. Thereafter, the mixture was concentrated under reduced pressure to give 2.07 g of compound (24).
¹H-NMR (CDCl₃, 400 MHz) δ [ppm]: -0.001 - 0.130 (m), 0.434 - 0.472 (m), 1.176 - 1.288 (m), 1.582 - 1.640 (m), 2.269 - 2.323 (m), 3.670 (s)°

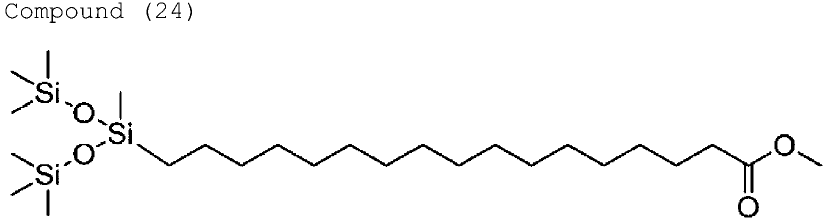

### (Synthetic Example 25)

First, 0.80 g of compound (24) obtained in Synthetic Example 24, 5.96 mL of allylamine, and 0.22 g of 1,5,7-triazabicyclo[4.4.0]dec-5-ene were each added, and the mixture was then stirred at 75°C for 3 hours. Thereafter, the mixture was washed with an aqueous hydrochloric acid solution, dehydrated over magnesium sulfate, and concentrated under reduced pressure to give 0.62 g of compound (25).
¹H-NMR (CDCl₃, 400 MHz) δ [ppm]: -0.012 - 0.123 (m), 0.423 - 0.461 (m), 1.250 - 1.289 (m), 1.615 - 1.660 (m), 2.166 - 2.204 (t), 3.122 - 2.228 (m), 3.876 - 3.902 (m), 5.108 - 5.202 (m), 5.778 - 5.886 (m)°

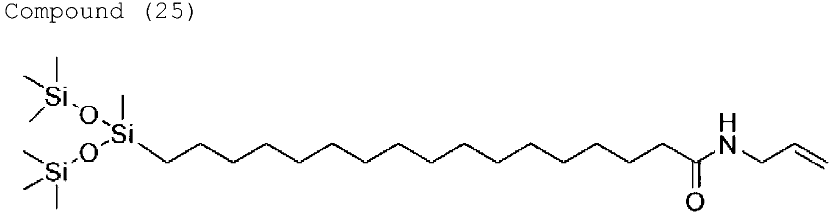

### (Synthetic Example 26)

First, 0.5 g of compound (25) obtained in Synthetic Example 25, 2.0 mL of toluene, 0.054 mL of a xylene solution containing a 2% Pt complex of 1,3-divinyl-1,1,3,3-tetramethyldisiloxane, and 0.026 mL of aniline were each added, then 0.24 mL of trimethoxysilane was added, and the mixture was stirred at 45°C for 2 hours. Thereafter, the mixture was purified to give 0.46 g of the following compound having a terminal trimethoxysilyl group (26).
¹H-NMR (CDCl₃, 400 MHz) δ [ppm]: -0.064 - 0.0.231 (m), 0.446 (t), 0.652 (t), 1.109 - 1.404 (m), 1.529 - 1.676 (m), 2.148 (t), 3.249 (q), 3.493 - 3.667 (m), 5.630 (br)

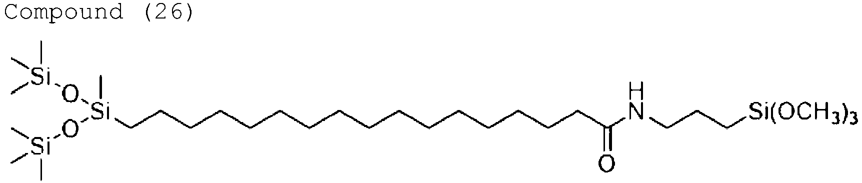

### (Surface-treating agent 11)

Compound (26) obtained above was diluted so as to be a 20 wt% ethanol solution, and thus a surface-treating agent 11 was obtained.

### (Synthetic Example 27)

First, 1.00 g of compound (24) obtained in the same manner as Synthetic Example 24, 2.41 mL of 2-allylpent-4-en-1-amine, and 0.28 g of 1,5,7-triazabicyclo[4.4.0]dec-5-ene were each added, and the mixture was then stirred at 75°C for 3 hours. Thereafter, the mixture was washed with an aqueous hydrochloric acid solution, dehydrated over magnesium sulfate, and concentrated under reduced pressure to give 1.03 g of compound (27).
¹H-NMR (CDCl₃, 400 MHz) δ [ppm]: -0.012 - 0.123 (m), 0.423 - 0.561 (m), 1.178 - 1.279 (m), 1.610 - 1.629 (m), 1.716 - 1.749 (m), 2.042 - 2.352 (m), 3.122 - 2.228 (m), 3.663 - 3.744 (m), 5.031 - 5.157 (m), 5.734 - 5.838 (m)°

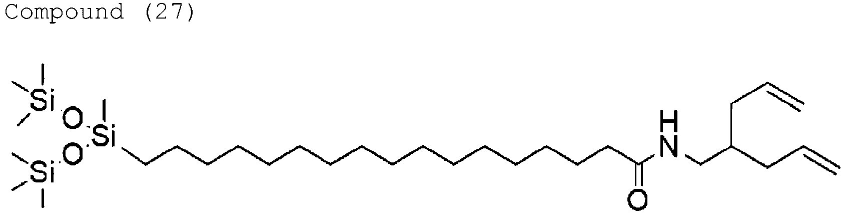

### (Synthetic Example 28)

First, 0.82 g of compound (27) obtained in Synthetic Example 27, 2.0 mL of toluene, 0.078 mL of a xylene solution containing a 2% Pt complex of 1,3-divinyl-1,1,3,3-tetramethyldisiloxane, and 0.038 mL of aniline were each added, then 0.70 mL of trimethoxysilane was added, and the mixture was stirred at 45°C for 2 hours. Thereafter, the mixture was purified to give 1.08 g of the following compound having a terminal trimethoxysilyl group (28).
¹H-NMR (CDCl₃, 400 MHz) δ [ppm]: -0.001 - 0.166 (m), 0.453 (t), 0.635 (t), 1.190 - 1.327 (m), 1.398 - 1.546 (m), 1.627 (quin), 2.159 (t), 3.189 (t), 3.489 - 3.685 (m), 5.510 (t)

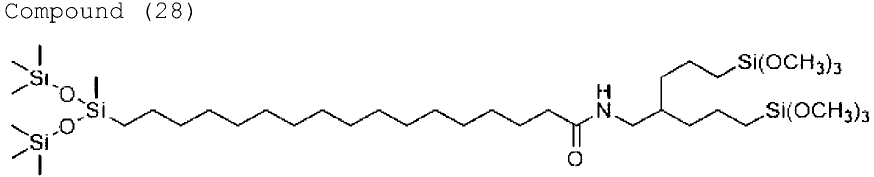

### (Surface-treating agent 12)

Compound (28) obtained above was diluted so as to be a 20 wt% ethanol solution, and thus a surface-treating agent 12 was obtained.

### (Synthetic Example 29)

First, 2.4 ml of 9-decen-1-ol, 2.7 ml of toluene, and 0.05 ml of a xylene solution containing a 2% Pt complex of 1,3-divinyl-1,1,3,3-tetramethyldisiloxane were added, the mixture was stirred, 3.8 ml of 1,1,1,3,5,5,5-heptamethyltrisiloxane was added dropwise thereto, and the mixture was stirred at room temperature for 1 hour. Thereafter, volatile components were distilled off by being heated under reduced pressure to give 4.1 g of the following trisiloxane-containing alcohol compound (29).
¹H-NMR (CDCl₃, 400 MHz) δ [ppm]: -0.067 - 0.157 (m), 0.425 - 0.463 (t), 1.200 - 1.400 (m), 1.443 (s), 1.528 - 1.598 (m), 3.615 - 3.648 (t)

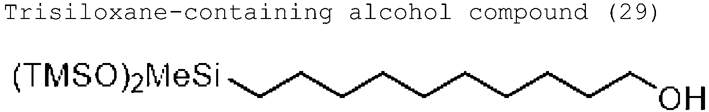

### (Synthetic Example 30)

First, 0.5 g of the trisiloxane-containing alcohol compound (29) and 3.0 ml of toluene were added, the mixture was stirred, and 0.42 ml of 10-undecenoyl chloride was added dropwise. After being stirred at room temperature for 1 hour, the mixture was purified to give 0.5 g of the following trisiloxane-containing ester compound (30).
¹H-NMR (CDCl₃, 400 MHz) δ [ppm]: -0.067 - 0.200 (m), 0.425 - 0.464 (t), 1.200 - 1.500 (m), 1.575 - 1.645 (m), 2.002 - 2.058 (q), 2.264 - 2.301 (t), 4.034 - 4.068 (t), 4.903 - 5.012 (m), 5.750 - 5.850 (m)

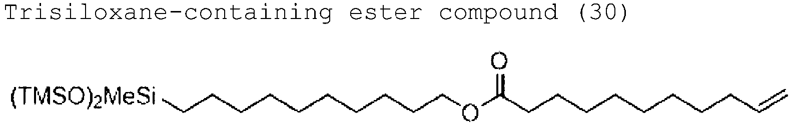

### (Synthetic Example 31)

First, 0.4 g of trisiloxane-containing ester compound (30), 2.0 ml of toluene, 0.04 ml of a xylene solution containing a 2% Pt complex of 1,3-divinyl-1,1,3,3-tetramethyldisiloxane, and 0.2 ml of aniline were added, the mixture was stirred, 0.19 ml of trimethoxysilane was added dropwise, and then the mixture was stirred at room temperature for 1 hour. Thereafter, volatile components were distilled off under reduced pressure, the mixture was purified, and thus 0.43 g of the following trisiloxane-containing trimethoxysilane compound (31) was obtained.
¹H-NMR (CDCl₃, 400 MHz) δ [ppm]: -0.072 - 0.200 (m), 0.419 - 0.457 (t), 0.615 - 0.656 (m), 1.200 - 1.500 (m), 1.571 - 1.639 (m), 2.258 - 2.296 (t), 3.510 - 3.629 (m), 4.028 - 4.062 (t)

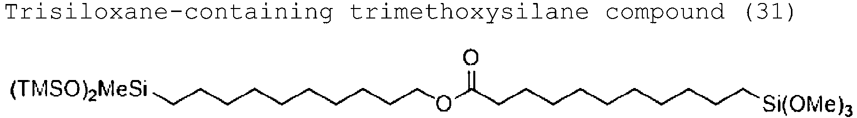

### (Synthetic Example 32)

First, 0.20 g of 4-allylhepta-1,6-dien-4-ol, 1.0 ml of toluene, and 0.05 ml of a xylene solution containing a 2% Pt complex of 1,3-divinyl-1,1,3,3-tetramethyldisiloxane were added, the mixture was stirred, 1.22 ml of 1,1,1,3,5,5,5-heptamethyltrisiloxane was added dropwise, and then the mixture was stirred at room temperature overnight. Thereafter, volatile components were distilled off under reduced pressure, and the mixture was purified to give 0.63 g of the following trisiloxane-containing alcohol compound (32).
¹H-NMR (CDCl₃, 400 MHz) δ [ppm]: -0.062 - 0.200 (m), 0.422 - 0.462 (t), 1.257 - 1.367 (m), 1.411 - 1.452 (m)

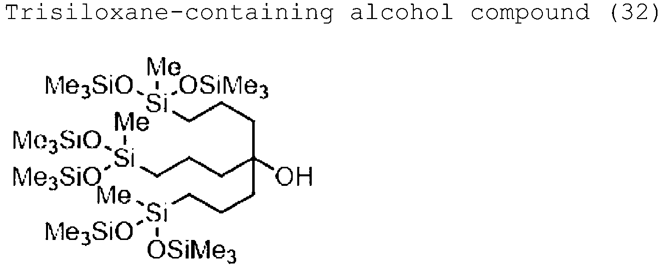

### (Synthetic Example 33)

First, 0.56 g of trisiloxane-containing alcohol compound (32) and 2.0 ml of toluene were added, the mixture was stirred, and 0.22 ml of 10-undecenoyl chloride was added dropwise. After being stirred at room temperature for 1 hour, the mixture was purified to give 0.52 g of the following trisiloxane-containing ester compound (33).
¹H-NMR (CDCl₃, 400 MHz) δ [ppm]: -0.066 - 0.237 (m), 0.423 - 0.463 (t), 1.200 - 1.680 (m), 1.714 - 1.756 (m), 1.925 - 2.062 (m), 4.916 - 5.011 (m), 5.757 - 5.858 (m)

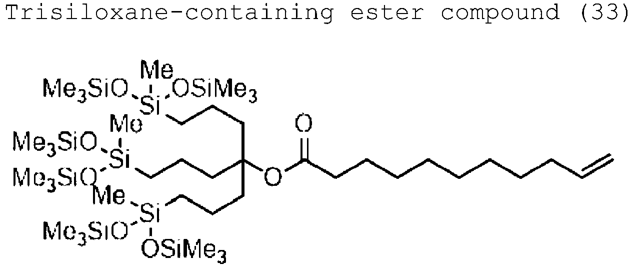

### (Synthetic Example 34)

First, 0.52 g of trisiloxane-containing ester compound (33), 4.0 ml of toluene, 0.02 ml of a xylene solution containing a 2% Pt complex of 1,3-divinyl-1,1,3,3-tetramethyldisiloxane, and 0.02 ml of aniline were added, the mixture was stirred, 0.13 ml of trimethoxysilane was added dropwise, and then the mixture was stirred at room temperature for 1 hour. Thereafter, volatile components were distilled off under reduced pressure, and the mixture was purified to give 0.54 g of the following trisiloxane-containing trimethoxysilane compound (34).
¹H-NMR (CDCl₃, 400 MHz) δ [ppm]: -0.200 - 0.300 (m), 0.300 - 0.550 (m), 0.600 - 0.670 (m), 1.100 - 2.100 (m), 3.300 - 3.770 (m)

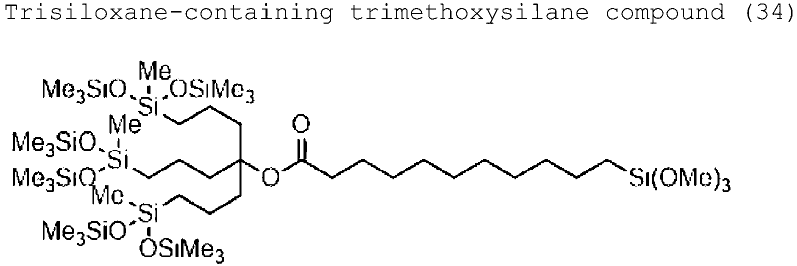

### (Surface-treating agent 13)

A mixture of compound 4 and compound 14 in a weight ratio of 50:50 was diluted so as to be a 20 wt% heptane solution, and thus a surface-treating agent 13 was obtained.

### (Surface-treating agent 14)

A mixture of compound 4 and compound 14 in a weight ratio of 30:70 was diluted so as to be a 20 wt% heptane solution, and thus a surface-treating agent 14 was obtained.

### (Na-containing intermediate layer forming material)

First, 2.2 g of sodium hydroxide (manufactured by Fujifilm Wako Pure Chemical Corporation) was dissolved in 24 g of distilled water to give a 8.4% by mass aqueous sodium hydroxide solution. Then, 24 g of this 8.4% by mass aqueous sodium hydroxide solution and 20 g of MS gel (M.S. GEL D-100-60A (manufactured by AGC Si-Tech Co., Ltd.)) were mixed so that the aqueous sodium hydroxide solution was absorbed into the MS gel. The MS gel that had absorbed the aqueous sodium hydroxide solution was dried at 25°C for 8 hours, then molded with a tableting machine (4 MPa for 1 minute), and fired at 1,000°C for 1 hour to give a formed article 1 (pellets).

### (Synthetic Example 35)

First, 1.0 g of trimethoxy(7-octen-1-yl)silane, 3.01 g of 1,1,1,3,5,5,5-heptamethyltrisiloxane, 10 mL of hexane, and 11 mg of tris(pentafluorophenyl)borane were added, and then the mixture was stirred at room temperature for 30 minutes. Thereafter, the mixture was purified to give 3.09 g of the following compound (35).
¹H-NMR (400 MHz, chloroform-D) δ 5.68 - 5.91 (1H), 4.85 - 5.04 (2H), 1.96 - 2.10 (2H), 1.17 - 1.47 (8H), 0.46 - 0.62 (2H), -0.04 - 0.26 (63H)

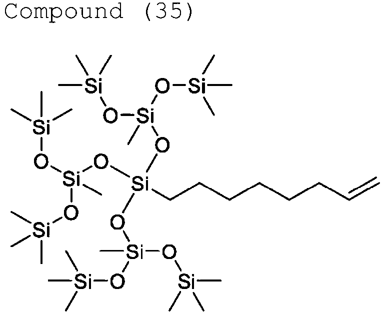

### (Synthetic Example 36)

First, 1.0 g of compound (35), 10 mL of toluene, 12 µL of pyridine, and 90 µL of a xylene solution containing a 2% Pt complex of 1,3-divinyl-1,1,3,3-tetramethyldisiloxane were each added, then 0.45 mL of trimethoxysilane was added, and the mixture was stirred at room temperature for 3 hours. Thereafter, the mixture was purified to give 1.02 g of the following compound having a terminal trimethoxysilyl group (36).
¹H-NMR (400 MHz, chloroform-D) δ 3.59 - 3.54 (m, 9H), 1.39 - 1.27 (m, 12H), 0.65 - 0.61 (m, 2H), 0.53 - 0.49 (m, 2H), 0.12 - 0.06 (m, 54H), 0.05- -0.07 (m, 9H)

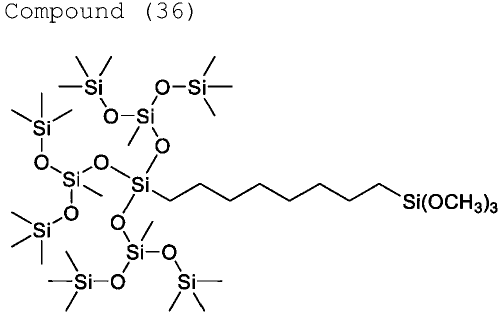

### (Surface-treating agent 15)

Compound (36) obtained above was diluted so as to be a 20 wt% ethanol solution, and thus a surface-treating agent 15 was obtained.

### (Synthetic Example 37)

First, 6.3 g of 1,1,1,3,5,5,5-heptamethyltrisiloxane, 1.9 ml of toluene, and 0.4 ml of a xylene solution containing a 2% Pt complex of 1,3-divinyl-1,1,3,3-tetramethyldisiloxane were added, the mixture was stirred, 1.5 g of 2,2-diallylpent-4-en-1-amine was added dropwise, and the mixture was stirred at 70°C overnight. Thereafter, volatile components were distilled off by being heated under reduced pressure to give 7.4 g of the following trisiloxane-containing amine compound (37).
¹H-NMR (CDCl₃, 400 MHz) δ [ppm]: -0.164 - 0.227 (m), 0.399 (s), 0.870 - 1.621 (m), 2.431 (s)

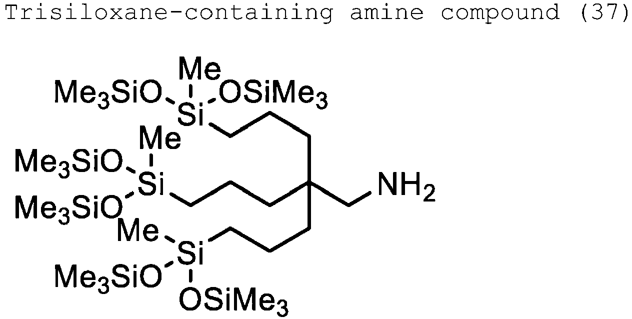

### (Synthetic Example 38)

First, 0.69 g of the trisiloxane-containing amine compound, 7 ml of toluene, and 0.15 ml of triethylamine were added, 10-undecenoyl chloride was added, and the mixture was stirred at room temperature for 1 hour. Thereafter, the mixture was purified to give 0.75 g of the following trisiloxane-containing amide compound (38).
¹H-NMR (CDCl₃, 400 MHz) δ [ppm]: -0.162 - 0.221 (m), 0.367 - 0.403 (t), 1.037 - 1.417 (m), 1.564 - 1.650 (m), 1.990 - 2.044 (q), 2.111 - 2.149 (t), 3.079 - 3.093 (d), 4.898 - 4.998 (m), 5.185 - 5.212 (m), 5.736 - 5.837 (m)

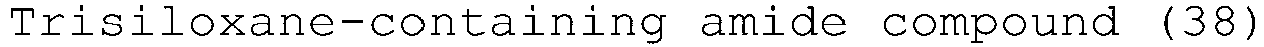

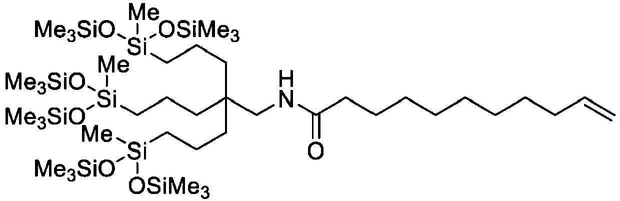

### (Synthetic Example 39)

First, 0.5 g of the trisiloxane-containing amide compound (38), 2.5 ml of toluene, 0.03 ml of a xylene solution containing a 2% Pt complex of 1,3-divinyl-1,1,3,3-tetramethyldisiloxane, and 0.01 ml of aniline were added, the mixture was stirred, 0.13 ml of trimethoxysilane was added dropwise, and then the mixture was stirred at room temperature for 1 hour. Thereafter, volatile components were distilled off under reduced pressure, and the mixture was purified to give 0.56 g of the following trisiloxane-containing trimethoxysilane compound (39).
¹H-NMR (CDCl₃, 400 MHz) δ [ppm]: -0.069 - 0.171 (m), 0.377 - 0.412 (m), 0.602 - 0.655 (m), 1.046 - 1.425 (m), 1.593 - 1.623 (m), 2.118 - 2.157 (t), 3.086 - 3.101 (d), 3.378 - 3.735 (m), 5.196 - 5.223 (t)

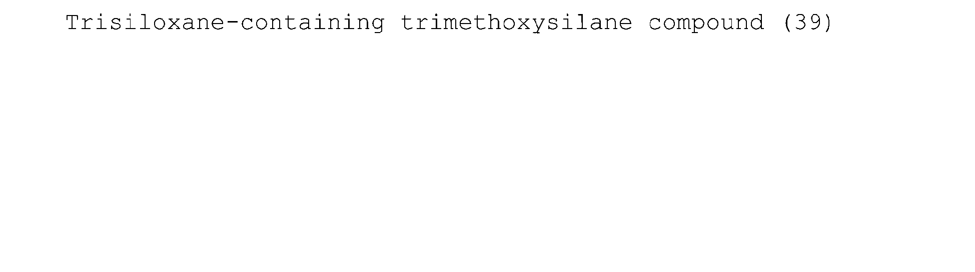

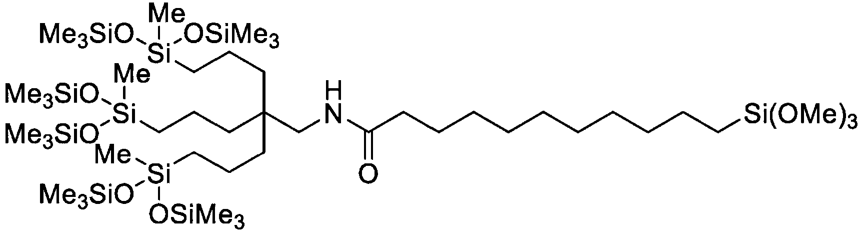

### (Surface-treating agent 16)

Compound (39) obtained above was diluted so as to be a 20 wt% ethanol solution, and thus a surface-treating agent 16 was obtained.

### (Synthetic Example 40)

First, 5 ml of toluene, 0.39 ml of methyl 10-undecenoate, 0.06 ml of pyridine, and 0.2 ml of a xylene solution containing a 2% Pt complex of 1,3-divinyl-1,1,3,3-tetramethyldisiloxane were added, the mixture was stirred, 0.60 g of 1,5-dibutyl-1,1,3,5,5-pentamethyltrisiloxane was added, and the mixture was stirred at 60°C overnight. Thereafter, the mixture was purified to give 0.91 g of the following trisiloxane-containing amide compound (40).
¹H-NMR (CDCl₃, 400 MHz) δ [ppm]: -0.005 - 0.100 (m), 0.866 (s), 0.885 (s), 1.256 - 1.282 (m), 1.581 - 1.633 (m), 2.80 - 2.317 (t), 3.663 (s)

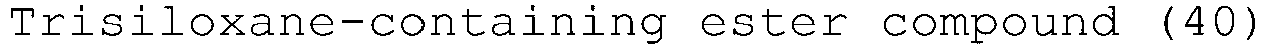

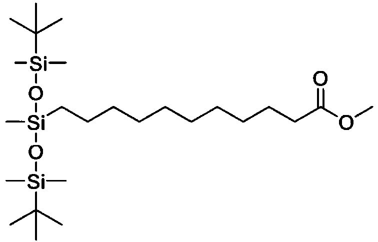

### (Synthetic Example 41)

First, 0.91 g of the trisiloxane-containing ester compound (40), 5 ml of allylamine, and 0.25 g of TBD were added, and the mixture was stirred at 60°C for 2 hours. Thereafter, the mixture was purified to give 0.90 g of the following trisiloxane-containing amide compound (41).
¹H-NMR (CDCl₃, 400 MHz) δ [ppm]: -0.007 - 0.171 (m), 0.434 - 0.473 (m), 0.856 - 0.883 (m), 1.252 - 1.330 (m), 1.598 - 1.671 (m), 2.166 - 2.204 (t), 3.865 - 3.902 (m), 5.112 - 5.198 (m), 5.498 (s), 5.790 - 5.886 (m)

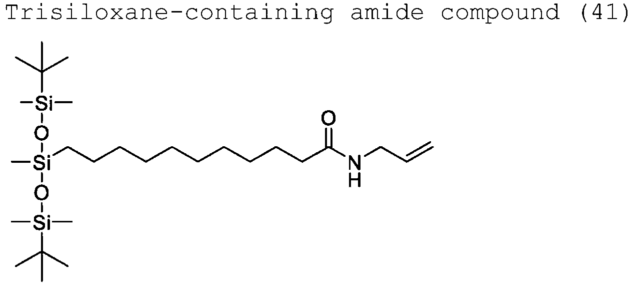

### (Synthetic Example 42)

First, 0.90 g of the trisiloxane-containing amide compound (41), 9.0 ml of toluene, 0.01 ml of a xylene solution containing a 2% Pt complex of 1,3-divinyl-1,1,3,3-tetramethyldisiloxane, and 0.04 ml of aniline were added, the mixture was stirred, 0.43 ml of trimethoxysilane was added dropwise, and then the mixture was stirred at room temperature for 4 hour. Thereafter, volatile components were distilled off under reduced pressure, the mixture was purified, and thus 1.05 g of the following trisiloxane-containing trimethoxysilane compound (42) was obtained.
¹H-NMR (CDCl₃, 400 MHz) δ [ppm]: -0.016 - 0.045 (m), 0.418 - 0.457 (m), 0.609 - 0.650 (m), 0.847 - 0.886 (m), 1.235 - 1.263 (m), 1.563 - 1.650 (m), 2.107 - 2.144 (t), 3.200 - 3.250 (m), 3.552 (s), 5.673 (s)

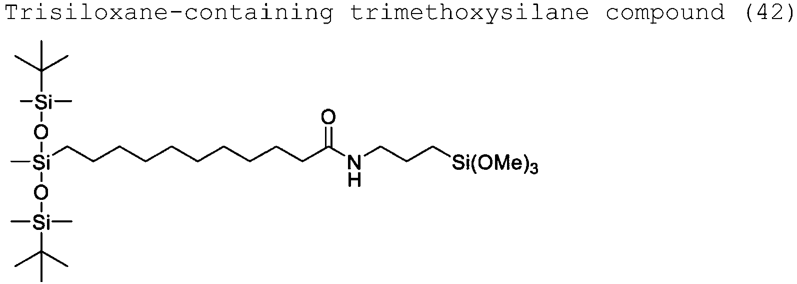

### (Surface-treating agent 17)

Compound (42) obtained above was diluted so as to be a 20 wt% ethanol solution, and thus a surface-treating agent 17 was obtained.

### (Synthetic Example 43)

First, 1.0 g of trimethoxy(7-octen-1-yl)silane, 3.01 g of 1,1,1,3,5,5,5-heptamethyltrisiloxane, 10 mL of hexane, and 11 mg of tris(pentafluorophenyl)borane were added, and then the mixture was stirred at room temperature for 30 minutes. Thereafter, the mixture was purified to give 3.09 g of the following compound (43).
¹H-NMR (400 MHz, chloroform-D) δ 5.68 - 5.91 (1H), 4.85 - 5.04 (2H), 1.96 - 2.10 (2H), 1.17 - 1.47 (8H), 0.46 - 0.62 (2H), -0.04 - 0.26 (63H)

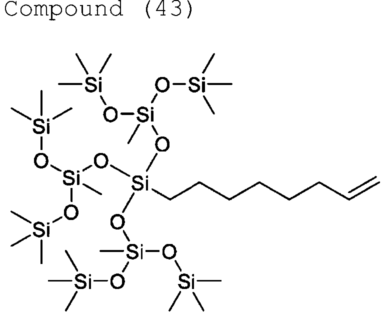

### (Synthetic Example 44)

First, 1.0 g of compound (43), 5.0 mL of toluene, 5.75 µL of triacetoxymethylsilane, and 178 µL of a xylene solution containing a 2% Pt complex of 1,3-divinyl-1,1,3,3-tetramethyldisiloxane were each added, then 0.48 mL of dichloromethylsilane was added, and the mixture was stirred at 40°C for 2 hours. Thereafter, toluene was distilled off, and 10 mL of tetrahydrofuran was added. Then, 2.35 mL of a tetrahydrofuran solution containing 22% allylmagnesium chloride was added dropwise at 0°C, and the mixture was stirred at room temperature for 2 hours. Thereafter, the mixture was purified to give 0.41 g of the following compound (44).
¹H-NMR (400 MHz, chloroform-D) δ 5.61 - 5.92 (2H), 4.72 - 4.90 (4H), 1.46 - 1.58 (4H), 1.16 - 1.45 (12H), 0.45 - 0.58 (4H), 0.06 - 0.14 (63H), -0.07- -0.01 (3H)

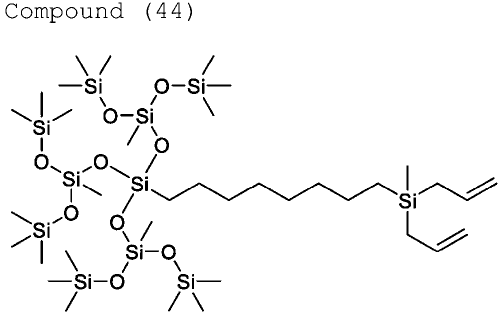

### (Synthetic Example 45)

First, 0.41 g of compound (44), 10 mL of toluene, 9 µL of pyridine, and 63 µL of a xylene solution containing a 2% Pt complex of 1,3-divinyl-1,1,3,3-tetramethyldisiloxane were each added, then 0.32 mL of trimethoxysilane was added, and the mixture was stirred at room temperature for 3 hours. Thereafter, the mixture was purified to give 0.5 g of the following compound having a terminal trimethoxysilyl group (45).
¹H-NMR (400 MHz, chloroform-D) δ 3.48 - 3.66 (18H), 1.17 - 1.50 (16H), 0.66 - 0.76 (4H), 0.41 - 0.63 (8H), -0.03 - 0.16 (63H), -0.13- -0.04 (3H)

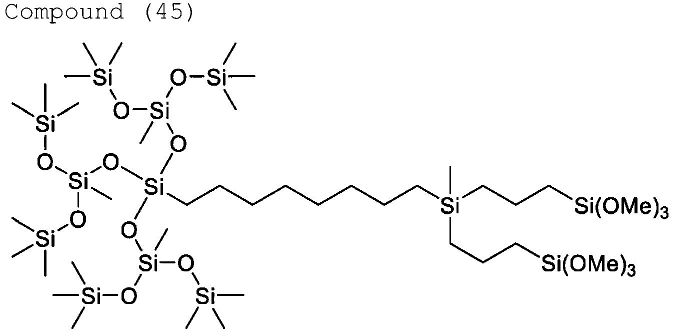

### (Surface-treating agent 18)

Compound (45) obtained above was diluted so as to be a 20 wt% ethanol solution, and thus a surface-treating agent 18 was obtained.

### (Synthetic Example 46)

First, 4.94 g of 18-bromo-1-octadecene: CH₂=CH(CH₂)₁₆Br, 28.5 ml of toluene, 0.01 g of pyridine, 0.66 ml of a xylene solution containing a 2% Pt complex of 1,3-divinyl-1,1,3,3-tetramethyldisiloxane, and 2.85 ml of trimethoxysilane were each added, and the mixture was stirred at room temperature for 6 hours. Thereafter, the mixture was purified to give the following bromine compound (46): (CH₃O)₃Si(CH₂)₁₈Br (4.79 g).
¹H-NMR (CDCl₃, 400 MHz) δ [ppm]: 0.620 - 0.660 (t), 1.247 (brs), 1.363 - 1.433 (m), 1.811 - 1.883 (m), 3.381 - 3.416 (t), 3.561 (s)

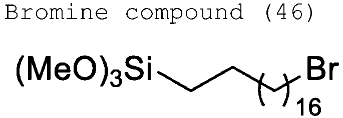

### (Synthetic Example 47)

First, 4.79 g of the bromine compound (46): (CH₃O)₃Si(CH₂)₁₈Br obtained in Synthetic Example 46, 5.5 ml of toluene, 9.17 ml of 1,1,1,3,5,5,5-heptamethyltrisiloxane, and 0.27 g of tris(pentafluorophenyl)borane were each added, and the mixture was stirred at room temperature for 1 hour. Thereafter, the mixture was purified to give the following siloxane compound (47): (((CH₃)₃SiO)₂SiCH₃O)₃Si(CH₂)₁₈Br (10.81 g).
¹H-NMR (CDCl₃, 400 MHz) δ [ppm]: 0.046 (s), 0.101 (s), 0.513 - 0.555 (m), 1.260 (brs), 1.360 - 1.442 (m), 1.819 - 1.891 (m), 3.388 - 3.423 (t)

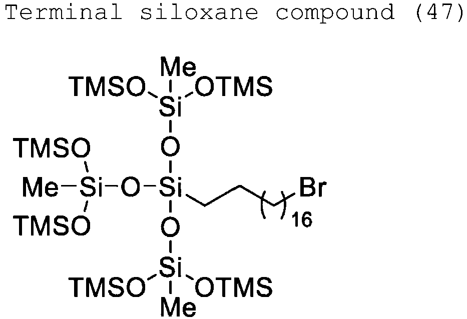

### (Synthetic Example 48)

First, 4.00 g of the siloxane compound (47): (((CH₃)₃SiO)₂SiCH₃O)₃Si(CH₂)₁₈Br obtained in Synthetic Example 47, 5.6 ml of tetrahydrofuran, 0.10 g of magnesium, and 0.02 g of iodine were each added, and the mixture was stirred at 60°C for 3 hours. Subsequently, the gaseous phase was purged with carbon dioxide gas in an ice bath, and the mixture was stirred at room temperature overnight. Thereafter, the mixture was purified to give the following siloxane compound (48): (((CH₃)₃SiO)₂SiCH₃O)₃Si(CH₂)₁₈COOH (1.52 g).
¹H-NMR (CDCl₃, 400 MHz) δ [ppm]: 0.041 (s), 0.097 (s), 0.507 - 0.549 (m), 1.252 (brs), 1.351 - 1.392 (m), 1.594 - 1.668 (m), 2.325 - 2.363 (t)

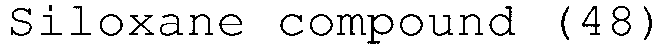

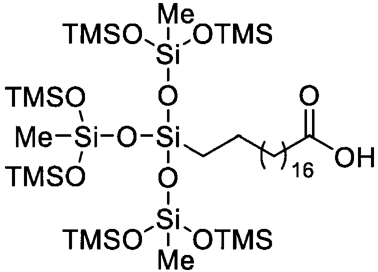

### (Synthetic Example 49)

First, 1.30 g of the siloxane compound (48): (((CH₃)₃SiO)₂SiCH₃O)₃Si(CH₂)₁₈COOH obtained in Synthetic Example 48, 20.0 ml of dichloromethane, 0.03 g of 4-dimethylaminopyridine, and 0.33 g of 1-(3-dimethylaminopropyl)-3-ethylcarbodiimide hydrochloride were each added, 0.28 ml of allylamine was added in an ice bath, and then the mixture was stirred at room temperature for 3 hours. Thereafter, the mixture was purified to give the following siloxane compound (49): (((CH₃)₃SiO)₂SiCH₃O)₃Si(CH₂)₁₈CONHCH₂CH=CH₂ (1.15 g).
¹H-NMR (CDCl₃, 400 MHz) δ [ppm]: 0.038 (s), 0.094 (s), 0.505 - 0.546 (m), 1.248 (brs), 1.347 - 1.390 (m), 1.597 - 1.671 (m), 2.166 - 2.204 (t), 3.867 - 3.903 (m), 5.109 - 5.203 (m), 5.482 (brs), 5.790 - 5.887 (m)

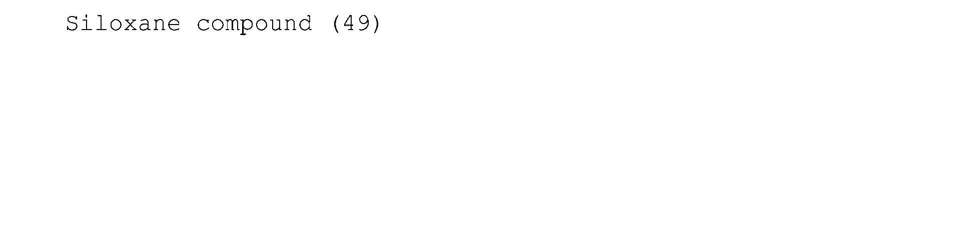

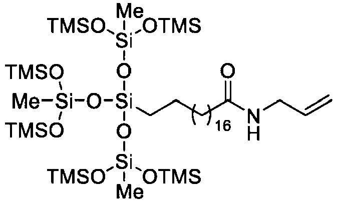

### (Synthetic Example 50)

First, 1.10 g of the siloxane compound (49): (((CH₃)₃SiO)₂SiCH₃O)₃Si(CH₂)₁₈CONHCH₂CH=CH₂ obtained in Synthetic Example 49, 6.5 ml of toluene, 0.01 g of pyridine, and 0.05 ml of a xylene solution containing a 2% Pt complex of 1,3-divinyl-1,1,3,3-tetramethyldisiloxane were each added, then 0.19 mL of trimethoxysilane was added, and the mixture was heated to 55°C and stirred for 3 hours. Thereafter, the mixture was purified to give the following siloxane compound (50): (((CH₃)₃SiO)₂SiCH₃O)₃Si(CH₂)₁₈CONH(CH₂)₃Si(OCH₃)₃ (1.18 g).
¹H-NMR (CDCl₃, 400 MHz) δ [ppm]: 0.038 (s), 0.094 (s), 0.504 - 0.546 (m), 0.626 - 0.668 (m), 1.248 (brs), 1.349 - 1.388 (m), 1.581 - 1.673 (m), 2.123 - 2.161 (t), 3.187 - 3.269 (m), 3.570 (s), 5.641 (brs)

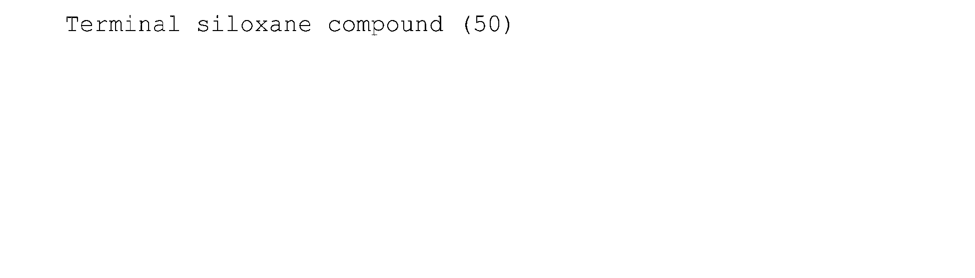

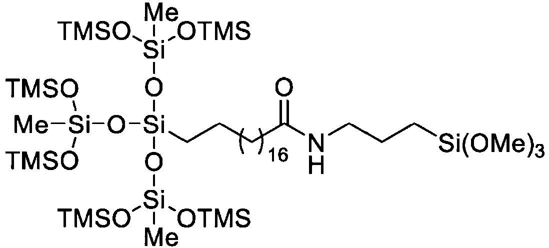

### (Surface-treating agent 19)

Compound (50) obtained above was diluted so as to be a 20 wt% ethanol solution, and thus a surface-treating agent 19 was obtained.

### (Synthetic Example 51)

First, 4.13 g of 18-bromo-1-octadecene: CH₂=CH(CH₂)₁₆Br, 24.0 ml of toluene, 0.01 g of pyridine, 0.55 ml of a xylene solution containing a 2% Pt complex of 1,3-divinyl-1,1,3,3-tetramethyldisiloxane, and 5.10 ml of 1,1,1,3,5,5,5-heptamethyltrisiloxane were each added, and the mixture was stirred at room temperature for 4 hours. Thereafter, the mixture was purified to give the following siloxane compound (51): ((CH₃)₃SiO)₂SiCH₃(CH₂)₁₈Br (6.74 g).
¹H-NMR (CDCl₃, 400 MHz) δ [ppm]: 0.003 (s), 0.085 (s), 0.428 - 0.466 (t), 1.258 (brs), 1.386 - 1.440 (m), 1.817 - 1.888 (m), 3.388 - 3.423 (t)

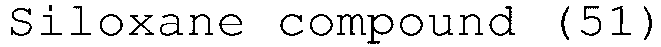

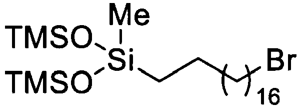

### (Synthetic Example 52)

The following siloxane compound (52): ((CH₃)₃SiO)₂SiCH₃(CH₂)₁₈CONH(CH₂)₃Si(OCH₃)₃ was obtained in the same manner as in Synthetic Examples 48 to 50 except that the raw material was changed to use the siloxane compound (51): ((CH₃)₃SiO)₂SiCH₃(CH₂)₁₈Br obtained in Synthetic Example 51.
¹H-NMR (CDCl₃, 400 MHz) δ [ppm]: -0.014 (s), 0.078 (s), 0.420 - 0.458 (t), 0.624 - 0.665 (t), 1.247 (brs), 1.578 - 1.654 (m), 2.121 - 2.160 (t), 3.184 - 3.266 (m), 3.568 (s), 5.658 (brs)

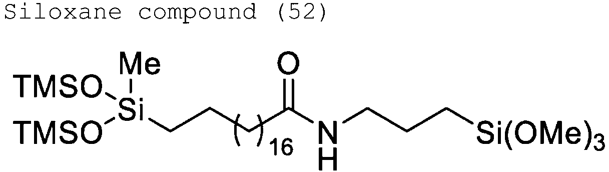

### (Surface-treating agent 20)

Compound (52) obtained above was diluted so as to be a 20 wt% ethanol solution, and thus a surface-treating agent 20 was obtained.

### (Synthetic Example 53)

First, 1.30 g of the siloxane compound (48): (((CH₃)₃SiO)₂SiCH₃O)₃Si(CH₂)₁₈COOH obtained in Synthetic Example 48, 24.0 ml of dichloromethane, 0.03 g of 4-dimethylaminopyridine, and 0.30 g of 1-(3-dimethylaminopropyl)-3-ethylcarbodiimide hydrochloride were each added, 0.24 g of 2-(2-propen-1-yl)-4-penten-1-amine was added in an ice bath, and then the mixture was stirred at room temperature for 3 hours. Thereafter, the mixture was purified to give the following siloxane compound (53): (((CH₃)₃SiO)₂SiCH₃O)₃Si(CH₂)₁₈CONHCH₂CH(CH₂CH=CH₂)₂ (1.26 g).
¹H-NMR (CDCl₃, 400 MHz) δ [ppm]: 0.038 (s), 0.094 (s), 0.505 - 0.546 (m), 1.247 (brs), 1.348 - 1.388 (m), 1.700 - 1.765 (m), 2.026 - 2.113 (q), 2.130 - 2.168 (t), 3.200 - 3.232 (m), 5.031 - 5.085 (m), 5.468 (brs), 5.737 - 5.840 (m)

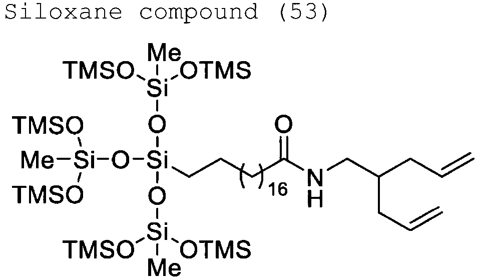

### (Synthetic Example 54)

First, 1.20 g of the siloxane compound (53): (((CH₃)₃SiO)₂SiCH₃O)₃Si(CH₂)₁₈CONHCH₂CH(CH₂CH=CH₂)₂ obtained in Synthetic Example 53, 7.0 ml of toluene, 0.01 g of triacetoxymethylsilane, and 0.22 ml of a xylene solution containing a 2% Pt complex of 1,3-divinyl-1,1,3,3-tetramethyldisiloxane were each added, then 0.40 mL of trichlorosilane was added, and the mixture was heated to 55°C and stirred for 3 hours. Thereafter, the mixture was purified to give the following siloxane compound (54): (((CH₃)₃SiO)₂SiCH₃O)₃Si(CH₂)₁₈CONHCH₂CH((CH₂)₃Si(OCH₃)₃)₂ (1.34 g).
¹H-NMR (CDCl₃, 400 MHz) δ [ppm]: 0.036 (s), 0.092 (s), 0.502 - 0.544 (m), 0.604 - 0.644 (t), 1.244 (brs), 1.349 - 1.448 (m), 1.473 - 1.535 (m), 1.579 - 1.652 (m), 2.130 - 2.169 (t), 3.164 - 3.194 (t), 3.552 (s), 5.507 (brs)

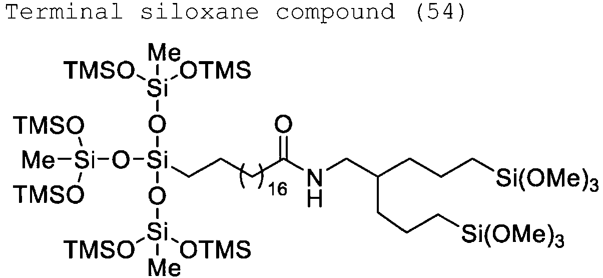

### (Surface-treating agent 21)

Compound (54) obtained above was diluted so as to be a 20 wt% ethanol solution, and thus a surface-treating agent 21 was obtained.

### (Synthetic Example 55)

First, 1.0 g of tricosenoic acid, 27 ml of toluene, and 0.04 ml of DMF were added, the mixture was heated to 60°C, 0.40 ml of thionyl chloride was added dropwise thereto, the mixture was stirred for 1 hour, and then volatile components were distilled off. To the mixture were added 27 ml of toluene and 0.7 ml of triethylamine, then 2.1 g of the trisiloxane-containing amine compound (37) was added dropwise, and the mixture was stirred at room temperature for 2 hours. Thereafter, the mixture was purified to give the following trisiloxane-containing amide compound (55) (2.05 g).
¹H-NMR (CDCl₃, 400 MHz) δ [ppm]: -0.146 - 0.232 (m), 0.400 (s), 1.100 - 1.500 (m), 1.600 (s), 2.017 - 2.500 (t), 2.133 - 2.146 (d), 3.094 (s), 4.916 - 5.007 (m), 5.204 (s), 5.769 - 5.700 (m)

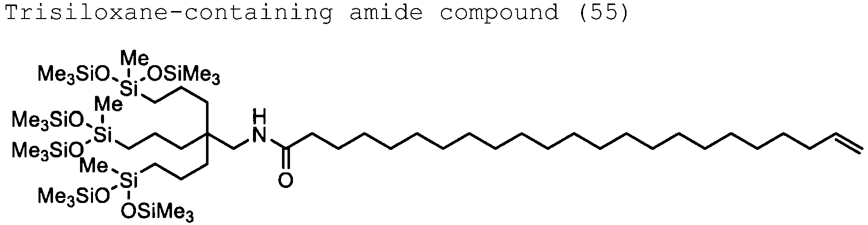

### (Synthetic Example 56)

First, 1.0 g of the trisiloxane-containing amide compound (55), 5.0 ml of toluene, 0.05 ml of a xylene solution containing a 2% Pt complex of 1,3-divinyl-1,1,3,3-tetramethyldisiloxane, and 0.02 ml of aniline were added, the mixture was stirred, 0.21 ml of trimethoxysilane was added dropwise, and then the mixture was stirred at room temperature for 1 hour. Thereafter, volatile components were distilled off under reduced pressure, and the mixture was purified to give the following trisiloxane-containing trimethoxysilane compound (56) (1.14 g).
¹H-NMR (CDCl₃, 400 MHz) δ [ppm]: -0.062 - 0.123 (m), 0.403 (s), 0.625 - 0.678 (m), 1.200 - 1.401 (m), 1.617 - 1.631 (m), 2.126 - 2.164 (m), 2.367 - 2.367 (m), 3.107 - 3.094 (d), 3.567 - 3.603 (m), 5.215 (s)

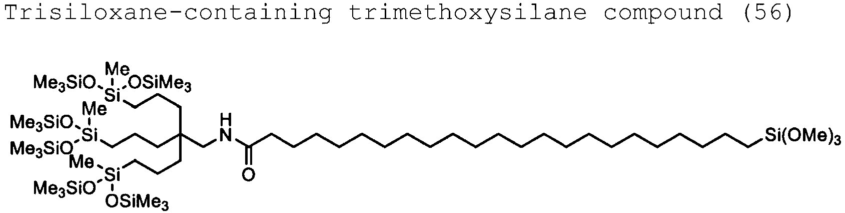

### (Surface-treating agent 22)

Compound (56) obtained above was diluted so as to be a 20 wt% ethanol solution, and thus a surface-treating agent 22 was obtained.

### (Synthetic Example 57)

First, 2.22 g of ((CH₃)₃SiO)₂SiCH₃(CH₂)₂₂COOCH₃, 12.8 ml of toluene, 0.54 g of 1,5,7-triazabicyclo[4.4.0]dec-5-ene, and 0.66 ml of diallylamine were each added, and the mixture was stirred at 70°C for 2 hours. Thereafter, the mixture was purified to give the following siloxane compound (57): ((CH₃)₃SiO)₂SiCH₃(CH₂)₂₂CON(CH₂CH=CH₂)₂ (2.12 g).
¹H-NMR (CDCl₃, 400 MHz) δ [ppm]: -0.011 (s), 0.081 (s), 0.424 - 0.462 (t), 1.250 (brs), 1.600 - 1.672 (m), 2.281 - 2.319 (t), 3.862 - 3.873 (d), 3.976 - 3.990 (d), 5.088 - 5.210 (m), 5.710 - 5.806 (m)

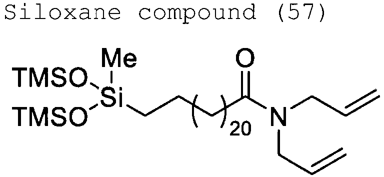

### (Synthetic Example 58)

First, 1.10 g of the siloxane compound (57): ((CH₃)₃SiO)₂SiCH₃(CH₂)₂₂CON(CH₂CH=CH₂)₂ obtained in Synthetic Example 57, 6.5 ml of toluene, 0.01 g of triacetoxymethylsilane, and 0.15 ml of a xylene solution containing a 2% Pt complex of 1,3-divinyl-1,1,3,3-tetramethyldisiloxane were each added, then 0.64 mL of trichlorosilane was added, and the mixture was heated to 40°C and stirred for 3 hours. Thereafter, the mixture was purified to give the following siloxane compound (58): ((CH₃)₃SiO)₂SiCH₃(CH₂)₂₂CON(CH₂)₃Si(OCH₃)₃)₂ (1.15 g).
¹H-NMR (CDCl₃, 400 MHz) δ [ppm]: -0.014 (s), 0.077 (s), 0.420 - 0.458 (t), 0.558 - 0.610 (t), 1.247 (brs), 1.601 - 1.661 (m), 2.256 - 2.293 (t), 3.181 - 3.221 (t), 3.262 - 3.300 (t), 3.555 (s), 3.574 (s)

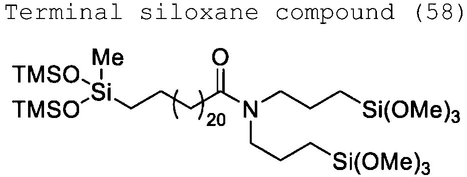

### (Surface-treating agent 23)

Compound (58) obtained above was diluted so as to be a 20 wt% ethanol solution, and thus a surface-treating agent 23 was obtained.

### (Synthetic Example 59)

First, 2.11 g of 22-tricosenoic acid: CH₂=CH(CH₂)₂₀COOH, 95 ml of toluene, and 1.26 g of 1,1'-carbonyldiimidazole were each added, and the mixture was stirred at room temperature for 1 hour. Thereafter, the mixture was purified to give the following amide compound (59): CH₂=CH(CH₂)₂₀CO(C₃H₄N₂) (2.22 g).
¹H-NMR (CDCl₃, 400 MHz) δ [ppm]: 1.250 (s), 1.333 - 1.426 (m), 1.761 - 1.836 (m), 2.007 - 2.061 (dd), 2.837 - 2.875 (t), 4.909 - 5.016 (m), 5.761 - 5.863 (m), 7.104 (s), 7.481 (s), 8.174 (s)

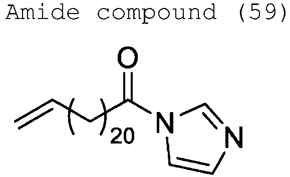

### (Synthetic Example 60)

First, 1.01 g of the amide compound (59): CH₂=CH(CH₂)₂₀CO(C₃H₄N₂) obtained in Synthetic Example 59, 6.6 ml of toluene, 0.02 g of triacetoxymethylsilane, 0.11 ml of a xylene solution containing a 2% Pt complex of 1,3-divinyl-1,1,3,3-tetramethyldisiloxane, and 6.6 ml of 1,1,1,3,5,5,5-heptamethyltrisiloxane were each added, and the mixture was stirred at room temperature for 3 hours. Thereafter, the mixture was purified to give the following siloxane compound (60): ((CH₃)₃SiO)₂SiCH₃(CH₂)₂₂CO(C₃H₄N₂) (1.33 g).
¹H-NMR (CDCl₃, 400 MHz) δ [ppm]: -0.011 (s), 0.081 (s), 0.422 - 0.459 (dd), 1.250 (s), 1.370 - 1.426 (m), 1.761 - 1.836 (m), 2.836 - 2.873 (t), 7.102 (s), 7.480 (s), 8.167 (s)

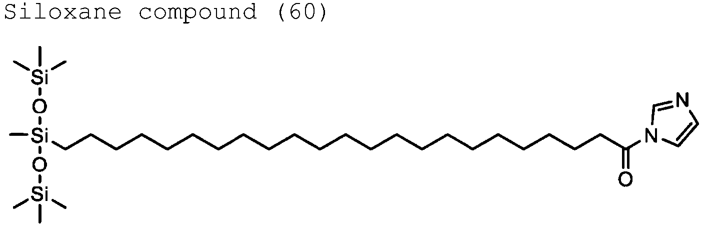

### (Synthetic Example 61)

First, 1.75 g of the amide compound (60) and 10 ml of toluene were added, the mixture was stirred, 0.82 ml of 2,2-diallylpent-4-en-1-amine was added dropwise thereto, and the mixture was stirred at room temperature overnight. Thereafter, the mixture was purified to give 1.2 g of the following trisiloxane-containing amide compound (61).
¹H-NMR (CDCl₃, 400 MHz) δ [ppm]: -0.069 - 0.133 (m), 0.422 - 0.461 (t), 1.248 - 1.427 (m), 1.569 - 1.650 (m), 2.020 - 2.039 (d), 2.139 - 2.177 (t), 3.186 - 3.201 (d), 5.068 - 5.114 (m), 5.520 - 5.580 (m), 5.810 - 5.916 (m),

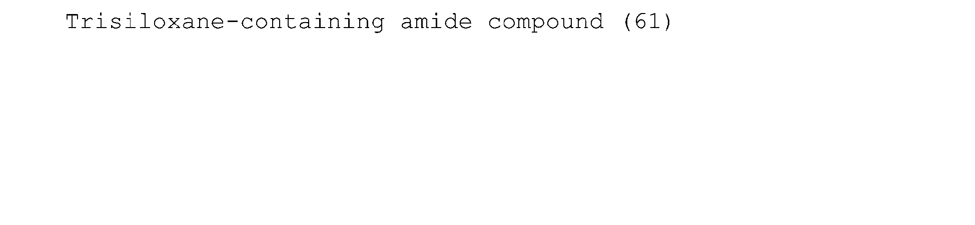

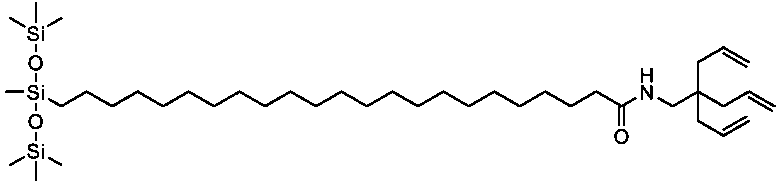

### (Synthetic Example 62)

First, 1.2 g of the trisiloxane-containing amide compound (61), 5 ml of toluene, 0.05 ml of a xylene solution containing a 2% Pt complex of 1,3-divinyl-1,1,3,3-tetramethyldisiloxane, and 0.04 ml of aniline were added, the mixture was stirred, 1.3 ml of trimethoxysilane was added dropwise, and then the mixture was stirred at 60°C overnight. Thereafter, volatile components were distilled off under reduced pressure, and the mixture was purified to give the following trisiloxane-containing trimethoxysilane compound (62) (1.8 g).

¹H-NMR (CDCl₃, 400 MHz) δ [ppm]: -0.075 - 0.128 (m), 0.417 - 0.455 (t), 0.575 - 0.613 (t), 1.092 - 1.394 (m), 1.583 - 1.634 (m), 2.107 - 2.170 (t), 3.092 - 3.108 (d), 3.472 - 3.611 (m), 5.696 - 5.726 (m)

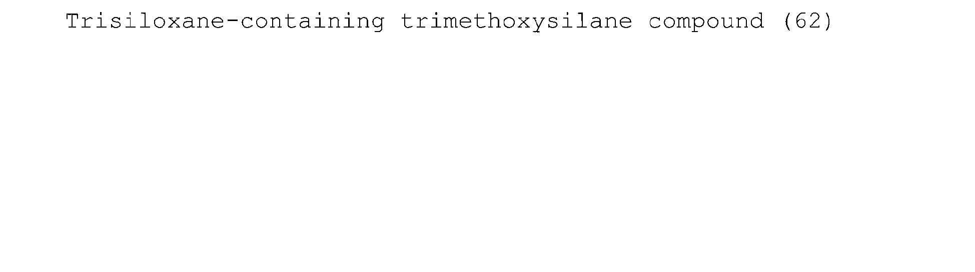

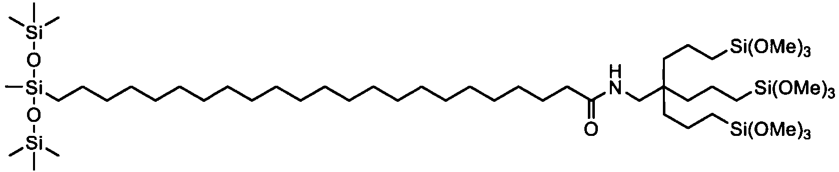

### (Surface-treating agent 24)

Compound (62) obtained above was diluted so as to be a 20 wt% ethanol solution, and thus a surface-treating agent 24 was obtained.

### (Synthetic Example 63)

First, 2.0 g of 1,1,1,3,5,5,5-heptamethyltrisiloxane, 5.0 ml of toluene, and 0.03 ml of a xylene solution containing a 2% Pt complex of 1,3-divinyl-1,1,3,3-tetramethyldisiloxane were added, the mixture was stirred, 0.70 ml of allylamine was added dropwise thereto, and the mixture was stirred at 70°C overnight. Thereafter, volatile components were distilled off by being heated under reduced pressure to give the following trisiloxane-containing amine compound (63) (1.7 g).
¹H-NMR (CDCl₃, 400 MHz) δ [ppm]: -0.148 - 0.150 (m), 0.385 - 0.509 (m), 1.181 (s), 1.396 - 1.474 (m), 2.626 - 2.661 (t)

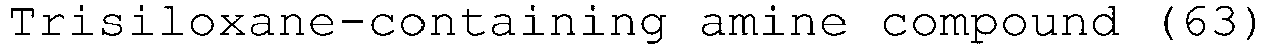

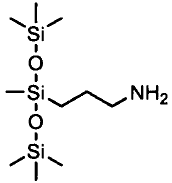

### (Synthetic Example 64)

First, 1.2 g of tricosenoic acid, 9 ml of toluene, and 0.07 ml of DMF were added, the mixture was heated to 60°C, 0.40 ml of thionyl chloride was added dropwise thereto, the mixture was stirred for 1 hour, and then volatile components were distilled off. To the mixture were added 9 ml of toluene and 1.0 ml of triethylamine, then 1.1 g of the trisiloxane-containing amine compound (63) was added dropwise, and the mixture was stirred at room temperature for 2 hours. Thereafter, the mixture was purified to give the following trisiloxane-containing amide compound (64) (0.85 g).
¹H-NMR (CDCl₃, 400 MHz) δ [ppm]: -0.066 - 0.146 (m), 0.426 - 0.469 (m), 1.100 - 1.400 (m), 1.478 - 1.537 (m), 1.599 - 1.633 (t), 2.000 - 2.057 (q), 2.127 - 2.165 (t), 3.192 - 3.241 (q), 4.899 - 5.010 (m), 5.504 (s), 5.754 - 5.856 (m)

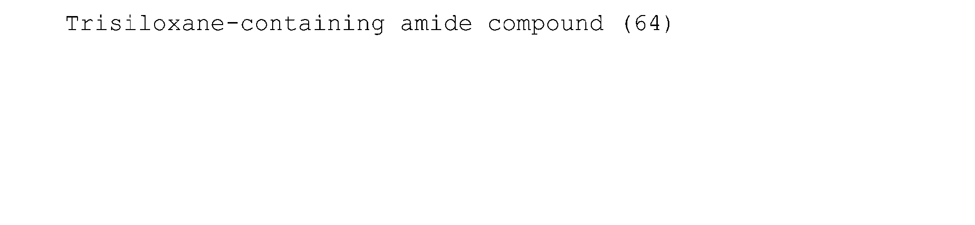

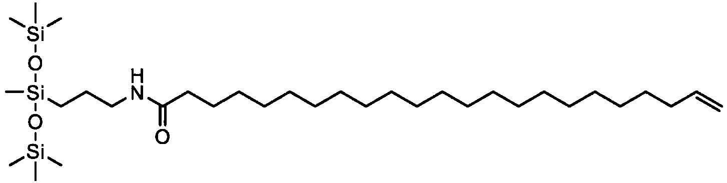

### (Synthetic Example 65)

First, 0.85 g of the trisiloxane-containing amide compound (64), 5.0 ml of toluene, 0.05 ml of a xylene solution containing a 2% Pt complex of 1,3-divinyl-1,1,3,3-tetramethyldisiloxane, and 0.03 ml of aniline were added, the mixture was stirred, 0.35 ml of trimethoxysilane was added dropwise, and then the mixture was stirred at room temperature overnight. Thereafter, volatile components were distilled off under reduced pressure, and the mixture was purified to give the following trisiloxane-containing trimethoxysilane compound (65) (1.14 g).
¹H-NMR (CDCl₃, 400 MHz) δ [ppm]: -0.065 - 0.122 (m), 0.426 - 0.501 (m), 0.620 - 0.660 (m), 1.169 - 1.420 (m), 1.458 - 1.536 (m), 1.580 - 1.660 (m), 2.124 - 2.163 (t), 3.189 - 3.240 (q), 3.473 - 3.643 (m), 5.499 (s)

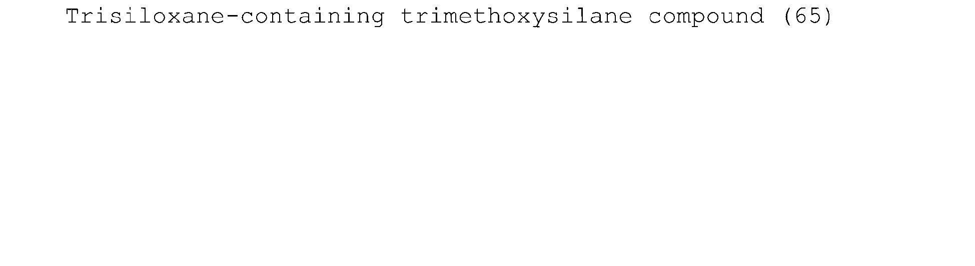

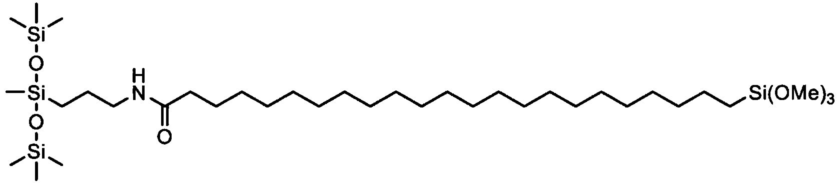

### (Surface-treating agent 25)

Compound (65) obtained above was diluted so as to be a 20 wt% ethanol solution, and thus a surface-treating agent 25 was obtained.

### (Synthetic Example 66)

First, 1.03 g of methyl 3,4-dihydroxybenzoate, 42.8 ml of N,N-dimethylformamide, 4.04 g of 18-bromo-1-octadecene, and 3.56 g of potassium carbonate were each added, and the mixture was heated to 80°C and stirred for 4 hours. Thereafter, the mixture was purified to give the following methyl ester compound (66): 3,4-(CH₂=CH(CH₂)₁₆O)₂C₆H₃COOCH₃ (4.30 g).
¹H-NMR (CDCl₃, 400 MHz) δ [ppm]: 1.263 (brs), 1.343 - 1.395 (m), 1.439 - 1.510 (m), 1.806 - 1.860 (m), 2.015 - 2.069 (q), 3.884 (s), 4.021 - 4.060 (m), 4.918 - 5.019 (m), 5.767 - 5.869 (m), 6.854 - 6.876 (d), 7.537 - 7.543 (d), 7.624 - 7.650 (dd)

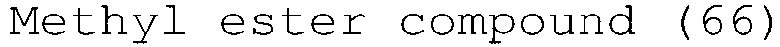

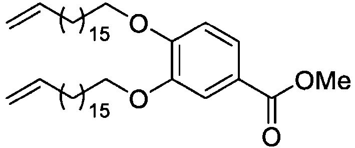

### (Synthetic Example 67)

First, 4.23 g of the methyl ester compound (66): 3,4-(CH₂=CH(CH₂)₁₆O)₂C₆H₃COOCH₃ obtained in Synthetic Example 66, 24.0 ml of toluene, 0.01 g of triacetoxymethylsilane, 0.56 ml of a xylene solution containing a 2% Pt complex of 1,3-divinyl-1,1,3,3-tetramethyldisiloxane, and 5.15 ml of 1,1,1,3,5,5,5-heptamethyltrisiloxane were each added, and the mixture was stirred at room temperature for 3 hours. Thereafter, the mixture was purified to give the following siloxane compound (67): 3,4-(((CH₃)₃SiO)₂SiCH₃(CH₂)₁₈O)₂C₆H₃COOCH₃ (5.36 g).
¹H-NMR (CDCl₃, 400 MHz) δ [ppm]: -0.006 (s), 0.085 (s), 0.430 - 0.467 (t), 1.258 (bbrs), 1.435 - 1.489 (m), 1.803 - 1.856 (m), 3.880 (s), 4.018 - 4.058 (m), 6.850 - 6.872 (d), 7.533 - 7.539 (d), 7.619 - 7.646 (dd)

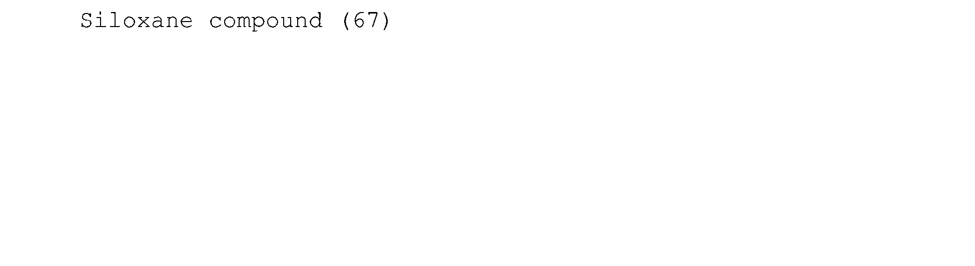

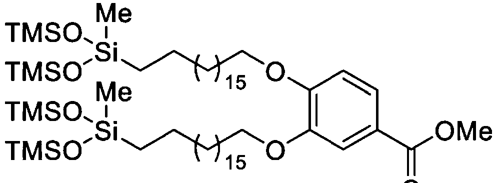

### (Synthetic Example 68)

First, 2.19 g of the siloxane compound (67): 3,4-(((CH₃)₃SiO)₂SiCH₃(CH₂)₁₈O)₂C₆H₃COOCH₃ obtained in Synthetic Example 67, 0.31 g of 1,5,7-triazabicyclo[4.4.0]dec-5-ene, and 0.74 ml of allylamine were each added, and the mixture was stirred at 60°C for 3 hours. Thereafter, the mixture was purified to give the following siloxane compound (68): 3,4-(((CH₃)₃SiO)₂SiCH₃(CH₂)₁₈O)₂C₆H₃CONHCH₂CH=CH₂ (1.86 g).
¹H-NMR (CDCl₃, 400 MHz) δ [ppm]: -0.010 (s), 0.082 (s), 0.425 - 0.463 (t), 1.255 (bbrs), 1.425 - 1.479 (m), 1.785 - 1.862 (m), 4.005 - 4.055 (q), 4.061 - 4.091 (t), 5.166 - 5.288 (m), 5.894 - 5.991 (m), 6.839 - 6.861 (d), 7.237 - 7.242 (d), 7.401 - 7.405 (d)

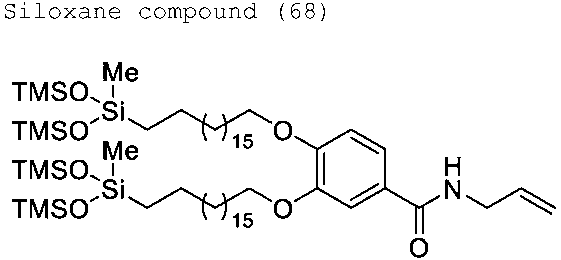

### (Synthetic Example 69)

First, 1.20 g of the siloxane compound (68): 3,4-(((CH₃)₃SiO)₂SiCH₃(CH₂)₁₈O)₂C₆H₃CONHCH₂CH=CH₂ obtained in Synthetic Example 68, 8.0 ml of toluene, 0.01 g of triacetoxymethylsilane, and 0.05 ml of a xylene solution containing a 2% Pt complex of 1,3-divinyl-1,1,3,3-tetramethyldisiloxane were each added, then 0.20 ml of trichlorosilane was added, and the mixture was heated to 40°C and stirred for 3 hours. Thereafter, the mixture was purified to give the following siloxane compound (69): 3,4-(((CH₃)₃SiO)₂SiCH₃(CH₂)₁₈O)₂C₆H₃CONH(CH₂)₃Si(OCH₃)₃ (1.29 g).
¹H-NMR (CDCl₃, 400 MHz) δ [ppm]: -0.010 (s), 0.082 (s), 0.425 - 0.463 (t), 0.703 - 0.743 (t), 1.255 (brs), 1.425 - 1.478 (m), 1.790 - 1.855 (m), 3.416 - 3.465 (q), 3.575 (s), 4.002 - 4.054 (q), 6.833 - 6.854 (d), 7.236 - 7.243 (d), 7.393 - 7.398 (d)

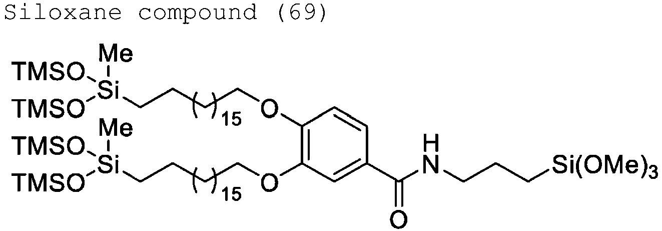

### (Surface-treating agent 26)

Compound (69) obtained above was diluted so as to be a 20 wt% ethanol solution, and thus a surface-treating agent 26 was obtained.

### (Synthetic Example 70)

The following siloxane compound (70): ((CH₃)₃SiO)₂SiCH₃(CH₂)₂₁CONH(CH₂)₃Si(OCH₃)₃ was obtained in the same manner as in Synthetic Examples 1 to 4 except that the raw material was changed to use 21-docosenoic acid: CH₂=CH(CH₂)₁₉COOH.
¹H-NMR (CDCl₃, 400 MHz) δ [ppm]: -0.019 (s), 0.073 (s), 0.415 - 0.453 (t), 0.621 - 0.661 (t), 1.240 (brs), 1.574 - 1.648 (m), 2.118 - 2.157 (t), 3.212 - 3.261 (q), 3.563 (s), 5.695 (brs)

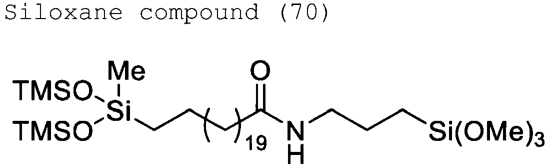

### (Surface-treating agent 27)

Compound (70) obtained above was diluted so as to be a 20 wt% ethanol solution, and thus a surface-treating agent 27 was obtained.

### (Synthetic Example 71)

First, 2.19 g of magnesium, 15 mL of THF, and 19.6 mg of iodine were each added, the mixture was stirred, and a THF solution of 29.0 g of 18-bromo-1-octadecene was added at 36 to 47°C. After the dropwise addition, the mixture was stirred at 42 to 51°C for 8 hours to prepare a reaction solution (1).

### (Synthetic Example 72)

First, 22.4 g of 12-bromododecanoic acid and 90 mL of THF were each added, the mixture was stirred, and 41.0 wt% ethylmagnesium bromide was added at -20°C to prepare a reaction solution (2).

### (Synthetic Example 73)

The reaction solution (2) prepared in Synthetic Example (72) was stirred at -16°C, and 13.8 mL of a 2.5 wt% THF solution of dilithium tetrachlorocopper(II) was added. Subsequently, the reaction solution (1) prepared in Synthesis Example 71 was added. The temperature was raised to room temperature, the mixture was stirred overnight, and then distilled water and sulfuric acid were added. Thereafter, the mixture was purified to give 20.4 g of the following triacont-29-enoic acid (73).

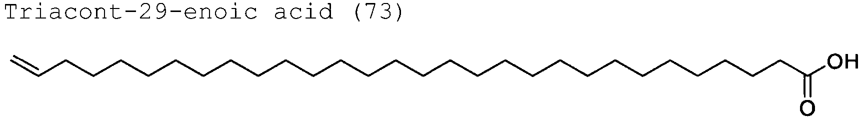

### (Synthetic Example 74)

First, 2.0 g of triacont-29-enoic acid, 13 mL of toluene, 9 mL of methanol, and 10 mL of a 10% hexane solution of TMS-diazomethane were added, and the mixture was stirred at room temperature for 15 minutes. Thereafter, the reaction was terminated by adding acetic acid, and the mixture was purified to give 2.0 g of the following compound (74).
¹H-NMR (400 MHz, chloroform-D) δ 5.66 - 5.94 (1H), 4.82 - 5.06 (2H), 3.62 - 3.72 (3H), 2.20 - 2.34 (2H), 1.96 - 2.14 (2H), 1.50 - 1.70 (2H), 1.16 - 1.50 (48H)

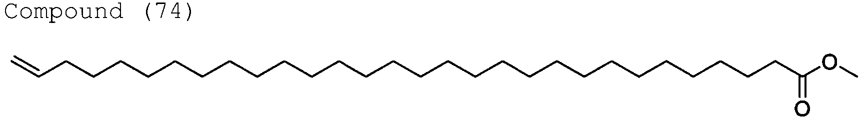

### (Synthetic Example 75)

First, 2.0 g of compound (74), 22 mL of toluene, 0.16 mL of aniline, and 490 µL of a xylene solution containing a 2% Pt complex of 1,3-divinyl-1,1,3,3-tetramethyldisiloxane were each added, and the mixture was stirred at room temperature for 16 hours. Thereafter, the mixture was purified to give 2.7 g of the following compound (75).
¹H-NMR (400 MHz, chloroform-D) δ 3.62 - 3.72 (3H), 2.20 - 2.40 (2H), 1.50 - 1.70 (2H), 1.16 - 1.50 (48H), 0.38 - 0.52 (2H), -0.06 - 0.38 (21H), -0.15- -0.06 (3H)

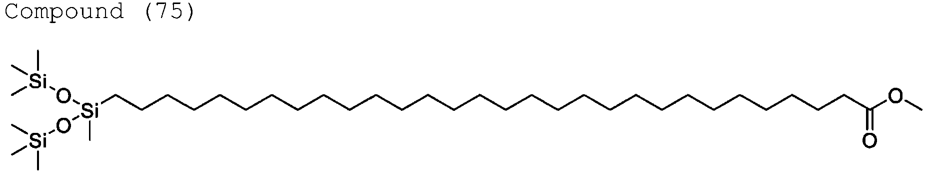

### (Synthetic Example 76)

First, 2.7 g of compound (75), 0.6 g of 1,5,7-triazabicyclo[4.4.0]-5-decene, and 17 mL of allylamine were added, and the mixture was stirred at 75°C for 3 hours. Thereafter, chloroform was added to dissolve and extract the product, hydrochloric acid was added to transfer allylamine to the aqueous layer, and thus a chloroform layer was obtained. Thereafter, the solution was washed with water and then purified to give 2.8 g of compound (76).
¹H-NMR (400 MHz, chloroform-D) δ 5.70 - 5.94 (1H), 5.06 - 5.24 (2H), 3.80 - 3.96 (2H), 2.14 - 2.28 (2H), 1.50 - 1.70 (2H), 1.16 - 1.50 (48H), 0.38 - 0.52 (2H), -0.06 - 0.38 (21H), -0.15- -0.06 (3H)

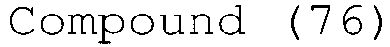

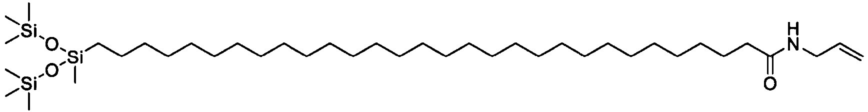

### (Synthetic Example 77)

First, 2.8 g of compound (76) obtained in Synthetic Example 76, 7 mL of toluene, 110 µL of aniline, and 230 µL of a xylene solution containing a 2% Pt complex of 1,3-divinyl-1,1,3,3-tetramethyldisiloxane were each added, then 1.0 mL of trimethoxysilane was added, and the mixture was stirred at 45°C for 2 hours. Thereafter, the mixture was purified to give 2.1 g of the following compound having a terminal trimethoxysilyl group (77).
¹H-NMR (400 MHz, chloroform-D) δ 5.60 - 5.80 (2H), 3.50 - 3.70 (9H), 3.15 - 3.30 (2H), 2.14 - 2.28 (2H), 1.50 - 1.70 (2H), 1.16 - 1.50 (48H), 0.60 - 0.75 (2H), 0.38 - 0.52 (2H), -0.06 - 0.38 (21H), -0.15- -0.06 (3H)

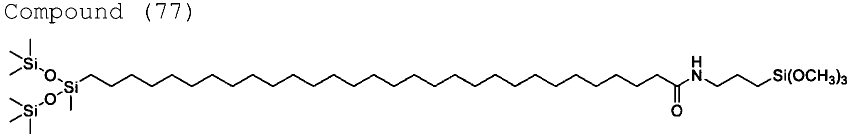

### (Surface-treating agent 28)

Compound (77) obtained above was diluted so as to be a 20 wt% ethanol solution, and thus a surface-treating agent 28 was obtained.

### (Synthetic Example 78)

First, 2.25 mL of methyl 10-undecenoate, 30.0 mL of toluene, and 2.3 mL of a xylene solution containing a 2% Pt complex of 1,3-divinyl-1,1,3,3-tetramethyldisiloxane were each added, and then 3.3 mL of 1,1,1,3,5,5,5-heptamethyltrisiloxane was added dropwise. After being stirred at room temperature for 6 hours, the mixture was purified to give 4.55 g of the following compound (78).
¹H-NMR (toluene, 400 MHz) δ [ppm]: 0.388 - 0.434 (m), 0.813 - 0.854 (m), 1.287 - 1.325 (t), 1.398 - 1.624 (m), 1.664 - 1.767 (m), 3.583 (s)

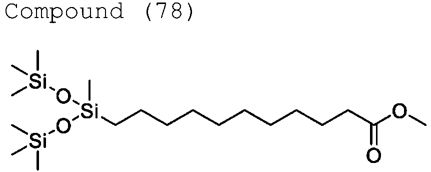

### (Synthetic Example 79)

First, 4.0 g of compound (78) obtained in Synthetic Example 78, 38 mL of allylamine, and 1.4 g of 1,5,7-triazabicyclo[4.4.0]dec-5-ene were each added, and the mixture was then stirred at 75°C for 6 hours. Thereafter, the mixture was washed with an aqueous hydrochloric acid solution, dehydrated over magnesium sulfate, and concentrated under reduced pressure to give 3.49 g of compound (79).
¹H-NMR (toluene, 400 MHz) δ [ppm]: 0.361 - 0.487 (m), 0.794 - 0.941 (m), 1.410 - 1.599 (m), 1.650 - 1.723 (m), 1.826 - 1.877 (m), 3.934 - 4.064 (m), 5.168 - 5.300 (m), 5.891 - 5.987 (m)

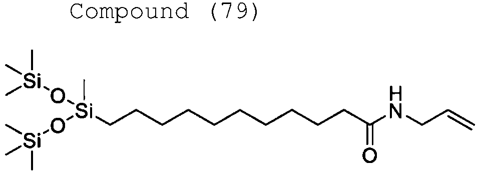

### (Synthetic Example 80)

First, 2.0 g of compound (79) obtained in Synthetic Example 79, 25 mL of toluene, 0.17 mL of pyridine, and 1.0 mL of a xylene solution containing a 2% Pt complex of 1,3-divinyl-1,1,3,3-tetramethyldisiloxane were each added, then 5.5 mL of trimethoxysilane was added, and the mixture was stirred at room temperature overnight. Thereafter, the mixture was purified to give 2.42 g of the following compound having a terminal trimethoxysilyl group (80).
¹H-NMR toluene, 400 MHz) δ [ppm]: 0.327 - 0.513 (m), 0.769 - 0.956 (m), 1.438 - 1.774 (m), 1.790 - 1.991 (m), 3.382 - 3.451 (m), 3.642 - 3.770 (m)

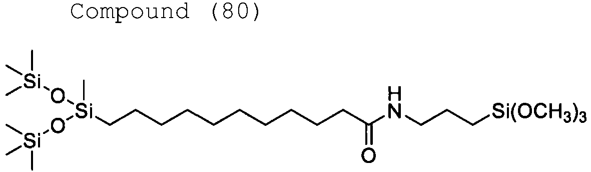

### (Surface-treating agent 29)

Compound (80) obtained above was diluted so as to be a 20 wt% ethanol solution, and thus a surface-treating agent 29 was obtained.

### (Synthetic Example 81)

First, 1.0 g of [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH=CH₂ (n≈8.7), 10 mL of toluene, 72 µL of a xylene solution containing a 2% Pt complex of 1,3-divinyl-1,1,3,3-tetramethyldisiloxane, and 17 µL of aniline were each added, then 323 µL of trimethoxysilane was added, and the mixture was stirred at room temperature for 16 hours. Thereafter, the mixture was purified to give 0.97 g of a compound having a terminal trimethoxysilyl group (81): [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH₂CH₂Si(OCH₃) ₃ (n≈9).
¹H-NMR (400 MHz, chloroform-D) δ [ppm] 7.00 (s), 6.71 - 6.78 (br), 5.65 (s), 5.33 - 5.47 (m), 4.62 (s), 4.21 - 4.50 (br), 3.46 - 3.67 (m), 3.16 - 3.29 (m), 2.10 - 2.39 (m), 1.91 - 2.06 (m), 1.52 - 1.68 (m), 1.14 - 1.36 (br), 0.85 - 0.99 (m), 0.60 - 0.70 (t), 0.48 - 0.59 (m), -0.13 - 0.25 (m)

### (Surface-treating agent 30)

Compound (81) obtained above was diluted so as to be a 20 wt% ethanol solution, and thus a surface-treating agent 30 was obtained.

### (Synthetic Example 82)

First, 1.0 g of [(CH₃)₃SiO]₃SiO(Si(CH₃)₂O)ₙSi(CH₃)₂CH₂CH₂CH₂CH₂CH₂CH₂CH₂CH₂CH₂ CH₂CH₂CH₂CH₂CH₂CH₂CH₂CH₂CH₂CH₂CH₂CH₂CH₂CONHCH₂CH=CH₂ (n≈6.7), 10 mL of toluene, 69 µL of a xylene solution containing a 2% Pt complex of 1,3-divinyl-1,1,3,3-tetramethyldisiloxane, and 17 µL of aniline were each added, then 309 µL of trimethoxysilane was added, and the mixture was stirred at room temperature for 16 hours. Thereafter, the mixture was purified to give 0.98 g of a compound having a terminal trimethoxysilyl group (82): [(CH₃)₃SiO]₃SiO(Si(CH₃)₂O)ₙSi(CH₃)₂CH₂CH₂CH₂CH₂CH₂CH₂CH₂CH₂CH₂ CH₂CH₂CH₂CH₂CH₂CH₂CH₂CH₂CH₂CH₂CH₂CH₂CH₂CONHCH₂CH₂CH₂Si(OCH₃)₃ (n≈8).
¹H-NMR (400 MHz, chloroform-D) δ [ppm] 7.00 (s), 6.71 - 6.78 (br), 5.65 (s), 5.33 - 5.47 (m), 4.62 (s), 4.21 - 4.50 (br), 3.46 - 3.67 (m), 3.16 - 3.29 (m), 2.10 - 2.39 (m), 1.91 - 2.06 (m), 1.52 - 1.68 (m), 1.14 - 1.38 (br), 0.85 - 0.99 (m), 0.60 - 0.70 (t), 0.48 - 0.59 (m), -0.13 - 0.25 (m)

### (Surface-treating agent 31)

Compound (82) obtained above was diluted so as to be a 20 wt% ethanol solution, and thus a surface-treating agent 31 was obtained.

### (Synthetic Example 83)

First, 3.0 g of compound (75), 0.6 g of 1,5,7-triazabicyclo[4.4.0]-5-decene, and 5.8 mL of 2-allylpent-4-enylamine were added, and the mixture was stirred at 75°C for 3 hours. Thereafter, chloroform was added to dissolve and extract the product, hydrochloric acid was added to transfer allylamine to the aqueous layer, and thus a chloroform layer was obtained. Thereafter, the solution was washed with water and then purified to give 3.0 g of compound (83).
¹H-NMR (400 MHz, chloroform-D) δ 5.70 - 5.94 (2H), 5.06 - 5.24 (4H), 3.15 - 3.30 (2H), 1.90 - 2.40 (4H), 1.50 - 1.75 (3H), 1.16 - 1.50 (54H), 0.38 - 0.52 (2H), -0.06 - 0.38 (21H), -0.15- -0.06 (3H)

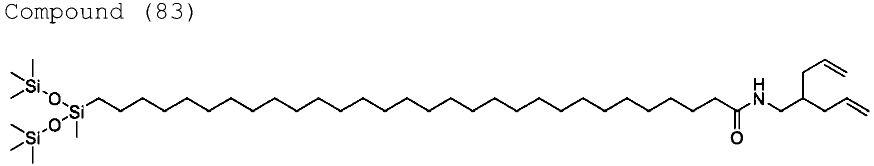

### (Synthetic Example 84)

First, 3.0 g of compound (83) obtained in Synthetic Example 83, 7 mL of toluene, 105 µL of aniline, and 219 µL of a xylene solution containing a 2% Pt complex of 1,3-divinyl-1,1,3,3-tetramethyldisiloxane were each added, then 2.0 mL of trimethoxysilane was added, and the mixture was stirred at 45°C for 1 hour. Thereafter, the mixture was purified to give 3.7 g of the following compound having a terminal trimethoxysilyl group (84).
¹H-NMR (400 MHz, chloroform-D) δ 3.40 - 3.70 (18H), 3.15 - 3.30 (2H), 2.14 - 2.28 (2H), 1.35 - 1.70 (10H), 1.16 - 1.50 (54H), 0.60 - 0.75 (4H), 0.38 - 0.52 (2H), -0.06 - 0.38 (21H)

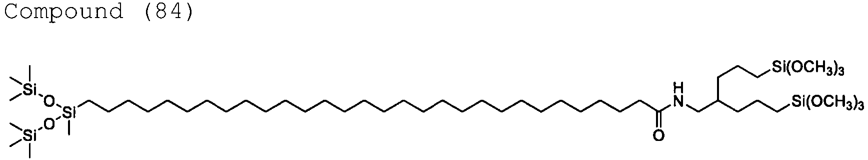

### (Surface-treating agent 32)

Compound (84) obtained above was diluted so as to be a 20 wt% ethanol solution, and thus a surface-treating agent 32 was obtained.

### (Synthetic Example 85)

First, 1.25 g of compound (1), 20.0 mL of toluene, 0.1 mL of pyridine, and 0.65 mL of a xylene solution containing a 2% Pt complex of 1,3-divinyl-1,1,3,3-tetramethyldisiloxane were each added, and then 1.01 g of tris(trimethylsilyloxy)silane was added dropwise. After being stirred at room temperature for 16 hours, the mixture was purified to give 1.36 g of compound (85).
¹H-NMR (CDCl₃, 400 MHz) δ [ppm]: 0.013 - 0.142 (m), 0.408 (t), 1.137 - 1.378 (m), 1.591 (quin), 2.275 (t), 3.639 (s)

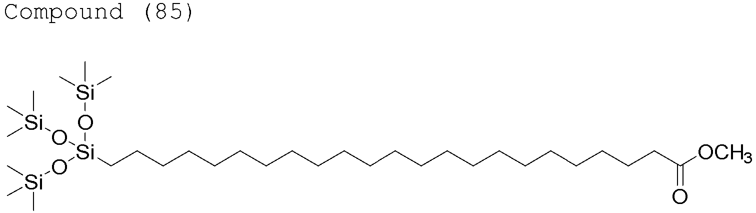

### (Synthetic Example 86)

First, 4.0 g of compound (85), 6.06 g of 2-allylpent-4-en-1-amine, and 0.84 g of 1,5,7-triazabicyclo[4.4.0]dec-5-ene were each added, and then the mixture was stirred at 75°C for 3 hours. Thereafter, the mixture was washed with an aqueous hydrochloric acid solution, dehydrated over magnesium sulfate, and concentrated under reduced pressure to give 3.94 g of compound (86).
¹H-NMR (CDCl₃, 400 MHz) δ [ppm]: 0.086 - 0.160 (m), 0.434 (t), 1.177 - 1.1.404 (m), 1.523 - 1.676 (m), 1.705 - 1.770 (m), 2.013 - 2.118 (m), 2.153 (t), 3.221 (t), 5.002 - 5.166 (m), 5.408 - 5.538 (br), 5.742 - 5.845 (m)

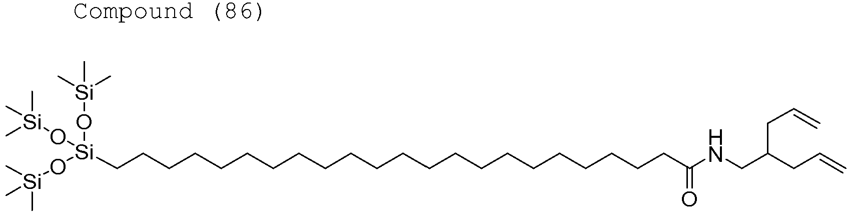

### (Synthetic Example 87)

First, 3.94 g of compound (86), 10 mL of toluene, 0.13 mL of pyridine, and 0.3 mL of a xylene solution containing a 2% Pt complex of 1,3-divinyl-1,1,3,3-tetramethyldisiloxane were each added, then 2.65 mL of trimethoxysilane was added, and the mixture was stirred at room temperature for 3 hours. Thereafter, the mixture was purified to give 3.11 g of compound (87).
¹H-NMR (CDCl₃, 400 MHz) δ [ppm]: 0.084 - 0.155 (m), 0.412 - 0.589 (m), 0.629 (t), 1.183 - 1.391 (m), 1.391 - 1.524 (m), 1.540 - 1.690 (m), 2.156 (t), 3.184 (t), 3.557 - 3.577 (s), 5.452 - 5.554 (m)

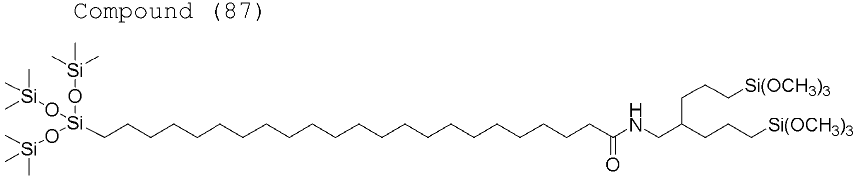

### (Surface-treating agent 33)

Compound (87) obtained above was diluted so as to be a 20 wt% heptane solution, and thus a surface-treating agent 33 was obtained.

### (Synthetic Example 88)

First, 3.21 g of compound (59), 65 ml of toluene, 0.25 ml of pyridine, 9 ml of a xylene solution containing a 2% Pt complex of 1,3-divinyl-1,1,3,3-tetramethyldisiloxane, and 4.7 ml of tris(trimethylsilyloxy)silane were each added, and the mixture was stirred at 80°C for 3 hours. Thereafter, the mixture was purified to give 5.5 g of compound (88).
¹H-NMR (CDCl₃, 400 MHz) δ [ppm]: 0.013 - 0.135 (m), 0.434 (t), 1.165 - 1.433 (m), 1.433 - 1.676 (m), 1.804 (quin), 1.931 - 2.036 (m), 2.856 (t), 7.104 (s), 7.480 (s), 8.166 (s)

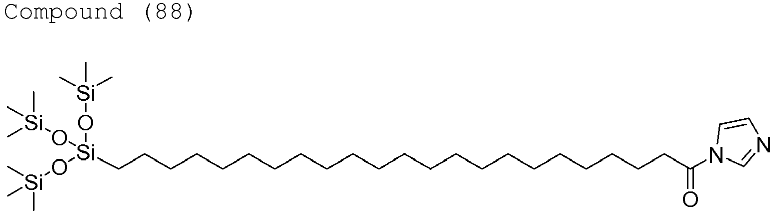

### (Synthetic Example 89)

First, 5.5 g of compound (88) and 10 ml of toluene were added, the mixture was stirred, 1.30 ml of diallylamine was added dropwise thereto, and the mixture was stirred at room temperature for 16 hours. Thereafter, the mixture was purified to give 4.9 g of compound (89).
¹H-NMR (CDCl₃, 400 MHz) δ [ppm]: -0.050 - 0.246 (m), 0.437 (t), 1.221 - 1.409 (m), 1.513 - 1.817 (m), 1.920 - 2.078 (m), 2.304 (t), 3.831 - 4.035 (m), 5.054 - 5.216 (m), 5.300 - 5.482 (m), 5.696 - 5.836 (m),

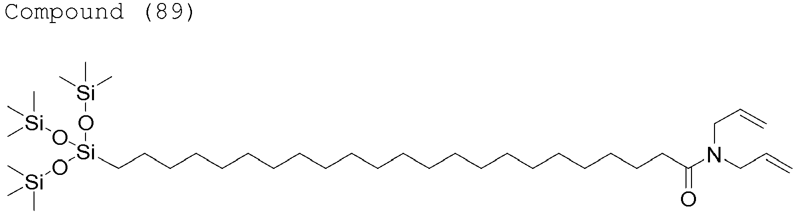

### (Synthetic Example 90)

First, 4.9 g of compound (89), 10 ml of toluene, 0.16 ml of pyridine, and 0.39 ml of a xylene solution containing a 2% Pt complex of 1,3-divinyl-1,1,3,3-tetramethyldisiloxane were each added, then 3.44 mL of trimethoxysilane was added, and the mixture was stirred at room temperature for 16 hours. Thereafter, the mixture was purified to give 5.9 g of compound (90).
¹H-NMR (CDCl3, 400 MHz) δ [ppm]: 0.023 - 0.134 (m), 0.401 - 0.489 (t), 0.545 - 0.642 (t), 1.184 - 1.403 (m), 1.546 - 1.717 (m), 1.930 - 2.034 (m), 2.283 (t), 3.208 (t), 3.288 (t), 3.542 - 3.630 (s)

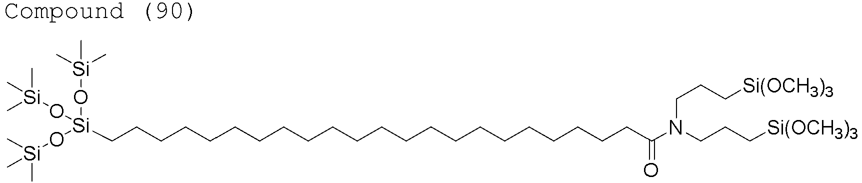

### (Surface-treating agent 34)

Compound (90) obtained above was diluted so as to be a 20 wt% heptane solution, and thus a surface-treating agent 34 was obtained.

### (Synthetic Example 91)

First, 2.01 g of [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH=CH₂ (n≈19), 10 ml of toluene, 0.13 ml of a xylene solution containing a 2% Pt complex of 1,3-divinyl-1,1,3,3-tetramethyldisiloxane, and 0.03 ml of aniline were added, the mixture was stirred, 0.57 ml of trimethoxysilane was added dropwise at room temperature, and then the mixture was heated to 45°C and stirred for 1.5 hours. Thereafter, volatile components were distilled off under reduced pressure, and the mixture was purified to give 2.1 g of compound (91): [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH₂CH₂Si(OCH₃) ₃ (n≈19).
¹H-NMR (CDCl₃, 400 MHz) δ [ppm] : -0.089 - 0.200 (m), 0.495 - 0.551 (m), 0.613 - 0.653 (t), 1.203 - 1.381 (m), 1.516 - 1.603 (m), 2.110 - 2.147 (t), 3.195 - 3.263 (m), 3.494 - 3.602 (m), 5.618 (br)

### (Surface-treating agent 35)

Compound (91) obtained above was diluted so as to be a 20 wt% heptane solution, and thus a surface-treating agent 35 was obtained.

### (Synthetic Example 92)

First, 2.00 g of [(CH₃)₃SiO]₃SiO(Si(CH₃)₂O)ₙSi(CH₃)₂CH₂CH₂CH₂CH₂CH₂CH₂CH₂CH₂CH₂ CH₂CH₂CH₂CH₂CH₂CH₂CH₂CH₂CH₂CH₂CH₂CH₂CH₂CONHCH₂CH=CH₂ (n≈58), 10 ml of toluene, 0.05 ml of a xylene solution containing a 2% Pt complex of 1,3-divinyl-1,1,3,3-tetramethyldisiloxane, and 0.01 ml of aniline were added, the mixture was stirred, 0.23 ml of trimethoxysilane was added dropwise at room temperature, and then the mixture was heated to 45°C and stirred for 2 hours. Thereafter, volatile components were distilled off under reduced pressure, and the mixture was purified to give 2.0 g of compound (92): [(CH₃)₃SiO]₃SiO(Si(CH₃)₂O)ₙSi(CH₃)₂CH₂CH₂CH₂CH₂CH₂CH₂CH₂CH₂CH₂ CH₂CH₂CH₂CH₂CH₂CH₂CH₂CH₂CH₂CH₂CH₂CH₂CH₂CONHCH₂CH₂CH₂Si(OCH₃)₃ (n≈58).
¹H-NMR (CDCl₃, 400 MHz) δ [ppm]: -0.097 - 0.199 (m), 0.488 - 0.536 (m), 0.609 - 0.662 (t), 1.192 - 1.377 (m), 1.495 - 1.651 (m), 2.103 - 2.160 (t), 3.205 - 3.235 (m), 3.483 - 3.616 (m), 5.609 (br)

### (Surface-treating agent 36)

Compound (92) obtained above was diluted so as to be a 20 wt% heptane solution, and thus a surface-treating agent 0 was obtained.

### (Synthetic Example 93)

First, 1.53 g of compound (2), 3.56 g of 2-(undec-10-en-1-yl)-12-en-1-amine, and 0.40 g of 1,5,7-triazabicyclo[4.4.0]dec-5-ene were each added, and the mixture was then stirred at 75°C for 3 hours. Thereafter, the mixture was purified to give 2.5 g of compound (93).
¹H-NMR (CDCl₃, 400 MHz) δ [ppm]: 0.043 - 0.124 (m), 0.447 (t), 1.126 - 1.639 (m), 2.041 (q), 2.159 (t), 3.183 (t), 4.882 - 5.201 (m), 5.764 - 5.866 (m)

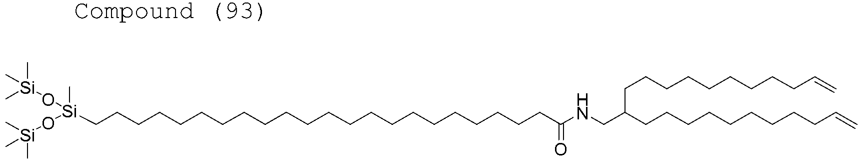

### (Synthetic Example 94)

First, 2.5 g of compound (93), 5 mL of toluene, 0.070 mL of pyridine, and 0.16 mL of a xylene solution containing a 2% Pt complex of 1,3-divinyl-1,1,3,3-tetramethyldisiloxane were each added, then 1.42 mL of trimethoxysilane was added, and the mixture was stirred at room temperature for 3 hours. Thereafter, the mixture was purified to give 2.2 g of compound (94).
¹H-NMR (CDCl₃, 400 MHz) δ [ppm]: 0.046 - 0.121 (m), 0.444 (t), 0.647 (t), 1.087 - 1.463 (m), 1.522 - 1.681 (m), 2.159 (t), 3.181 (t), 3.494 - 3.644 (m), 5.313 - 5.342 (m)

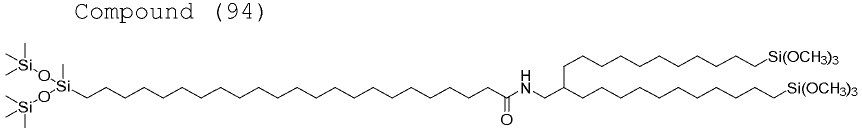

### (Surface-treating agent 37)

Compound (94) obtained above was diluted so as to be a 20 wt% heptane solution, and thus a surface-treating agent 37 was obtained.

### (Synthetic Example 95)

First, 2.00 g of [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH(CH₂CH=CH₂)₂ (n≈26), 10 ml of toluene, 0.05 ml of a xylene solution containing a 2% Pt complex of 1,3-divinyl-1,1,3,3-tetramethyldisiloxane, and 0.01 ml of aniline were added, the mixture was stirred, 0.24 ml of trimethoxysilane was added dropwise at room temperature, and then the mixture was heated to 45°C and stirred for 2 hours. Thereafter, volatile components were distilled off under reduced pressure, and the mixture was purified to give 2.0 g of compound (95): [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH[CH₂CH₂CH₂Si (OCH₃)₃]₂ (n≈26).
¹H-NMR (CDCl₃, 400 MHz) δ [ppm] : -0.089 - 0.207 (m), 0.492 - 0.531 (m), 0.595 - 0.635 (t), 1.200 - 1.308 (m), 1.378 - 1.681 (m), 2.123 - 2.160 (t), 3.157 - 3.187 (t), 3.517 - 3.592 (m), 3.494 - 3.602 (m), 5.465 - 5.492 (m)

### (Surface-treating agent 38)

Compound (95) obtained above was diluted so as to be a 20 wt% heptane solution, and thus a surface-treating agent 38 was obtained.

### (Synthetic Example 96)

First, 2.00 g of [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂C(CH₂CH=CH₂)₃ (n≈18), 10 ml of toluene, 0.06 ml of a xylene solution containing a 2% Pt complex of 1,3-divinyl-1,1,3,3-tetramethyldisiloxane, and 0.01 ml of aniline were added, the mixture was stirred, 0.76 ml of trimethoxysilane was added dropwise at room temperature, and then the mixture was heated to 45°C and stirred for 2 hours. Thereafter, volatile components were distilled off under reduced pressure, and the mixture was purified to give 2.3 g of compound (96): [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂C[CH₂CH₂CH₂Si( OCH₃)₃]₃ (n≈18).
¹H-NMR (CDCl₃, 400 MHz) δ [ppm] : -0.091 - 0.208 (m), 0.490 - 0.529 (m), 0.570 - 0.608 (t), 1.147 - 1.386 (m), 1.514 - 1.685 (m), 2.125 - 2.164 (t), 3.087 - 3.103 (t), 3.513 - 3.587 (m), 5.680 - 5.709 (m)

### (Surface-treating agent 39)

Compound (96) obtained above was diluted so as to be a 20 wt% heptane solution, and thus a surface-treating agent 39 was obtained.

### (Synthetic Example 97)

First, 2.00 g of [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH (CH₂CH₂CH₂CH ₂CH₂CH₂CH₂CH₂CH₂CH=CH₂)₂ (n≈17), 10 ml of toluene, 0.05 ml of a xylene solution containing a 2% Pt complex of 1,3-divinyl-1,1,3,3-tetramethyldisiloxane, and 0.01 ml of aniline were added, the mixture was stirred, 0.48 ml of trimethoxysilane was added dropwise at room temperature, and then the mixture was heated to 45°C and stirred for 2 hours. Thereafter, volatile components were distilled off under reduced pressure, and the mixture was purified to give 2.2 g of compound (97): [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH[CH₂CH₂CH₂CH ₂CH₂CH₂CH₂CH₂CH₂CH₂CH₂Si(OCH₃)₃]₂ (n≈17).
¹H-NMR (CDCl₃, 400 MHz) δ [ppm] : -0.091 - 0.204 (m), 0.491 - 0.529 (m), 0.612 - 0.652 (t), 1.199 - 1.274 (m), 1.354 - 1.465 (m), 1.505 - 1.624 (m), 2.125 - 2.163 (t), 3.152 - 3.182 (t), 3.517 - 3.593 (m), 5.292 - 5.320 (m)

### (Surface-treating agent 40)

Compound (97) obtained above was diluted so as to be a 20 wt% heptane solution, and thus a surface-treating agent 40 was obtained.

### (Synthetic Example 98)

First, 2.00 g of [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CON(CH₂CH=CH₂)₂ (n≈24), 10 ml of toluene, 0.05 ml of a xylene solution containing a 2% Pt complex of 1,3-divinyl-1,1,3,3-tetramethyldisiloxane, and 0.01 ml of aniline were added, the mixture was stirred, 0.46 ml of trimethoxysilane was added dropwise at room temperature, and then the mixture was heated to 45°C and stirred for 2 hours. Thereafter, volatile components were distilled off under reduced pressure, and the mixture was purified to give 2.1 g of compound (98): [(CH₃)₃SiO]₂CH₃Si(O(Si(CH₃)₂O)ₙSi(CH₃)₂CH₂CH₂CH₂CH₂CH₂CH₂CH₂CH ₂CH₂CH₂CH₂CH₂CH₂CH₂CH₂CH₂CH₂CH₂CH₂CH₂CH₂CH₂CON[CH₂CH₂CH₂Si(OCH₃ )₃]₂ (n≈24).
¹H-NMR (CDCl₃, 400 MHz) δ [ppm] : -0.091 - 0.208 (m), 0.491 - 0.530 (m), 0.549 - 0.602 (m), 1.200 - 1.310 (m), 1.561 - 1.632 (m), 2.246 - 2.285 (t), 3.173 - 3.212 (t), 3.254 - 3.293 (t), 3.442 - 3.517 (t), 3.510 - 3.603 (m),

### (Surface-treating agent 41)

Compound (98) obtained above was diluted so as to be a 20 wt% heptane solution, and thus a surface-treating agent 41 was obtained.

### (Formation of surface-treating layer)

### (Examples 1, 3, 5, 9, 15, 17, 19, 23, 25, 27, 29, 31, 33, 35, 37, 39, 41, 43, 45, 47, 49, 51, 53, 55, 57, 59, 61, 63, 65, 67, 69, 71, 73 and 75, and Comparative Example 1)

The surface-treating agents 1 to 5, 10 to 12, 15 to 31, and A prepared above were vacuum-deposited onto chemically tempered glass (Gorilla Glass, manufactured by Corning Incorporated, thickness 0.7 mm). Specifically, a molybdenum boat in a vacuum deposition system was filled with 0.1 g of a surface-treating agent, and the vacuum deposition system was evacuated to a pressure of 3.0 × 10⁻³ Pa or lower. Thereafter, a silicon dioxide film having a thickness of 7 nm was formed, followed by heating the boat by the resistance heating scheme to form a surface-treating layer. Thereafter, heat treatment was performed in an oven at 150°C for 2 hours to give a surface-treating layer.

### (Examples 2, 4, 6, 8, 10 to 14, 16, 18, 20 to 22, 24, 26, 28, 30, 32, 34, 36, 38, 40, 42, 44, 46, 48, 50, 52, 54, 56, 58, 60, 62, 64, 66, 68, 70, 72, 74, and 76)

The surface-treating agents 1 to 31 prepared above were vacuum-deposited onto chemically tempered glass (Gorilla Glass, manufactured by Corning Incorporated, thickness 0.7 mm). Specifically, a molybdenum boat in a vacuum deposition system was filled with 0.1 g of a surface-treating agent, and the vacuum deposition system was evacuated to a pressure of 3.0 × 10⁻³ Pa or lower. Thereafter, vapor deposition by the electron beam deposition scheme was performed using the formed article 1 to form a Na-containing silicon dioxide film having a thickness of 7 nm, followed by heating the boat by the resistance heating scheme to form a surface-treating layer. Thereafter, heat treatment was performed in an oven at 150°C for 2 hours to give a surface-treating layer.

### <Evaluation>

### [Abrasion resistance evaluation, and water-repellency/oil-repellency evaluation]

### (Initial evaluation)

As initial evaluation (0 times of abrasion), the static water contact angle was measured after forming the surface-treating layer and wiping off excessive matter on the surface. For contact angle measurement, a fully automatic contact angle meter DropMaster 700 (manufactured by Kyowa Interface Science Co., Ltd.) was used under an environment of 25°C. Specifically, the substrate having the measurement target, i.e., the surface-treating layer, was placed horizontally, water and hexadecane were separately dripped from a microsyringe onto the surface, and a static image was taken with a video microscope one second after the dropwise addition to thereby measure the respective static contact angles. The static contact angle was measured at five different points on the surface-treating layer of the substrate, and the average value calculated therefrom was used.

### (Evaluation after abrasion resistance test)

A friction block as described below was brought into contact with the formed surface-treating layer, a 5 N load was applied thereto, and the friction block was moved back and forth at a speed of 40 mm/sec, with the load being applied. After predetermined times of abrasion, the static water contact angle was measured. The results are shown in Table 1 and Table 2.

### - Friction block

The surfaces of an article obtained by processing silicone rubber as described below were covered with cotton soaked with artificial sweat having the following composition, and the article was used as a friction block.

Composition of artificial sweat:
Anhydrous disodium hydrogen phosphate: 2 g
Sodium chloride: 20 g
85% Lactic acid: 2 g
Histidine hydrochloride: 5 g
Distilled water: 1 kg

Article obtained by processing silicone rubber:
Obtained by processing Silicone Rubber Stopper SR-51 manufactured by Tigers Polymer Corporation into a cylinder having a diameter of 1 cm and a thickness of 1 cm.

**[Table 1]**

| Example | Surface-treating agent | Underlayer | Contact angle (degree) | |
|---|---|---|---|---|
| | | | Water | Hexadecane |
| Example 1 | Surface-treating agent 1 | Silicon dioxide film | 104 | 41 |
| Example 2 | Surface-treating agent 1 | Sodium-containing silicon dioxide film | 104 | 43 |
| Example 3 | Surface-treating agent 2 | Silicon dioxide film | 106 | 43 |
| Example 4 | Surface-treating agent 2 | Sodium-containing silicon dioxide film | 107 | 44 |
| Example 5 | Surface-treating agent 3 | Silicon dioxide film | 98 | 38 |
| Example 6 | Surface-treating agent 3 | Sodium-containing silicon dioxide film | 102 | 43 |
| Example 8 | Surface-treating agent 4 | Sodium-containing silicon dioxide film | 102 | 39 |
| Example 9 | Surface-treating agent 5 | Silicon dioxide film | 101 | 34 |
| Example 10 | Surface-treating agent 5 | Sodium-containing silicon dioxide film | 101 | 36 |
| Example 11 | Surface-treating agent 6 | Sodium-containing silicon dioxide film | 108 | 45 |
| Example 12 | Surface-treating agent 7 | Sodium-containing silicon dioxide film | 107 | 45 |
| Example 13 | Surface-treating agent 8 | Sodium-containing silicon dioxide film | 106 | 44 |
| Example 14 | Surface-treating agent 9 | Sodium-containing silicon dioxide film | 100 | 36 |
| Example 15 | Surface-treating agent 10 | Silicon dioxide film | 100 | 40 |
| Example 16 | Surface-treating agent 10 | Sodium-containing silicon dioxide film | 99 | 43 |
| Example 17 | Surface-treating agent 11 | Silicon dioxide film | 103 | 43 |
| Example 18 | Surface-treating agent 11 | Sodium-containing silicon dioxide film | 106 | 44 |
| Example 19 | Surface-treating agent 12 | Silicon dioxide film | 100 | 39 |
| Example 20 | Surface-treating agent 12 | Sodium-containing silicon dioxide film | 102 | 39 |
| Example 21 | Surface-treating agent 13 | Sodium-containing silicon dioxide film | 107 | 44 |
| Example 22 | Surface-treating agent 14 | Sodium-containing silicon dioxide film | 107 | 45 |
| Example 23 | Surface-treating agent 15 | Silicon dioxide film | 101 | 42 |
| Example 24 | Surface-treating agent 15 | Sodium-containing silicon dioxide film | 102 | 41 |
| Example 25 | Surface-treating agent 16 | Silicon dioxide film | 104 | 41 |
| Example 26 | Surface-treating agent 16 | Sodium-containing silicon dioxide film | 102 | 40 |
| Example 27 | Surface-treating agent 17 | Silicon dioxide film | 102 | 30 |
| Example 28 | Surface-treating agent 17 | Sodium-containing silicon dioxide film | 104 | 32 |
| Example 29 | Surface-treating agent 18 | Silicon dioxide film | 102 | 42 |
| Example 30 | Surface-treating agent 18 | Sodium-containing silicon dioxide film | 103 | 44 |
| Example 31 | Surface-treating agent 19 | Silicon dioxide film | 107 | 45 |
| Example 32 | Surface-treating agent 19 | Sodium-containing silicon dioxide film | 107 | 44 |
| Example 33 | Surface-treating agent 20 | Silicon dioxide film | 108 | 43 |
| Example 34 | Surface-treating agent 20 | Sodium-containing silicon dioxide film | 108 | 45 |
| Example 35 | Surface-treating agent 21 | Silicon dioxide film | 107 | 49 |
| Example 36 | Surface-treating agent 21 | Sodium-containing silicon dioxide film | 107 | 44 |
| Example 37 | Surface-treating agent 22 | Silicon dioxide film | 101 | 39 |
| Example 38 | Surface-treating agent 22 | Sodium-containing silicon dioxide film | 103 | 42 |
| Example 39 | Surface-treating agent 23 | Silicon dioxide film | 101 | 31 |
| Example 40 | Surface-treating agent 23 | Sodium-containing silicon dioxide film | 103 | 37 |
| Example 41 | Surface-treating agent 24 | Silicon dioxide film | 99 | 28 |
| Example 42 | Surface-treating agent 24 | Sodium-containing silicon dioxide film | 97 | 30 |
| Example 43 | Surface-treating agent 25 | Silicon dioxide film | 97 | 39 |
| Example 44 | Surface-treating agent 25 | Sodium-containing silicon dioxide film | 100 | 43 |
| Example 45 | Surface-treating agent 26 | Silicon dioxide film | 105 | 41 |
| Example 46 | Surface-treating agent 26 | Sodium-containing silicon dioxide film | 100 | 36 |
| Example 47 | Surface-treating agent 27 | Silicon dioxide film | 105 | 41 |
| Example 48 | Surface-treating agent 27 | Sodium-containing silicon dioxide film | 103 | 44 |
| Example 49 | Surface-treating agent 28 | Silicon dioxide film | 105 | 41 |
| Example 50 | Surface-treating agent 28 | Sodium-containing silicon dioxide film | 106 | 42 |
| Example 51 | Surface-treating agent 29 | Silicon dioxide film | 101 | 37 |
| Example 52 | Surface-treating agent 29 | Sodium-containing silicon dioxide film | 101 | 39 |
| Example 53 | Surface-treating agent 30 | Silicon dioxide film | 106 | 39 |
| Example 54 | Surface-treating agent 30 | Sodium-containing silicon dioxide film | 106 | 40 |
| Example 55 | Surface-treating agent 31 | Silicon dioxide film | 105 | 38 |
| Example 56 | Surface-treating agent 31 | Sodium-containing silicon dioxide film | 105 | 39 |
| Example 57 | Surface-treating agent 32 | Silicon dioxide film | 103 | 37 |
| Example 58 | Surface-treating agent 32 | Sodium-containing silicon dioxide film | 101 | 39 |
| Example 59 | Surface-treating agent 33 | Silicon dioxide film | 102 | 34 |
| Example 60 | Surface-treating agent 33 | Sodium-containing silicon dioxide film | 100 | 33 |
| Example 61 | Surface-treating agent 34 | Silicon dioxide film | 101 | 32 |
| Example 62 | Surface-treating agent 34 | Sodium-containing silicon dioxide film | 100 | 34 |
| Example 63 | Surface-treating agent 35 | Silicon dioxide film | 103 | 37 |
| Example 64 | Surface-treating agent 35 | Sodium-containing silicon dioxide film | 104 | 38 |
| Example 65 | Surface-treating agent 36 | Silicon dioxide film | 106 | 37 |
| Example 66 | Surface-treating agent 36 | Sodium-containing silicon dioxide film | 105 | 38 |
| Example 67 | Surface-treating agent 37 | Silicon dioxide film | 97 | 24 |
| Example 68 | Surface-treating agent 37 | Sodium-containing silicon dioxide film | 98 | 31 |
| Example 69 | Surface-treating agent 38 | Silicon dioxide film | 106 | 38 |
| Example 70 | Surface-treating agent 38 | Sodium-containing silicon dioxide film | 106 | 40 |
| Example 71 | Surface-treating agent 39 | Silicon dioxide film | 105 | 36 |
| Example 72 | Surface-treating agent 39 | Sodium-containing silicon dioxide film | 105 | 38 |
| Example 73 | Surface-treating agent 40 | Silicon dioxide film | 101 | 37 |
| Example 74 | Surface-treating agent 40 | Sodium-containing silicon dioxide film | 100 | 36 |
| Example 75 | Surface-treating agent 41 | Silicon dioxide film | 105 | 38 |
| Example 76 | Surface-treating agent 41 | Sodium-containing silicon dioxide film | 106 | 40 |
| Comparative example 1 | Surface-treating agent A | Silicon dioxide film | 82 | 8 |

**[Table 2]**

| Example | Surface-treating agent | Underlayer | Contact angle (degree) | | Initial-angle retention rate (%) |
|---|---|---|---|---|---|
| | | | At before beginning | After 100 times of abrasion | |
| Example 1 | Surface-treating agent 1 | Silicon dioxide film | 104.2 | 80.6 | 77 |
| Example 2 | Surface-treating agent 1 | Sodium-containing silicon dioxide film | 104.0 | 83.5 | 80 |
| Example 4 | Surface-treating agent 2 | Sodium-containing silicon dioxide film | 106.8 | 81.4 | 76 |
| Example 6 | Surface-treating agent 3 | Sodium-containing silicon dioxide film | 101.5 | 84.9 | 84 |
| Example 8 | Surface-treating agent 4 | Sodium-containing silicon dioxide film | 101.5 | 75.1 | 74 |
| Example 9 | Surface-treating agent 5 | Silicon dioxide film | 101.3 | 77.6 | 77 |
| Example 10 | Surface-treating agent 5 | Sodium-containing silicon dioxide film | 101.5 | 93.2 | 92 |
| Example 14 | Surface-treating agent 9 | Sodium-containing silicon dioxide film | 99.9 | 96.2 | 96 |
| Example 16 | Surface-treating agent 10 | Sodium-containing silicon dioxide film | 99.5 | 71.9 | 72 |
| Example 19 | Surface-treating agent 12 | Silicon dioxide film | 99.7 | 77.3 | 78 |
| Example 20 | Surface-treating agent 12 | Sodium-containing silicon dioxide film | 102.3 | 88.4 | 86 |
| Example 21 | Surface-treating agent 13 | Sodium-containing silicon dioxide film | 107.3 | 96.5 | 90 |
| Example 22 | Surface-treating agent 14 | Sodium-containing silicon dioxide film | 107.4 | 87.8 | 82 |
| Example 36 | Surface-treating agent 21 | Sodium-containing silicon dioxide film | 106.8 | 78.6 | 74 |
| Example 39 | Surface-treating agent 23 | Silicon dioxide film | 101.1 | 77.4 | 77 |
| Example 40 | Surface-treating agent 23 | Sodium-containing silicon dioxide film | 103.3 | 93.8 | 91 |
| Example 41 | Surface-treating agent 24 | Silicon dioxide film | 98.5 | 70.5 | 72 |
| Example 42 | Surface-treating agent 24 | Sodium-containing silicon dioxide film | 97.3 | 87.8 | 90 |
| Example 43 | Surface-treating agent 25 | Silicon dioxide film | 96.7 | 74.8 | 77 |
| Example 44 | Surface-treating agent 25 | Sodium-containing silicon dioxide film | 100.0 | 85.4 | 85 |
| Example 47 | Surface-treating agent 27 | Silicon dioxide film | 104.6 | 86.4 | 83 |
| Example 48 | Surface-treating agent 27 | Sodium-containing silicon dioxide film | 103.3 | 92.5 | 90 |
| Example 54 | Surface-treating agent 30 | Sodium-containing silicon dioxide film | 106.1 | 90.9 | 86 |
| Example 55 | Surface-treating agent 31 | Silicon dioxide film | 104.6 | 79.6 | 76 |
| Example 56 | Surface-treating agent 31 | Sodium-containing silicon dioxide film | 105.0 | 90.1 | 86 |
| Example 57 | Surface-treating agent 32 | Silicon dioxide film | 102.7 | 76.3 | 74 |
| Example 58 | Surface-treating agent 32 | Sodium-containing silicon dioxide film | 100.9 | 94.9 | 94 |
| Example 59 | Surface-treating agent 33 | Silicon dioxide film | 101.8 | 76.5 | 75 |
| Example 60 | Surface-treating agent 33 | Sodium-containing silicon dioxide film | 99.5 | 91.0 | 91 |
| Example 61 | Surface-treating agent 34 | Silicon dioxide film | 100.6 | 76.7 | 76 |
| Example 62 | Surface-treating agent 34 | Sodium-containing silicon dioxide film | 99.8 | 91.3 | 91 |
| Example 63 | Surface-treating agent 35 | Silicon dioxide film | 103.1 | 72.2 | 70 |
| Example 64 | Surface-treating agent 35 | Sodium-containing silicon dioxide film | 103.5 | 90.0 | 87 |
| Example 66 | Surface-treating agent 36 | Sodium-containing silicon dioxide film | 105.3 | 81.1 | 77 |
| Example 68 | Surface-treating agent 37 | Sodium-containing silicon dioxide film | 97.6 | 90.8 | 93 |
| Example 69 | Surface-treating agent 38 | Silicon dioxide film | 105.9 | 88.6 | 84 |
| Example 70 | Surface-treating agent 38 | Sodium-containing silicon dioxide film | 105.8 | 96.5 | 91 |
| Example 71 | Surface-treating agent 39 | Silicon dioxide film | 105.3 | 74.1 | 70 |
| Example 72 | Surface-treating agent 39 | Sodium-containing silicon dioxide film | 105.0 | 91.6 | 87 |
| Example 73 | Surface-treating agent 40 | Silicon dioxide film | 101.0 | 71.7 | 71 |
| Example 74 | Surface-treating agent 40 | Sodium-containing silicon dioxide film | 99.9 | 88.0 | 88 |
| Example 75 | Surface-treating agent 41 | Silicon dioxide film | 104.9 | 86.6 | 83 |
| Example 76 | Surface-treating agent 41 | Sodium-containing silicon dioxide film | 105.6 | 95.2 | 90 |
| Comparative example 1 | Surface-treating agent A | Silicon dioxide film | 82.4 | 54.0 | 66 |

### Industrial Applicability

The surface-treating agent of the present disclosure can be suitably utilized in a variety of applications.

## Claims

1. A silane compound comprising:
the following group A at a terminal:
R¹ₙₐR²₃₋ₙₐSi-(O)_{z}- (A)
wherein
R¹ is each independently a group represented by -(R⁴-SiR³₂)ₘₐ-R³,
R⁴ is each independently an oxygen atom or a C₁₋₆ alkylene group,
R³ is each independently a hydrocarbon group or R^{1'},
R^{1'} has the same meaning as R¹,
ma is each independently an integer of 1 to 5,
provided that the number of R^{1'} in R¹ is 20 or less,
R² is each independently a hydrocarbon group,
na is an integer of 1 to 3,
z is 0 or 1; and
a Si atom to which a hydroxyl group or a hydrolyzable group is bonded, at another terminal.

2. The silane compound according to claim 1, which is represented by the following formula (1):
R^{A}_{α}-X¹-R^{Si}_{β} (1)
wherein
R^{A} is the group A,
X¹ is a di- to decavalent group,
R^{Si} is a monovalent group containing the Si atom to which a hydroxyl group or a hydrolyzable group is bonded,
α is an integer of 1 to 9, and
β is an integer of 1 to 9.

3. The silane compound according to claim 1, wherein in the group A,
R¹ is each independently a group represented by - (OSiR³₂)ₘₐ-R³,
R³ is each independently a hydrocarbon group or R^{1'},
ma is each independently 1 or 2,
R² is each independently a hydrocarbon group, and
na is an integer of 1 to 3.

4. The silane compound according to claim 1, wherein R³ is a C₁₋₄ alkyl group.

5. The silane compound according to claim 2, wherein R^{Si} is a group represented by the following formula (S1), (S2), (S3), (S4), or (S5): 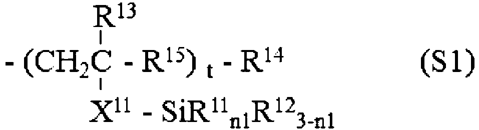
- SiR¹¹ₙ₁R¹²₃₋ₙ₁ (S2)
**-** SiR^{a1}ₖ₁R^{b1}₁₁R^{c1}ₘ₁ (S3)
- CR^{d1}ₖ₂R^{e1}₁₂R^{f1}ₘ₂ (S4)
**-** NR^{g1}R^{h1} (S5)
wherein
R¹¹ is each independently a hydroxyl group or a hydrolyzable group,
R¹² is each independently a monovalent organic group,
n1 is each independently an integer of 0 to 3 for each (SiR¹¹ₙ₁R¹²₃₋ₙ₁) unit,
X¹¹ is each independently a single bond or a divalent organic group,
R¹³ is each independently a hydrogen atom or a monovalent organic group,
t is each independently an integer of 2 or more,
R¹⁴ is each independently a hydrogen atom, a halogen atom, or -X¹¹-SiR¹¹ₙ₁R¹²₃₋ₙ₁,
R¹⁵ is each independently a single bond, an oxygen atom, an alkylene group having 1 to 6 carbon atoms, or an alkyleneoxy group having 1 to 6 carbon atoms,
R^{a1} is each independently -Z¹-SiR²¹ₚ₁R²²_{q1}R²³ᵣ₁,
Z¹ is each independently a divalent organic group,
R²¹ is each independently -Z^{1'}-SiR^{21'}_{p1'}R^{22'}_{q1'}R^{23'}_{r1'},
R²² is each independently a hydroxyl group or a hydrolyzable group,
R²³ is each independently a monovalent organic group,
p1 is each independently an integer of 0 to 3,
q1 is each independently an integer of 0 to 3,
r1 is each independently an integer of 0 to 3,
Z^{1'} is each independently a divalent organic group,
R^{21'} is each independently -Z^{1"}-SiR^{22"}_{q1"}R^{23"}_{r1"},
R^{22'} is each independently a hydroxyl group or a hydrolyzable group,
R^{23'} is each independently a monovalent organic group,
p1' is each independently an integer of 0 to 3,
q1' is each independently an integer of 0 to 3,
r1' is each independently an integer of 0 to 3,
Z^{1"} is each independently a divalent organic group,
R^{22"} is each independently a hydroxyl group or a hydrolyzable group,
R^{23"} is each independently a monovalent organic group,
q1" is each independently an integer of 0 to 3,
r1" is each independently an integer of 0 to 3,
R^{b1} is each independently a hydroxyl group or a hydrolyzable group,
R^{c1} is each independently a monovalent organic group,
k1 is each independently an integer of 0 to 3,
11 is each independently an integer of 0 to 3,
m1 is each independently an integer of 0 to 3,
provided that, in the formula (S3), at least two Si atoms to which a hydroxyl group or a hydrolyzable group is bonded are present,
R^{d1} is each independently -Z²-CR³¹ₚ₂R³²_{q2}R³³ᵣ₂,
Z² is each independently a single bond, an oxygen atom, or a divalent organic group,
R³¹ is each independently -Z^{2'}-CR^{32'}_{q2'}R^{33'}_{r2'},
R³² is each independently -Z³-SiR³⁴ₙ₂R³⁵₃₋ₙ₂,
R³³ is each independently a hydrogen atom, a hydroxyl group, or a monovalent organic group,
p2 is each independently an integer of 0 to 3,
q2 is each independently an integer of 0 to 3,
r2 is each independently an integer of 0 to 3,
Z^{2'} is each independently a single bond, an oxygen atom, or a divalent organic group,
R^{32'} is each independently -Z³-SiR³⁴ₙ₂R³⁵₃₋ₙ₂,
R^{33'} is each independently a hydrogen atom, a hydroxyl group, or a monovalent organic group,
q2' is each independently an integer of 0 to 3,
r2' is each independently an integer of 0 to 3,
Z³ is each independently a single bond, an oxygen atom, or a divalent organic group,
R³⁴ is each independently a hydroxyl group or a hydrolyzable group,
R³⁵ is each independently a monovalent organic group,
n2 is each independently an integer of 0 to 3,
R^{e1} is each independently -Z³-SiR³⁴ₙ₂R³⁵₃₋ₙ₂,
R^{f1} is each independently a hydrogen atom, a hydroxyl group, or a monovalent organic group,
k2 is each independently an integer of 0 to 3,
l2 is each independently an integer of 0 to 3,
m2 is each independently an integer of 0 to 3,
provided that, in the formula (S4), at least two Si atoms to which a hydroxyl group or a hydrolyzable group is bonded are present,
R^{g1} and R^{h1} are each independently -Z⁴-SiR¹¹ₙ₁R¹²₃₋ₙ₁, - Z⁴-SiR^{a1}ₖ₁R^{b1}ₗ₁R^{c1}ₘ₁, or -Z⁴-CR^{d1}ₖ₂R^{e1}ₗ₂R^{f1}ₘ₂, and
Z⁴ is each independently a single bond, an oxygen atom, or a divalent organic group,
provided that, in the formula (S5), at least two Si atoms to which a hydroxyl group or a hydrolyzable group is bonded are present.

6. The silane compound according to claim 5, wherein R^{Si} is a group represented by the formula (S2).

7. The silane compound according to claim 5, wherein R^{Si} is a group represented by the formula (S3), (S4), or (S5).

8. The silane compound according to claim 2, wherein X¹ is a di- to decavalent group containing -CO-, -COO-, - NR⁴¹-, -CONR⁴¹-, -OCONR⁴¹-, -NR⁴¹-CO-NR⁴¹-, -O-, -S-, -CON=, or R^{S},
R⁴¹ is a hydrogen atom or a C₁₋₆ alkyl group,
R^{S} is a group represented by the following formula: 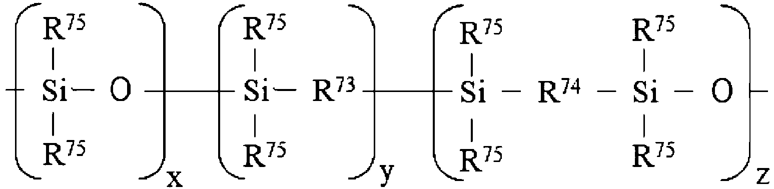 wherein
R⁷³ is each independently a single bond, a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁶ is each independently a C₁₋₆ alkylene group,
R⁷⁷ is each independently an optionally substituted phenylene group or naphthylene group,
R⁷⁸ is each independently a single bond or a C₁₋₆ alkylene group,
R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula.

9. The silane compound according to claim 2, wherein X¹ is a group represented by the following formula:
-(X²¹)ₐ₀-[(X¹¹)ₐ₁-(X¹²)ₐ₂]-
wherein
X²¹ is an optionally substituted tri- to hexavalent aromatic group, R⁶¹_{b1}R⁶²_{3-b1}C-, R⁶³_{b2}R⁶⁴_{3-b2}Si-, or R⁶⁵₂N-,
R⁶¹ is each independently a single bond or a divalent organic group,
R⁶² is each independently a hydrogen atom or a monovalent organic group,
R⁶³ is each independently a single bond or a divalent organic group,
R⁶⁴ is each independently a hydrogen atom or a monovalent organic group,
R⁶⁵ is each independently a single bond or a divalent organic group,
b1 is 2 or 3,
b2 is 2 or 3,
X¹¹ is a single bond or a divalent organic group,
X¹² is -CO-, -COO-, -OCO-, -NR⁴¹-, -CONR⁴¹-, -NR⁴¹CO-, -OCONR⁴¹-, -NR⁴¹COO-, -NR⁴¹-CO-NR⁴¹-, -O-, -S-, or R^{S},
R⁴¹ is a hydrogen atom or a C₁₋₆ alkyl group,
R^{S} is a group represented by the following formula: 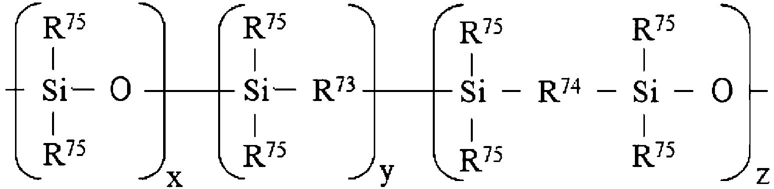 (wherein
R⁷³ is each independently a single bond, a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁶ is each independently a C₁₋₆ alkylene group,
R⁷⁷ is each independently an optionally substituted phenylene group or naphthylene group,
R⁷⁸ is each independently a single bond or a C₁₋₆ alkylene group,
R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula),
a0 is 0 or 1,
a1 is an integer of 1 to 5,
a2 is an integer of 0 to 5, and
the occurrence order of the respective repeating units enclosed in parentheses provided with a1 or a2 is not limited in the formula; or
a group represented by formula (X^{A1}): 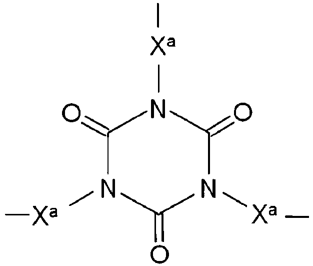
wherein X^{a} is each independently a single bond or a divalent linking group.

10. The silane compound according to claim 9, wherein X¹¹ is a divalent hydrocarbon group.

11. The silane compound according to claim 2, wherein R^{A} is the following group: 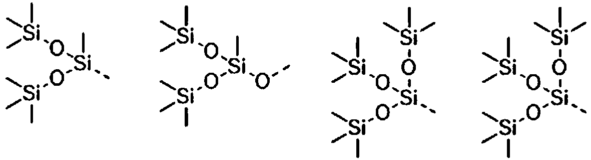 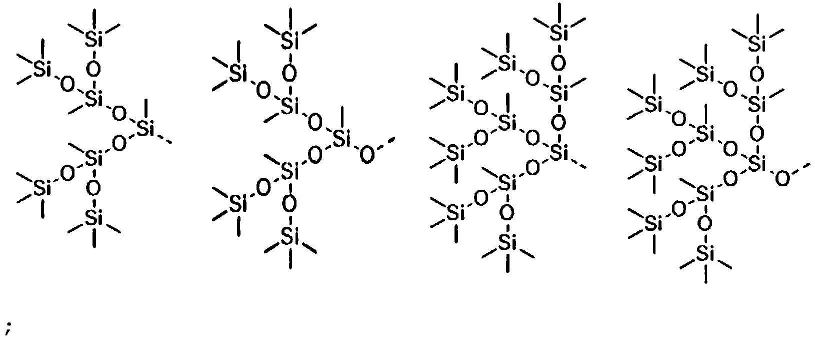 X¹ is the following group:
C₁₋₃₀ alkylene,
C₁₋₃₀ alkylene-CONH-C₁₋₃₀ alkylene,
C₁₋₃₀ alkylene-OCO-C₁₋₃₀ alkylene,
-OCO-C₁₋₃₀ alkylene,
-OSi(CH₃)₂-C₁₋₃₀ alkylene-CONH-C₁₋₃₀ alkylene,
-OSi(CH₃)₂-C₁₋₃₀ alkylene-OCO-C₁₋₃₀ alkylene,
-Si(CH₃)₂-C₁₋₃₀ alkylene-CONH-C₁₋₃₀ alkylene,
-Si(CH₃)₂-C₁₋₃₀ alkylene-OCO-C₁₋₃₀ alkylene,
C₁₋₃₀ alkylene-CO-,
(C₁₋₁₀ alkylene)₃C-C₁₋₃₀ alkylene-CONH-C₁₋₃₀ alkylene,
(C₁₋₁₀ alkylene)₃C-C₁₋₃₀ alkylene-OCO-C₁₋₃₀ alkylene, or
[C₁₋₁₀ alkylene-O-]₂phenyl-CONH-C₁₋₃₀ alkylene; and
R^{Si} is -Si(OCH₃)₃, -Si(CH₃)(CH₂CH₂CH₂-Si(OCH₃)₃)₂, - CH(CH₂CH₂CH₂-Si(OCH₃)₃)₂, -C(CH₂CH₂CH₂-Si(OCH₃)₃)₃, or - N(CH₂CH₂CH₂-Si(OCH₃)₃)₂.

12. The compound according to claim 1, which is selected from the following compounds: 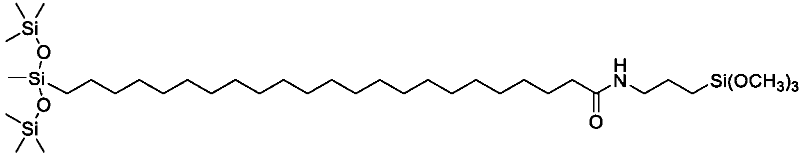 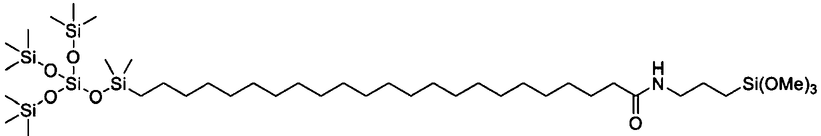 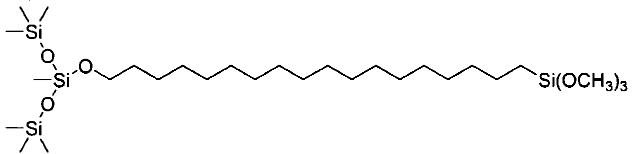 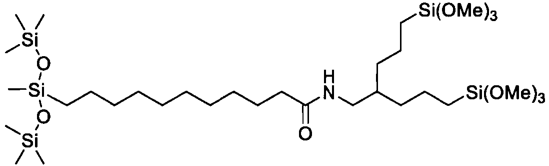 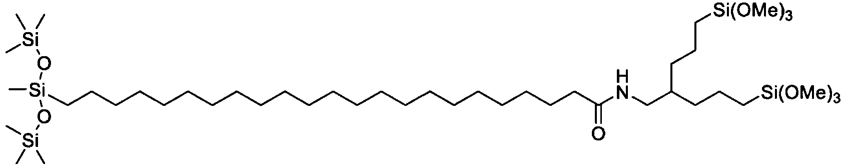 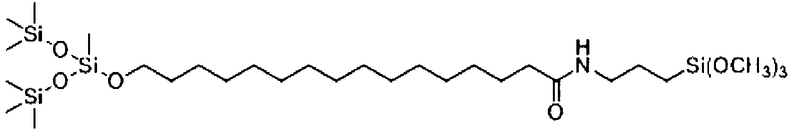 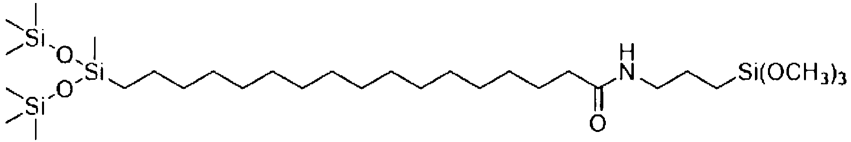 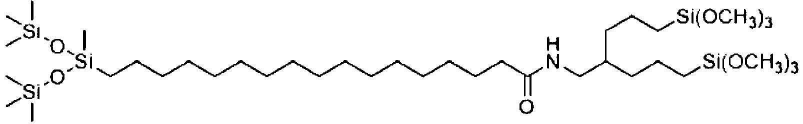 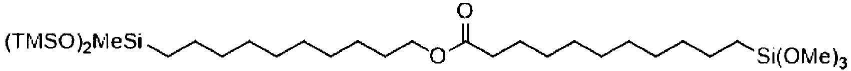 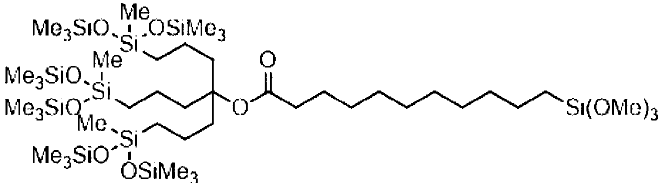 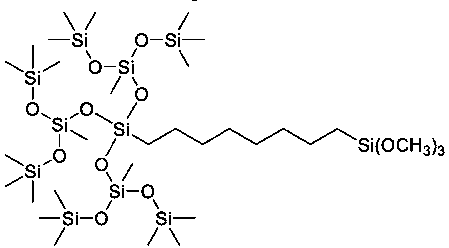 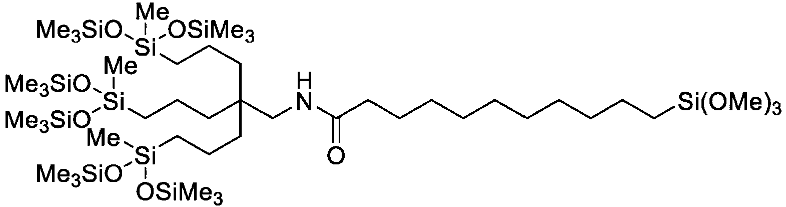 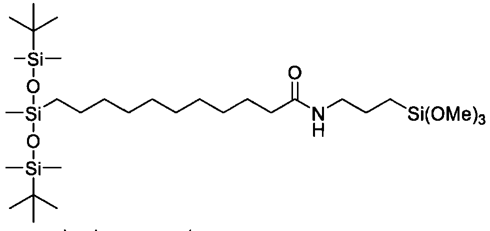 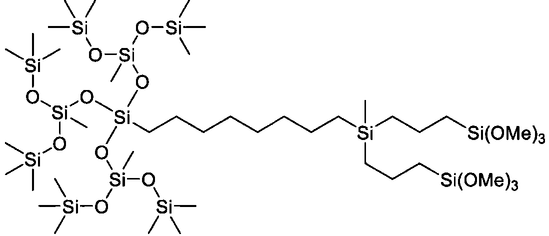 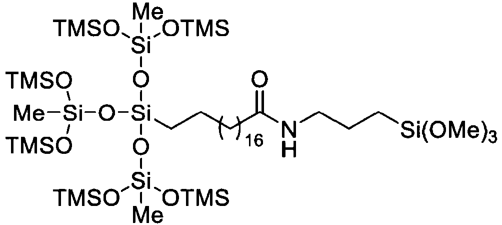 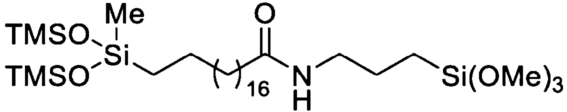 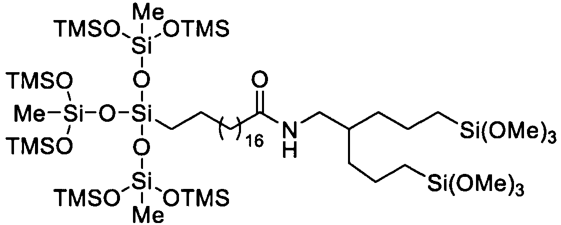 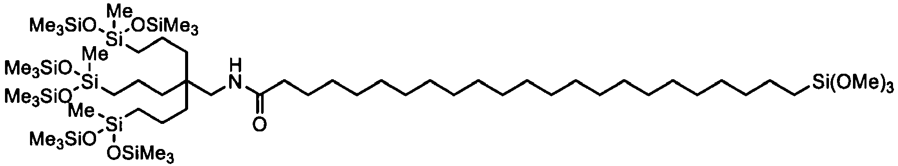
((CH₃)₃SiO)₂SiCH₃(CH₂)₂₂CON((CH₂)₃Si(OCH₃)₃)₂, 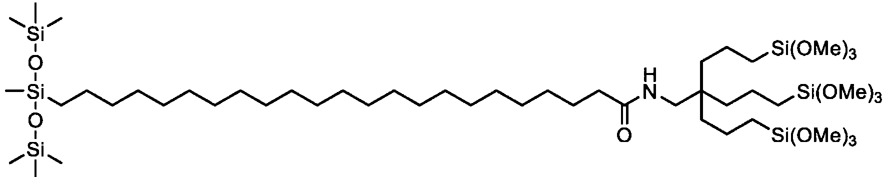 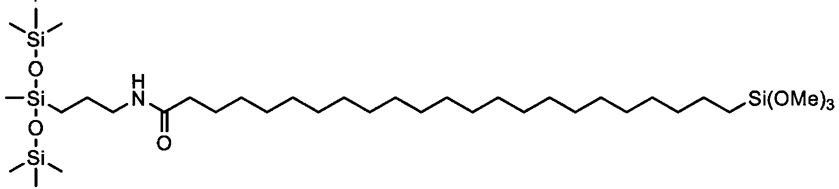 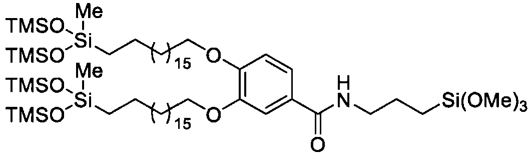
((CH₃)₃SiO)₂SiCH₃(CH₂)₂₁CONH(CH₂)₃Si(OCH₃)₃, 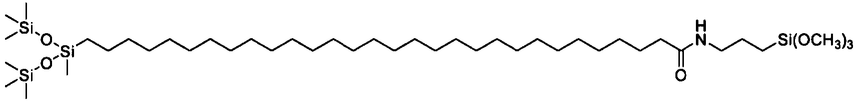 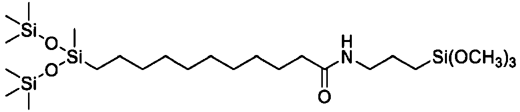
[(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH₂CH₂Si(OCH₃) ₃, wherein n is an integer of 2 to 80, [(CH₃)₃SiO]₃SiO(Si(CH₃)₂O)ₙSi(CH₃)₂CH₂CH₂CH₂CH₂CH₂CH₂CH₂CH₂CH₂ CH₂CH₂CH₂CH₂CH₂CH₂CH₂CH₂CH₂CH₂CH₂CH₂CH₂CONHCH₂CH₂CH₂Si(OCH₃)₃ wherein n is an integer of 2 to 80, 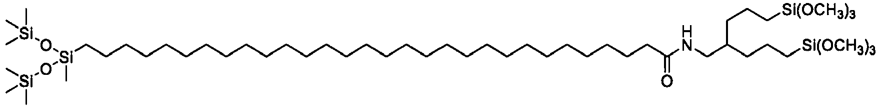 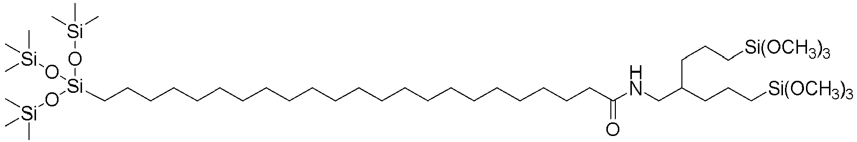 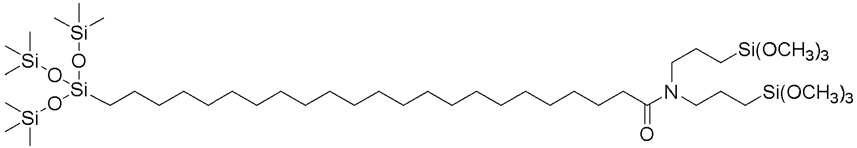 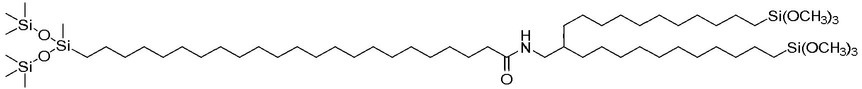 [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH[CH₂CH₂CH₂Si (OCH₃)₃]₂ wherein n is an integer of 2 to 80, [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂C[CH₂CH₂CH₂Si( OCH₃)₃]₃ wherein n is an integer of 2 to 80, [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH[CH₂CH₂CH₂CH ₂CH₂CH₂CH₂CH₂CH₂CH₂CH₂Si(OCH₃)₃]₂ wherein n is an integer of 2 to 80, [(CH₃)₃SiO]₂CH₃Si(O(Si(CH₃)₂O)ₙSi(CH₃)₂CH₂CH₂CH₂CH₂CH₂CH₂CH₂CH ₂CH₂CH₂CH₂CH₂CH₂CH₂CH₂CH₂CH₂CH₂CH₂CH₂CH₂CH₂CON[CH₂CH₂CH₂Si(OCH₃ )₃]₂ wherein n is an integer of 2 to 80, wherein TMSO is a trimethylsilyloxy group.

13. A composition comprising the compound according to claim 1 and a compound represented by formula (3):
R⁵¹-R⁵²-CONR⁵⁴-R⁵³-SiR¹¹ₙ₁R¹²₃₋ₙ₁ (3)
wherein
R⁵¹ is CH₃CH₂CH₂-, CH₃CH=CH-, or R¹²₃₋ₙ₁R¹¹ₙ₁Si-,
R⁵² is a C₀₋₃₀ alkylene group,
R⁵³ is a C₁₋₁₀ alkylene group,
R⁵⁴ is a hydrogen atom, a C₁₋₆ alkyl group, or a phenyl group,
R¹¹ is each independently a hydroxyl group or a hydrolyzable group,
R¹² is each independently a hydrogen atom or a monovalent organic group, and
n1 is an integer of 1 to 3.

14. The composition according to claim 11, comprising the compound represented by formula (3) in an amount of 0.1% by mass to 30% by mass based on the sum of the compound represented by formula (1) and the compound represented by formula (3).

15. The composition according to claim 11, which is a surface-treating agent.

16. A surface-treating agent comprising the silane compound according to any one of claims 1 to 10.

17. The surface-treating agent according to claim 11, further comprising a condensate of the silane compound according to claim 1.

18. The surface-treating agent according to claim 14, further comprising an alcohol represented by R⁹⁰-OH, wherein R⁹⁰ is a monovalent organic group.

19. The surface-treating agent according to claim 14, which is for vacuum deposition.

20. The surface-treating agent according to claim 14, which is for wet coating.

21. A pellet comprising the surface-treating agent according to any one of claims 14 to 18.

22. An article comprising a substrate and a layer on the substrate, wherein the layer is formed from the silane compound according to any one of claims 1 to 13.

23. The article according to claim 20, comprising, between the substrate and the aforementioned layer, a silicon oxide-containing intermediate layer.

24. The article according to claim 21, wherein the intermediate layer comprises an alkali metal atom.

25. The article according to claim 22, wherein the alkali metal atom is at least partially sodium.

26. The article according to claim 22, which is an optical member.

27. The article according to claim 22, which is a display.

28. A compound represented by the following formula:
CH₂=CH-(CH₂)ₙ₁₁₁COR¹¹¹
wherein n111 is an integer of 25 or more, and
R¹¹¹ is a hydrogen atom, a hydroxyl group, or a saturated or unsaturated hydrocarbon group having 1 to 12 carbon atoms and optionally substituted with a halogen.

29. A compound represented by the following formula:
CH₂=CH-(CH₂)ₙ₁₁₂COR¹¹²
wherein n112 is an integer of 7 or more, and
R¹¹² is an electron-withdrawing group containing an oxygen atom or a nitrogen atom directly bonded to a carbonyl group.

30. A compound represented by the following formula:
R^{A}-X¹¹¹-Rⁱ
wherein
R^{A} is a group A,
Rⁱ is COOR¹¹³, CONR¹¹⁴₂, CONR¹¹³-R¹¹⁵-CR¹¹⁴₃, or COR¹¹⁶,
R¹¹³ is a hydrogen atom, a hydroxyl group, or a saturated or unsaturated hydrocarbon group having 1 to 12 carbon atoms and optionally substituted with a halogen,
R¹¹⁴ is an alkenyl group having 2 to 20 carbon atoms and having a terminal double bond,
R¹¹⁵ is a divalent organic group,
R¹¹⁶ is an electron-withdrawing group containing an oxygen atom or a nitrogen atom directly bonded to a carbonyl group, and
X¹¹¹ is an alkylene group having 8 or more carbon atoms.
